# EUROPÄISCHE PATENTANMELDUNG

(11) **EP 4 376 060 A1**
(43) Veröffentlichungstag der Anmeldung: **29.05.2024**
(21) Anmeldenummer: 22208725.6
(22) Anmeldetag: 22.11.2022
(51) Int. Cl.: H01L 21/68, B23Q 1/38, B23Q 1/60, B23Q 1/62, G03F 7/20

(54) **POSITIONIERVORRICHTUNG ZUM POSITIONIEREN EINES BEWEGLICHEN ELEMENTS**

(71) Anmelder: Schneeberger Holding AG, 4914 Roggwil (CH)
(72) Erfinder: ZIHLMANN, Jean-Claude, 6247 Schötz (CH)
(74) Vertreter: EGLI-EUROPEAN PATENT ATTORNEYS

(57) **Zusammenfassung**

Die Positioniervorrichtung (1) zum Positionieren eines beweglichen Elements (5) umfasst eine Basis (B) mit einer ebenen Führungsfläche (FF), welche parallel zu einer ersten Richtung (X) und parallel zu einer zweiten Richtung (Y) angeordnet ist, und eine erste Bewegungseinrichtung (10) in Gantry-Bauweise mit einem sich in der zweiten Richtung (Y) in einem Abstand zur ebenen Führungsfläche (FF) erstreckenden Gantry-Balken (15) und mit einem Gantry-Antrieb (GA) zum Bewegen des Gantry-Balkens relativ zur Basis (B) in der ersten Richtung (X) mit zwei sich in der ersten Richtung (X) erstreckenden ersten Linearachsen (X1, X2) mit je einem Linearantrieb (LMX1, LMX2). Eine erste Luftlager-Einrichtung (LL1) mit mehreren mit dem Gantry-Balken (15) verbundenen Luftlagern zum Führen des Gantry-Balkens an der ebenen Führungsfläche (FF) der Basis (B) umfasst eine erste Luftlager-Anordnung (30) mit mindestens einem ersten horizontalen Luftlager (31, 32) zum Führen eines ersten Endes (15.1) des Gantry-Balkens (15) an einem ersten Abschnitt (FF1) der ebenen Führungsfläche (FF), eine zweite Luftlager-Anordnung (35) mit mindestens einem zweiten horizontalen Luftlager (36, 37) zum Führen eines zweiten Endes (15.2) des Gantry-Balkens an einem zweiten Abschnitt (FF2) der ebenen Führungsfläche (FF), eine an einem mittleren Abschnitts des Gantry-Balkens (15) angeordnete dritte Luftlager-Anordnung (50) mit mindestens einem dritten horizontalen Luftlager (51, 52) und mindestens einem vierten horizontalen Luftlager (53, 54) zum Führen des mittleren Abschnitts des Gantry-Balkens (15) an einem dritten Abschnitt (FF3) der ebenen Führungsfläche (FF) und mit mindestens einem seitlichen Luftlager (55, 56) zum Führen des Gantry-Balkens (15) an einer ebenen Seitenfläche (SF) eines Führungsbalkens (FB).

## Beschreibung

### Technisches Gebiet

Die Erfindung bezieht sich auf eine Positioniervorrichtung zum Positionieren eines beweglichen Elements. Die Erfindung bezieht sich insbesondere auf eine Positioniervorrichtung zum Positionieren eines beweglichen Elements, welche ausgebildet ist, das bewegliche Element mithilfe einer Bewegungseinrichtung in Gantry-Bauweise bezüglich einer an einer Basis ausgebildeten ebenen Führungsfläche in einer ersten Richtung und in einer zweiten Richtung zu bewegen.

### Stand der Technik

Eine Vielzahl von Positioniervorrichtungen zum Positionieren eines beweglichen Elements, welche geeignet sind, ein bewegliches Element bezüglich einer an einer Basis ausgebildeten ebenen Führungsfläche in einer ersten Richtung und in einer zweiten Richtung zu bewegen, sind bereits bekannt. Derartige Positioniervorrichtungen werden beispielsweise in der Halbleiterindustrie verwendet, um u.a. Halbleiterwafer während Prozessschritten zur Herstellung von Mikrostrukturen an einer Oberfläche eines Halbleiterwafers in unterschiedliche Positionen zu bringen oder Halbleiterwafer zu metrologischen Zwecken relativ zu Messvorrichtungen zu positionieren (beispielsweise zur Inspektion und/oder zur messtechnischen Charakterisierung von Mikrostrukturen an Oberflächen von Halbleiterwafern).

Beispielsweise im Hinblick auf industrielle Anwendungen zur Durchführung von Prozessschritten zur Herstellung von Mikrostrukturen oder zur Inspektion und/oder zur messtechnischen Charakterisierung von Mikrostrukturen besteht ein Bedarf an Positioniervorrichtungen, welche geeignet sind, ein bewegliches Element (beispielsweise eine Plattform bzw. einen Tisch zur Aufnahme eines zu positionierenden Gegenstands) in einer ersten Richtung und in einer zweiten Richtung (d.h. zweidimensional relativ zu einer vorgegebenen Ebene) mit einer möglichst grossen Geschwindigkeit und gegebenenfalls mit einer möglichst grossen Beschleunigung (z.B. im Bereich von 2g oder mehr) zu bewegen und dabei wiederholt und reproduzierbar in vorgegebene Positionen jeweils mit einer grossen Präzision (d.h. mit einer Genauigkeit im Sub-Mikrometer-Bereich) zu positionieren.

Um ein schnelles und präzises Positionieren eines beweglichen Elements in einer ersten Richtung und in einer zweiten Richtung zu ermöglichen, umfassen Positioniervorrichtungen der vorstehend genannten Art häufig eine Basis (z.B. einen Block aus Granit) mit einer ebenen Führungsfläche, welche parallel zu einer ersten Richtung und parallel zu einer zweiten Richtung angeordnet ist, und eine Bewegungsvorrichtung zum Bewegen des beweglichen Elements mit Bezug auf die ebene Führungsfläche der Basis. Eine Bewegungsvorrichtung der vorstehend genannten Art kann hierbei beispielsweise u.a. eine erste Bewegungseinrichtung in Gantry-Bauweise aufweisen, welche einen über der ebenen Führungsfläche angeordneten, sich in der zweiten Richtung in einem Abstand zur ebenen Führungsfläche erstreckenden Gantry-Balken und einen Gantry-Antrieb zum Bewegen des Gantry-Balkens relativ zur Basis in der ersten Richtung umfasst. Der Gantry-Balken weist hierbei ein erstes Ende und ein dem ersten Ende gegenüberliegendes zweites Ende auf, wobei der Gantry-Antrieb zwei sich in der ersten Richtung erstreckende erste Linearachsen mit je einem Linearantrieb umfasst und die zwei sich in der ersten Richtung erstreckenden ersten Linearachsen derart konzipiert sind, dass der Linearantrieb einer der zwei ersten Linearachsen mit dem ersten Ende des Gantry-Balkens und der Linearantrieb der anderen der zwei ersten Linear-Achsen mit dem zweiten Ende des Gantry-Balkens verbunden ist.

Um ein Bewegen des beweglichen Elements in der ersten Richtung und in der zweiten Richtung zu ermöglichen, ist dabei das bewegliche Element am Gantry-Balken derart gelagert, dass das bewegliche Element am Gantry-Balken linear in der zweiten Richtung bewegbar ist, wobei der Gantry-Balken eine sich in der zweiten Richtung erstreckende zweite Linearachse mit einem mit dem beweglichen Element verbundenen Linearantrieb zum Bewegen des beweglichen Elements in der zweiten Richtung aufweist.

Um zu ermöglichen, dass das bewegliche Element wiederholt und reproduzierbar in vorgegebene Positionen jeweils mit einer grossen Präzision (d.h. mit einer Genauigkeit im Bereich von Nanometern) relativ zur Führungsfläche der Basis positioniert werden kann, kann es für viele Anwendungen vorteilhaft sein, den Gantry-Balken der ersten Bewegungseinrichtung bei einer Bewegung entlang der ebenen Führungsfläche der Basis mittels Luftlagern an der Basis zu lagern und zu diesem Zweck eine Luftlager-Einrichtung mit mehreren mit dem Gantry-Balken verbundenen Luftlagern zum Führen des Gantry-Balkens an der ebenen Führungsfläche der Basis bereitzustellen. Die Luftlager haben den Effekt, dass bei einer Bewegung des Gantry-Balkens relativ zur Basis gegenüberliegende und relativ zueinander bewegte Oberflächenbereiche des Gantry-Balkens und der Führungsfläche der Basis im Bereich der Luftlager jeweils durch Luftkissen separiert sind und deshalb berührungslos relativ zueinander bewegt werden können. Dadurch ist insbesondere gewährleistet, dass eine mechanische Reibung (Haftreibung und/oder Gleitreibung) zwischen gegenüberliegenden Oberflächenbereichen des Gantry-Balkens und der Führungsfläche der Basis verhindert wird und somit auf einer mechanischen Reibung zwischen relativ zueinander bewegten Festkörpern beruhende Effekte, welche die Genauigkeit einer Positionierung relativ zueinander bewegter Festkörper in der Regel beeinträchtigen (Haftgleiteffekt bzw. Ruckgleiten der relativ zueinander bewegten Festkörper), vermieden werden.

Im Hinblick auf viele Anwendungen von Positioniervorrichtungen der vorstehend genannten Art besteht ein Bedarf, derartige Positioniervorrichtungen "hochdynamisch" auszubilden, sodass sie geeignet sind, ein bewegliches Element mit einer grossen Beschleunigung (z.B. im Bereich von 2g oder mehr) zu bewegen. Bei einer hochdynamischen Positioniervorrichtung der vorstehend genannten Art besteht eine wesentliche Anforderung darin, dass die Positioniervorrichtung und insbesondere der Gantry-Balken der ersten Bewegungseinrichtung infolge der Massenträgheit sowohl während einer grossen Beschleunigung des Gantry-Balkens mittels der Linearantriebe der zwei ersten Linearachsen in der ersten Richtung als auch bei einer grossen Beschleunigung des beweglichen Elements mittels des Linearantriebs der zweiten Linearachse in der zweiten Richtung möglichst wenig deformiert wird und deshalb eine möglichst grosse Steifigkeit mit Bezug auf eine Deformation in Form einer Biegung und/oder einer Torsion um die erste Richtung und/oder die zweite Richtung aufweisen sollte.

Hinsichtlich Positioniervorrichtungen der vorstehend genannten Art, bei welchen der Gantry-Balken mittels Luftlagern an der Basis geführt ist und welche hochdynamisch ausgebildet sind, sind insbesondere Konstruktionen bekannt geworden, welche eine "flache" Bauformen aufweisen, derart, dass die beiden Linearantriebe der ersten Linearachsen möglichst auf der Höhe des Massenschwerpunktes aller mittels dieser beiden Linearantriebe bewegten Teile der Positioniervorrichtung angeordnet sind, um die dynamische Torsionssteifigkeit (entsprechend einer Eigenfrequenz) des Gantry-Balkens zu maximieren. Letzteres steht im Zusammenhang mit der Tatsache, dass je grösser der vertikale Abstand (d.h. senkrecht zur ebenen Führungsfläche der Basis) zwischen dem auf den Gantry-Balken wirkenden Kraftvektor der Linearantriebe der zwei ersten Linearachsen und dem Masseschwerpunkt aller mittels der Linearantriebe der zwei ersten Linearachsen bewegten Teile der Positioniervorrichtung ist, umso stärker wird sich der Gantry-Balken bei einer beschleunigten Bewegung in der ersten Richtung aufgrund der Massenträgheit der mittels der Linearantriebe der zwei ersten Linearachsen bewegten Teile der Positioniervorrichtung verdrehen, was in nachteiliger Weise die Einschwingzeit verlängert, welche der Gantry-Balken benötigt, um nach einer Beschleunigung des Gantry-Balkens in der ersten Richtung wieder in eine stabile Lage zu gelangen.

Eine hochdynamisch ausgebildete Positioniervorrichtung der vorstehend genannten Art, bei welcher der Gantry-Balken mittels Luftlagern an einer ebenen Führungsfläche einer Basis geführt ist, ist beispielsweise aus der Druckschrift CN 113977294 A bekannt. Diese Positioniervorrichtung ist konzipiert für eine präzise Positionierung eines beweglichen Elements in Form eines bewegbaren Tischs zur Aufnahme eines Werkstücks (beispielsweise für eine Mikrobearbeitung des Werkstücks). Der Gantry-Balken dieser Positioniervorrichtung ist an einer ebenen Führungsfläche an der Oberseite der Basis mittels zwei horizontalen Luftlagern geführt, wobei eines der zwei horizontalen Luftlager am ersten Ende des Gantry-Balkens angeordnet ist, um das erste Ende des Gantry-Balkens bei einer Bewegung in der ersten Richtung auf der ebenen Führungsfläche der Basis zu stützen bzw. zu führen, und wobei das andere der zwei horizontalen Luftlager am zweiten Ende des Gantry-Balkens angeordnet ist, um das zweite Ende des Gantry-Balkens bei einer Bewegung in der ersten Richtung auf der ebenen Führungsfläche an der Oberseite der Basis zu stützen bzw. zu führen. Der zu positionierende bewegbare Tisch ist mittels des Linearantriebs der am Gantry-Balken angeordneten zweiten Linearachse in der zweiten Richtung (Längsrichtung des Gantry-Balkens) bewegbar und ebenfalls mittels horizontaler Luftlager an der ebenen Führungsfläche an der Oberseite der Basis gestützt bzw. geführt. Um den Gantry-Balken bei einer Bewegung in der ersten Richtung seitlich zu führen, ist eine seitliche Führungsfläche vorgesehen, welche sich parallel zur ersten Richtung und senkrecht zur ebenen Führungsfläche der Basis erstreckt. Die seitliche Führungsfläche ist mit Bezug auf die ebene Führungsfläche an der Oberseite der Basis in etwa auf derselben Höhe angeordnet wie der Gantry-Balken, derart, dass die seitliche Führungsfläche seitlich neben dem Gantry-Balken in der Nähe eines der Enden des Gantry-Balkens in einem Abstand zu diesem einen Ende des Gantry-Balkens platziert ist. Der Gantry-Balken ist an der einen seitlichen Führungsfläche mittels eines seitlichen Luftlagers geführt, welches zu diesem Zweck an einer Seitenfläche des Gantry-Balkens an dem einen Ende des Gantry-Balkens befestigt ist, welches in der Nähe der seitlichen Führungsfläche angeordnet ist. Die Anordnung der seitlichen Führungsfläche (d.h. seitlich neben dem Gantry-Balken in der Nähe eines der Enden des Gantry-Balken in einem Abstand zu diesem einen Ende des Gantry-Balkens) ermöglicht eine Maximierung der dynamischen Biegesteifigkeit des Gantry-Balkens bei einer Beschleunigung des bewegbaren Tischs in der zweiten Richtung (entsprechend der Längsrichtung des Gantry-Balkens). Letzteres steht im Zusammenhang mit der Tatsache, dass je grösser der Abstand zwischen dem Ort, an dem der Gantry-Balken mittels des seitlichen Luftlagers an der einen seitlichen Führungsfläche geführt ist, und dem Massenschwerpunkt des am Gantry-Balken angeordneten bewegbaren Tischs ist, desto grösser wird das bei einer Beschleunigung des bewegbaren Tischs in der zweiten Richtung auf den Gantry-Balken bzw. das seitliche Luftlager wirkende Biegemoment, was die Biegesteifigkeit des Gantry-Balkens reduziert und in nachteiliger Weise die Einschwingzeit verlängert, welche der Gantry-Balken benötigt, um nach einer Beschleunigung des bewegbaren Tischs in der zweiten Richtung wieder in eine stabile Lage zu gelangen. Zum Ausgleich von Toleranzen und unterschiedlichen Geschwindigkeiten der beiden Linearantriebe der zwei ersten Linearachsen bei einer Bewegung des Gantry-Balkens in der ersten Richtung ist das seitliche Luftlager über ein (zwischen dem seitlichen Luftlager und dem einen Ende des Gantry-Balkens platziertes) Festkörpergelenk derart mit dem einen Ende des Gantry-Balkens verbunden, dass das seitliche Luftlager relativ zum Gantry-Balken schwenkbar ist.

Bekannte hochdynamisch ausgebildete Positioniervorrichtungen der vorstehend genannten Art, bei welcher der Gantry-Balken und das in Längsrichtung des Gantry-Balkens bewegbare bewegliche Elements jeweils mittels Luftlagern an einer ebenen Führungsfläche einer Basis geführt ist (z.B. die vorstehend beschriebene, aus der Druckschrift CN 113977294 A bekannte Positioniervorrichtung), haben den Nachteil, dass diese Positioniervorrichtungen - im Vergleich zu den Distanzen, über welche das zu positionierende bewegliche Element mittels der jeweiligen Positioniervorrichtungen relativ zur ebenen Führungsfläche der Basis bewegbar ist, einen verhältnismässig grossen Platzbedarf (hinsichtlich einer Grundfläche parallel zur ersten Richtung und zur zweiten Richtung, über welche die jeweiligen Teile der Positioniervorrichtung räumlich verteilt angeordnet sind) haben, bedingt durch die räumliche Anordnung der zwei ersten Linearachsen und der zweiten Linearachse und die räumliche Anordnung der Luftlager zum Führen des Gantry-Balkens und des beweglichen Elements an der Basis. Die am Gantry-Balken angeordneten Luftlager zum Führen des Gantry-Balkens an der Basis und die am beweglichen Element angeordneten Luftlager zum Führen des beweglichen Elements an der Basis sind dabei relativ zueinander in der Regel derart angeordnet, dass das bewegliche Element aufgrund des Platzbedarfs der jeweiligen Luftlager in der zweiten Richtung nicht entlang der gesamten Länge des Gantry-Balkens bewegt werden kann, sondern nur über einen Teil der Länge des Gantry-Balkens.

### Zusammenfassung der Erfindung

Der vorliegenden Erfindung liegt die Aufgabe zugrunde, die genannten Nachteile zu vermeiden und eine hochdynamisch ausgebildete Positioniervorrichtung zum Positionieren eines beweglichen Elements zu schaffen, bei welcher der Gantry-Balken mittels Luftlagern an einer ebenen Führungsfläche einer Basis geführt ist und welche relativ kompakt aufgebaut ist (mit einer verhältnismässig kleinen Grundfläche, über welche die jeweiligen Teile der Positioniervorrichtung räumlich verteilt angeordnet sind) und zudem geeignet ist, das bewegliche Element mit einer relativ grossen Beschleunigung über eine verhältnismässig grosse Fläche zu bewegen (im Vergleich zur Grundfläche der Positioniervorrichtung).

Diese Aufgabe wird gelöst durch eine Positioniervorrichtung zum Positionieren eines beweglichen Elements mit den Merkmalen des Patentanspruchs 1.

Die Positioniervorrichtung umfasst eine Basis mit einer ebenen Führungsfläche, welche parallel zu einer ersten Richtung und parallel zu einer zweiten Richtung angeordnet ist, und eine erste Bewegungseinrichtung in Gantry-Bauweise, welche erste Bewegungseinrichtung einen über der ebenen Führungsfläche angeordneten, sich in der zweiten Richtung in einem Abstand zur ebenen Führungsfläche erstreckenden Gantry-Balken und einen Gantry-Antrieb zum Bewegen des Gantry-Balkens relativ zur Basis in der ersten Richtung umfasst, wobei der Gantry-Balken ein erstes Ende und ein dem ersten Ende gegenüberliegendes zweites Ende aufweist und der Gantry-Antrieb zwei sich in der ersten Richtung erstreckende erste Linearachsen mit je einem Linearantrieb umfasst. Dabei ist der Linearantrieb einer der zwei ersten Linearachsen mit dem ersten Ende des Gantry-Balkens und der Linearantrieb der anderen der zwei ersten Linear-Achsen mit dem zweiten Ende des Gantry-Balkens verbunden.

Die Positioniervorrichtung umfasst ausserdem eine erste Luftlager-Einrichtung mit mehreren mit dem Gantry-Balken verbundenen Luftlagern zum Führen des Gantry-Balkens an der ebenen Führungsfläche der Basis.

Das bewegliche Element ist am Gantry-Balken derart gelagert, dass das bewegliche Element am Gantry-Balken linear in der zweiten Richtung bewegbar ist, wobei der Gantry-Balken eine sich in der zweiten Richtung erstreckende zweite Linearachse mit einem mit dem beweglichen Element verbundenen Linearantrieb zum Bewegen des beweglichen Elements in der zweiten Richtung aufweist.

Die erste Luftlager-Einrichtung der Positioniervorrichtung weist eine erste Luftlager-Anordnung auf, welche mindestens ein am ersten Ende des Gantry-Balkens angeordnetes erstes horizontales Luftlager zum Führen des ersten Endes des Gantry-Balkens an einem sich in der ersten Richtung erstreckenden ersten Abschnitt der ebenen Führungsfläche umfasst, welches mindestens eine erste horizontale Luftlager bezüglich des ersten Abschnitts der ebenen Führungsfläche vorgespannt ist.

Die erste Luftlager-Einrichtung der Positioniervorrichtung weist ausserdem eine zweite Luftlager-Anordnung auf, welche mindestens ein am zweiten Ende des Gantry-Balkens angeordnetes zweites horizontales Luftlager zum Führen des zweiten Endes des Gantry-Balkens an einem zweiten sich in der ersten Richtung erstreckenden Abschnitt der ebenen Führungsfläche umfasst, welches mindestens eine zweite horizontale Luftlager bezüglich des zweiten Abschnitts der ebenen Führungsfläche vorgespannt ist.

Gemäss der Erfindung weist die erste Luftlager-Einrichtung der Positioniervorrichtung zusätzlich eine dritte Luftlager-Anordnung auf, welche mindestens ein drittes horizontales Luftlager und mindestens ein viertes horizontales Luftlager umfasst, wobei das mindestens eine dritte horizontale Luftlager und das mindestens eine vierte horizontale Luftlager an einem mittleren Abschnitt des Gantry-Balkens zwischen dem ersten Ende des Gantry-Balkens und dem zweiten Ende des Gantry-Balkens angeordnet sind, sodass der mittlere Abschnitt des Gantry-Balkens mittels des dritten horizontalen Luftlagers und des vierten horizontales Luftlagers an einem sich in der ersten Richtung erstreckenden dritten Abschnitt der ebenen Führungsfläche geführt ist, welcher mit Bezug auf die zweite Richtung zwischen dem ersten Abschnitt der ebenen Führungsfläche und dem zweiten Abschnitt der ebenen Führungsfläche angeordnet ist, wobei das mindestens eine dritte horizontale Luftlager und das mindestens eine vierte horizontale Luftlager relativ zueinander einen Abstand in der ersten Richtung aufweisen und das mindestens eine dritte horizontale Luftlager und das mindestens eine vierte horizontale Luftlager bezüglich des dritten Abschnitts der ebenen Führungsfläche vorgespannt sind.

Die Positioniervorrichtung ist ausserdem derart ausgebildet, dass an der Basis neben dem dritten Abschnitt der ebenen Führungsfläche ein sich in der ersten Richtung erstreckender Führungsbalken angeordnet ist, welcher eine ebene Seitenfläche aufweist, welche sich parallel zur ersten Richtung und parallel zu einer im Wesentlichen senkrecht zur ebenen Führungsfläche gerichteten dritten Richtung erstreckt. Entsprechend umfasst die dritte Luftlager-Anordnung mindestens ein an dem mittleren Abschnitt des Gantry-Balkens angeordnetes seitliches Luftlager zum Führen des Gantry-Balkens an der einen ebenen Seitenfläche des Führungsbalkens, wobei das mindestens eine seitliche Luftlager bezüglich der einen ebenen Seitenfläche des Führungsbalkens vorgespannt ist.

Es sei darauf hingewiesen, dass die Formulierung "parallel zu einer im Wesentlichen senkrecht zur ebenen Führungsfläche gerichteten dritten Richtung" in diesem Zusammenhang derart auszulegen sein soll, dass die "dritte Richtung" exakt parallel zu einer sich "senkrecht zur ebenen Führungsfläche" erstreckenden Geraden gerichtet sein kann, aber nicht notwendigerweise exakt parallel zu einer sich "senkrecht zur ebenen Führungsfläche" erstreckenden Geraden gerichtet sein muss, sondern auch mit einem Winkel im Bereich von 0°-5° bezüglich einer sich "senkrecht zur ebenen Führungsfläche" erstreckenden Geraden geneigt sein kann.

Die Bezeichnung "horizontales Luftlager" bezeichnet in diesem Zusammenhang eine "Lagereinrichtung", welche ausgebildet ist, mittels einer Abgabe von Druckluft ein Luftkissen zwischen der ebenen Führungsfläche der Basis und der Lagereinrichtung zu erzeugen und auf diese Weise die Lagereinrichtung in einem Abstand zur ebenen Führungsfläche der Basis zu halten.

Die Bezeichnung "seitliches Luftlager" bezeichnet in diesem Zusammenhang eine "Lagereinrichtung", welche ausgebildet ist, mittels einer Abgabe von Druckluft ein Luftkissen zwischen der ebenen Seitenfläche des Führungsbalkens und der Lagereinrichtung zu erzeugen und auf diese Weise die Lagereinrichtung in einem Abstand zur ebenen Seitenfläche des Führungsbalkens zu halten.

Die Bezeichnung "horizontales Luftlager, welche bezüglich eines Abschnitts der ebenen Führungsfläche vorgespannt ist" bezeichnet in diesem Zusammenhang eine "Lagereinrichtung", welche ausgebildet ist, mittels einer Abgabe von Druckluft ein Luftkissen zwischen der ebenen Führungsfläche der Basis und der Lagereinrichtung zu erzeugen, und zusätzlich technische Mittel umfasst, welche geeignet sind, eine auf die Lagereinrichtung wirkende, auf den jeweiligen Abschnitt der ebenen Führungsfläche gerichtete Anziehungskraft ("Vorspannkraft") zu erzeugen, sodass die Lagereinrichtung durch ein Zusammenwirken des Luftkissens und der erzeugten Anziehungskraft bzw. Vorspannkraft in einer stabilen Lage bezüglich der ebenen Führungsfläche gehalten ist, in welcher stabilen Lage die Lagereinrichtung einen Abstand bezüglich der ebenen Führungsfläche aufweist (entsprechend der Dicke eines Luftspalts zwischen der Lagereinrichtung und der ebenen Führungsfläche, in welchem das durch die Abgabe von Druckluft erzeugte Luftkissen ausgebildet ist). Entsprechende technische Mittel zum Vorspannen eines Luftlagers sind an sich bekannt und werden im Folgenden noch spezifiziert. Aufgrund eines Zusammenwirkens der auf die ebene Führungsfläche gerichteten Vorspannkraft und der von der Lagereinrichtung abgegebenen Druckluft hat das im Luftspalt zwischen der Lagereinrichtung und der ebenen Führungsfläche ausgebildete Luftkissen die Wirkung eines "Federelements", welches in einer Richtung senkrecht zur ebenen Führungsfläche elastisch deformierbar ist: Die Dicke des Luftspalts, welcher zwischen der Lagereinrichtung und der ebenen Führungsfläche aufgrund der Präsenz des Luftkissens ausgebildet ist, kann deshalb nur mittels einer auf die Lagereinrichtung wirkenden, senkrecht zur ebenen Führungsfläche gerichteten Kraft geändert (d.h. abhängig von der jeweiligen Richtung der Kraft vergrössert oder verkleinert) werden, wobei das Luftkissen mit Bezug auf eine Veränderung der Dicke des Luftspalts eine "Steifigkeit" aufweist. Die Steifigkeit ist hierbei definiert als das Verhältnis der auf die Lagereinrichtung wirkenden, senkrecht zur ebenen Führungsfläche gerichteten Kraft zu der Grösse der Änderung der Dicke der Luftspalts, welche von der auf die Lagereinrichtung wirkenden Kraft hervorgerufen wird. Die Grösse der Steifigkeit des Luftlagers ist hierbei u.a. von der jeweiligen Grösse der Vorspannkraft abhängig, sodass die Steifigkeit des Luftlagers in einem bestimmten Bereich nach Bedarf variiert werden kann (durch Auswahl einer bestimmten Grösse der Vorspannkraft). Die Steifigkeit des Luftlagers mit Bezug auf eine senkrecht zur ebenen Führungsfläche gerichteten Kraft kann dementsprechend vorteilhafterweise durch Auswahl einer bestimmten Vorspannkraft "maximiert" werden, um die Lagereinrichtung besonders effektiv in einer stabilen Lage bezüglich der ebenen Führungsfläche zu halten.

Entsprechend bezeichnet der Ausdruck "seitliches Luftlager, welches bezüglich der einen ebenen Seitenfläche des Führungsbalkens vorgespannt ist" in diesem Zusammenhang eine "Lagereinrichtung", welche ausgebildet ist, mittels einer Abgabe von Druckluft ein Luftkissen zwischen der ebenen Seitenfläche des Führungsbalkens zu erzeugen, und zusätzlich technische Mittel umfasst, welche geeignet sind, eine auf die Lagereinrichtung wirkende, auf die ebene Seitenfläche des Führungsbalkens gerichtete Anziehungskraft ("Vorspannkraft") zu erzeugen, sodass die Lagereinrichtung durch ein Zusammenwirken des Luftkissens und der erzeugten Anziehungskraft bzw. Vorspannkraft in einer stabilen Lage bezüglich der ebenen Seitenfläche des Führungsbalkens gehalten ist, in welcher stabilen Lage die Lagereinrichtung einen Abstand bezüglich der ebenen Seitenfläche des Führungsbalkens aufweist (entsprechend der Dicke eines Luftspalts zwischen der Lagereinrichtung und der ebenen Seitenfläche des Führungsbalkens, in welchem das durch die Abgabe von Druckluft erzeugte Luftkissen ausgebildet ist). Entsprechende technische Mittel zum Vorspannen des Luftlagers werden im Folgenden noch spezifiziert. Das im Luftspalt zwischen der Lagereinrichtung und der ebenen Seitenfläche des Führungsbalkens ausgebildete Luftkissen hat die Wirkung eines "Federelements", welches in einer Richtung senkrecht zur ebenen Seitenfläche elastisch deformierbar ist: Die Dicke des Luftspalts, welcher zwischen der Lagereinrichtung und der ebenen Seitenfläche aufgrund der Präsenz des Luftkissens ausgebildet ist, kann deshalb nur mittels einer auf die Lagereinrichtung wirkenden, senkrecht zu der ebenen Seitenfläche gerichteten Kraft geändert (d.h. abhängig von der jeweiligen Richtung der Kraft vergrössert oder verkleinert) werden, wobei das Luftkissen mit Bezug auf eine Veränderung der Dicke des Luftspalts eine Steifigkeit aufweist. Die Grösse der Steifigkeit des Luftlagers ist hierbei u.a. von der jeweiligen Grösse der Vorspannkraft abhängig, sodass die Steifigkeit des Luftlagers in einem bestimmten Bereich nach Bedarf variiert werden kann (durch Auswahl einer bestimmten Grösse der Vorspannkraft). Die Steifigkeit des Luftlagers mit Bezug auf eine senkrecht zur ebenen Seitenfläche gerichteten Kraft kann dementsprechend vorteilhafterweise durch Auswahl einer bestimmten Vorspannkraft "maximiert" werden, um die Lagereinrichtung besonders effektiv in einer stabilen Lage bezüglich der ebenen Seitenfläche zu halten.

Als "Linearachse" sei hier jeweils eine Kombination aus Linearführung und Linearantrieb verstanden. Die horizontalen Luftlager der ersten Luftlager-Einrichtung und die seitlichen Luftlager der ersten Luftlager-Einrichtung wirken mit der ebenen Führungsfläche der Basis und der ebenen Seitenfläche des Führungsbalkens derart zusammen, dass der Gantry-Balken mittels der horizontalen Luftlager und der seitlichen Luftlager der ersten Luftlager-Einrichtung derart geführt ist, dass der Gantry-Balken linear in der ersten Richtung bewegbar ist. Diese Linearführung des Gantry-Balkens repräsentiert in Kombination mit jeweils einem der zwei Linearantriebe, welche mit jeweils einem der zwei Enden des Gantry-Balkens verbunden sind, jeweils eine der zwei "ersten Linearachsen" der Positioniervorrichtung. Da das bewegliche Element am Gantry-Balken derart gelagert, dass das bewegliche Element am Gantry-Balken linear in der zweiten Richtung bewegbar ist, weist der Gantry-Balken eine Linearführung zum Führen des beweglichen Elements bei einer Bewegung in der zweiten Richtung auf, welche Linearführung in Kombination mit dem Linearantrieb, der zum Bewegen des beweglichen Elements in der zweiten Richtung mit dem beweglichen Element verbunden ist, die "zweite Linearachse" der Positioniervorrichtung repräsentiert.

Als wesentlich im Hinblick auf die Lösung der der Erfindung zugrundeliegenden Aufgabe kann angesehen werden, dass die erste Luftlager-Einrichtung der erfindungsgemässen Positioniervorrichtung - zusätzlich zu der ersten Luftlager-Anordnung und der zweiten Luftlager-Anordnung - die dritte Luftlager-Anordnung umfasst und dass an der Basis neben dem dritten Abschnitt der ebenen Führungsfläche der sich in der ersten Richtung erstreckende Führungsbalken mit einer sich parallel zur ersten Richtung und parallel zur dritten Richtung erstreckenden ebenen Seitenfläche angeordnet ist.

Die dritte Luftlager-Anordnung weist hierbei insbesondere eine Gruppe von mindestens drei verschiedenen Luftlagern auf, welche Gruppe umfasst: das mindestens eine dritte horizontale Luftlager, das mindestens eine vierte horizontale Luftlager und das mindestens eine seitliche Luftlager. Diese mindestens drei verschiedenen Luftlager der dritten Luftlager-Anordnung sind am Gantry-Balken mit Bezug auf die zweite Richtung (entsprechend der Längsrichtung des Gantry-Balkens) räumlich zwischen den jeweiligen (horizontalen) Luftlagern der ersten Luftlager-Anordnung und den jeweiligen (horizontalen) Luftlagern der zweiten Luftlager-Anordnung (in einem "mittleren Abschnitt" des Gantry-Balkens) angeordnet und haben deshalb den Zweck, den Gantry-Balken im Bereich des "mittleren Abschnitts" des Gantry-Balkens zwischen dem ersten Ende und dem zweiten Ende des Gantry-Balkens sowohl an der (sich parallel zur ersten Richtung und parallel zur zweiten Richtung erstreckenden) ebenen Führungsfläche der Basis zu stützen bzw. zu führen (mittels des mindestens einen dritten horizontalen Luftlagers und des mindestens einen vierten horizontalen Luftlagers) als auch an der einen (sich parallel zur ersten Richtung und parallel zur dritten Richtung erstreckenden) ebenen Seitenfläche des Führungsbalkens seitlich zu führen (mittels des mindestens einen seitlichen Luftlagers), sodass der Gantry-Balken linear in der ersten Richtung bewegbar ist.

Die Bezeichnung "mittlerer Abschnitt des Gantry-Balkens" bezeichnet in diesem Zusammenhang einen sich in der zweiten Richtung erstreckenden Längsabschnitt des Gantry-Balkens, welcher sich in der zweiten Richtung über eine Länge erstreckt, welche höchstens 50% der Erstreckung des Gantry-Balkens in der zweiten Richtung beträgt, und welcher bezüglich des ersten Endes des Gantry-Balkens und des zweiten Endes Gantry-Balkens jeweils einen Abstand in der zweiten Richtung aufweist, welcher mindestens 25% der Erstreckung des Gantry-Balkens in der zweiten Richtung beträgt.

Die Luftlager der dritten Luftlager-Anordnung haben den Effekt, dass diese Luftlager im Betrieb der Positioniervorrichtung die Torsions- und Biegesteifigkeit des Gantry-Balkens in Bezug auf die erste Richtung und/oder die zweite Richtung bei einer Beschleunigung des Gantry-Balkens in der ersten Richtung mittels der Linearantriebe der ersten Linearachse und bei einer Beschleunigung des beweglichen Elements in der zweiten Richtung mittels des Linearantriebs der zweiten Linearachse erhöhen und somit eine mittels einer Beschleunigung des Gantry-Balkens in der ersten Richtung und/oder mittels einer Beschleunigung des beweglichen Elements in der zweiten Richtung induzierbare Torsion oder Biegung der Gantry-Achse reduziert wird.

Dadurch, dass das mindestens eine dritte horizontale Luftlager und das mindestens eine vierte horizontale Luftlager relativ zueinander einen Abstand in der ersten Richtung aufweisen, sind das mindestens eine dritte horizontale Luftlager und das mindestens eine vierte horizontale Luftlager insbesondere geeignet, gemeinsam die Torsionssteifigkeit des Gantry-Balkens hinsichtlich einer Torsion des Gantry-Balkens um die zweite Richtung bei einer Beschleunigung des Gantry-Balkens in der ersten Richtung zu erhöhen. Die Erhöhung der Torsionssteifigkeit des Gantry-Balkens wird hierbei massgeblich durch die Grösse der jeweiligen Steifigkeit des mindestens einen dritten horizontalen Luftlagers und des mindestens einen vierten horizontalen Luftlagers bestimmt (derart, dass die Erhöhung der Torsionssteifigkeit des Gantry-Balkens umso grösser ist, je grösser die jeweilige Steifigkeit des mindestens einen dritten horizontalen Luftlagers und des mindestens einen vierten horizontalen Luftlagers ist).

Dadurch, dass der sich in der ersten Richtung erstreckende Führungsbalken neben dem dritten Abschnitt der ebenen Führungsfläche angeordnet ist, und dadurch, dass der mittlere Abschnitt des Gantry-Balkens mittels des mindestens einen seitlichen Luftlagers an der ebenen Seitenfläche des Führungsbalkens und mittels des mindestens einen dritten horizontalen Luftlager und des mindestens einen vierten horizontalen Luftlagers am dritten Abschnitt der ebenen Führungsfläche gestützt bzw. geführt ist, sind das mindestens eine seitlichen Luftlager und das mindestens eine dritte horizontale Luftlager und das mindestens eine vierte horizontale Luftlagers aufgrund ihrer Anordnung relativ zueinander geeignet, gemeinsam die Steifigkeit des Gantry-Balkens hinsichtlich einer Torsion oder Biegung des Gantry-Balkens um die erste Richtung bei einer Beschleunigung des beweglichen Elements in der zweiten Richtung zu erhöhen. Die Erhöhung der Steifigkeit des Gantry-Balkens hinsichtlich einer Torsion oder Biegung des Gantry-Balkens um die erste Richtung wird hierbei massgeblich durch die Grösse der jeweiligen Steifigkeit des mindestens einen seitlichen Luftlagers, des mindestens einen dritten horizontalen Luftlager und des mindestens einen vierten horizontalen Luftlagers bestimmt (derart, dass Erhöhung der Steifigkeit des Gantry-Balkens hinsichtlich einer Torsion oder Biegung des Gantry-Balkens um die erste Richtung umso grösser ist, je grösser die jeweilige Steifigkeit des mindestens einen seitlichen Luftlagers, des mindestens einen dritten horizontalen Luftlager bzw. des mindestens einen vierten horizontalen Luftlagers ist).

Die dritte Luftlager-Anordnung bildet u.a. aus den im Folgenden genannten Gründen eine Voraussetzung dafür, dass die erfindungsgemässe Vorrichtung Positioniervorrichtung einen kompakten Aufbau (mit einer verhältnismässig kleinen Grundfläche) aufweisen kann und zudem geeignet ist, das bewegliche Element mit einer relativ grossen Beschleunigung über eine verhältnismässig grosse Fläche zu bewegen (im Vergleich zur Grundfläche der Positioniervorrichtung).

Einerseits ist der die ebene Seitenfläche aufweisende Führungsbalken an der Basis neben dem dritten Abschnitt der ebenen Führungsfläche angeordnet und erstreckt sich in der ersten Richtung im Bereich des mittleren Abschnitts des Gantry-Balkens durch einen Zwischenraum zwischen dem Gantry-Balken und der ebenen Führungsfläche der Basis (im Unterschied zu der aus der Druckschrift CN 113977294 A bekannten Positioniervorrichtung, bei welcher eine seitliche Führungsfläche seitlich neben dem Gantry-Balken in der Nähe eines der Enden des Gantry-Balkens in einem Abstand zu diesem einen Ende des Gantry-Balkens platziert ist, wie oben erläutert). Aufgrund dieser Anordnung des Führungsbalkens ist in vorteilhafter Weise der Platzbedarf der erfindungsgemässen Positioniervorrichtung mit Bezug auf die Erstreckung der Positioniervorrichtung in der zweiten Richtung (entsprechend der Längsrichtung des Gantry-Balkens) reduziert. Die Anordnung des Führungsbalkens scheint andererseits im Hinblick auf eine hochdynamische Ausbildung der erfindungsgemässen Positioniervorrichtung insofern mit einem nachteiligen Effekt verbunden zu sein, als der Gantry-Balken wegen der Anordnung des Führungsbalkens, einen vorgegebenen Abstand zur ebenen Führungsfläche der Basis haben muss, welcher grösser ist als die Erstreckung der ebenen Seitenfläche des Führungsbalkens in der dritten Richtung. Aufgrund der Anordnung des Führungsbalkens kann auf den Gantry-Balken deshalb bei einer Beschleunigung des Gantry-Balkens in der ersten Richtung ein "erhöhtes" Torsionsmoment in Richtung der zweiten Richtung wirken (im Vergleich zu einem entsprechenden Torsionsmoment, welches auf den Gantry-Balken bei gleicher Beschleunigung des Gantry-Balkens in der ersten Richtung wirken würde, wenn der Gantry-Balken einen Abstand zur ebenen Führungsfläche der Basis hätte, welcher geringer ist als die Erstreckung der ebenen Seitenfläche des Führungsbalkens in der dritten Richtung). Der vorstehend genannte nachteilige Effekt kann im Falle der erfindungsgemässen Positioniervorrichtung allerdings ohne weiteres in Kauf genommen werden, als die dritte Luftlager-Anordnung derart ausgebildet werden kann, dass die Torsionssteifigkeit des Gantry-Balkens mit Bezug auf eine Torsion um die zweite Richtung während einer Beschleunigung in der ersten Richtung durch die dritte Luftlager-Anordnung derart vergrössert ist, dass der vorstehend genannte nachteilige Effekt im Vergleich zu der Erhöhung der Torsionssteifigkeit des Gantry-Balkens aufgrund der dritten Luftlager-Anordnung relativ klein ist.

Die mittels der dritten Luftlager-Anordnung erzielbare Erhöhung der Torsions- und Biegesteifigkeit des Gantry-Balkens in Bezug auf die erste Richtung und/oder die zweite Richtung bei einer Beschleunigung des Gantry-Balkens in der ersten Richtung und bei einer Beschleunigung des beweglichen Elements in der zweiten Richtung bietet ausserdem eine Voraussetzung dafür, dass darauf verzichtet werden kann, das bewegliche Element mittels horizontalen Luftlagern ebenfalls an der ebenen Führungsfläche der Basis zu führen (im Unterschied zu der aus der Druckschrift CN 113977294 A bekannten Positioniervorrichtung). Die mittels der dritten Luftlager-Anordnung erzielbare Erhöhung der Torsions- und Biegesteifigkeit des Gantry-Balkens ermöglicht es, das bewegliche Element bei einer Bewegung in der zweiten Richtung ausschliesslich am Gantry-Balken zu führen und trotzdem zu gewährleisten, dass die Positioniervorrichtung hochdynamisch ausgebildet ist und Deformationen des Gantry-Balkens selbst bei einer grossen Beschleunigung des beweglichen Elements in der ersten Richtung und/oder in der zweiten Richtung in tolerablen Grenzen gehalten werden können. Dadurch, dass das bewegliche Element am Gantry-Balken derart angeordnet werden kann, dass das bewegliche Element bei einer Bewegung in der zweiten Richtung ausschliesslich am Gantry-Balken geführt ist, ist es möglich, das bewegliche Element am Gantry-Balken derart zu führen, dass das bewegliche Element im Wesentlichen über die gesamte Länge des Gantry-Balkens in der zweiten Richtung bewegt werden kann. Im Vergleich zu der aus Druckschrift CN 113977294 A bekannten Positioniervorrichtung ist auf diese Weise die Länge der Distanz, über welche das bewegliche Element in der zweiten Richtung bewegbar ist, vergrössert.

Eine Ausführungsform der Positioniervorrichtung ist derart ausgebildet, dass die dritte Luftlager-Anordnung zwei dritte horizontale Luftlager und zwei vierte horizontale Luftlager zum Führen des mittleren Abschnitts des Gantry-Balkens an dem dritten Abschnitt der ebenen Führungsfläche umfasst, wobei die zwei dritten horizontalen Luftlager relativ zueinander derart angeordnet sind, dass die zwei dritten horizontalen Luftlager relativ zueinander einen Abstand in der zweiten Richtung aufweisen, und die zwei vierten horizontalen Luftlager relativ zueinander derart angeordnet, dass die zwei vierten horizontalen Luftlager relativ zueinander einen Abstand in der zweiten Richtung aufweisen, wobei die zwei dritten horizontalen Luftlager und die zwei vierten horizontalen Luftlager bezüglich des dritten Abschnitts der ebenen Führungsfläche vorgespannt sind. Durch das Bereitstellen von zwei dritten horizontalen Luftlager und zwei vierten horizontalen Luftlagern in der vorstehend genannten Weise ermöglicht die dritte Luftlager-Anordnung eine zusätzliche Erhöhung der Steifigkeit des Gantry-Balkens mit Bezug auf eine Torsion oder Biegung des Gantry-Balkens um die erste Richtung bei einer Beschleunigung des beweglichen Elements in der zweiten Richtung. Der Abstand der zwei dritten Luftlager relativ zueinander in der zweiten Richtung und der Abstand der zwei vierten horizontalen Luftlager relativ zueinander in der zweiten Richtung können jeweils geeignet gewählt werden, um die Steifigkeit des Gantry-Balkens um einen vorgegebenen Wert zu erhöhen.

Eine andere Ausführungsform der Positioniervorrichtung ist derart ausgebildet, dass die dritte Luftlager-Anordnung zwei seitliche Luftlager zum Führen des Gantry-Balkens an der ebenen Seitenfläche des Führungsbalkens umfasst, wobei die zwei seitlichen Luftlager relativ zueinander derart angeordnet sind, dass sie relativ zueinander einen Abstand in der ersten Richtung aufweisen, und wobei die zwei seitlichen Luftlager bezüglich der ebenen Seitenfläche des Führungsbalkens vorgespannt sind. Die Verwendung von seitlichen Luftlagern, welche relativ zueinander einen Abstand in der ersten Richtung aufweisen, ermöglicht eine stabilere Führung des Gantry-Balkens an der ebenen Seitenfläche des Führungsbalkens bei einer Bewegung des Gantry-Balkens in der ersten Richtung, insbesondere derart, dass eine Bewegung des Gantry-Balkens bezüglich einer Torsion oder Drehung des Gantry-Balkens um die dritte Richtung stabilisiert wird.

Eine andere Ausführungsform der Positioniervorrichtung ist derart ausgebildet, dass die erste Luftlager-Anordnung zwei erste horizontale Luftlager zum Führen des ersten Endes des Gantry-Balkens an dem ersten Abschnitt der ebenen Führungsfläche umfasst, wobei die zwei ersten horizontalen Luftlager relativ zueinander derart angeordnet sind, dass die zwei ersten horizontalen Luftlager relativ zueinander einen Abstand in der ersten Richtung aufweisen, wobei die zwei ersten horizontalen Luftlager bezüglich des ersten Abschnitts der ebenen Führungsfläche vorgespannt sind. Dadurch, dass die erste Luftlager-Anordnung zwei (in einem Abstand in der ersten Richtung relativ zueinander angeordnete) erste horizontale Luftlager aufweist, ermöglicht die erste Luftlager-Anordnung eine Erhöhung der Steifigkeit des ersten Endes des Gantry-Balkens mit Bezug auf eine Drehung oder Torsion des Gantry-Balkens um die zweite Richtung, sodass eine Bewegung des ersten Endes des Gantry-Balkens in der ersten Richtung bezüglich einer Drehung oder Torsion des Gantry-Balkens um die zweite Richtung stabilisiert ist. Die Erhöhung der Steifigkeit ist hierbei abhängig vom Abstand zwischen den zwei ersten horizontalen Luftlagern in der ersten Richtung, sodass die Steifigkeit in der Regel umso grösser ist, je grösser der Abstand zwischen den zwei ersten horizontalen Luftlagern in der ersten Richtung gewählt wird.

Eine andere Ausführungsform der Positioniervorrichtung ist derart ausgebildet, dass die zweite Luftlager-Anordnung zwei zweite horizontale Luftlager zum Führen des zweiten Endes des Gantry-Balkens an dem zweiten Abschnitt der ebenen Führungsfläche umfasst, wobei die zwei zweiten horizontalen Luftlager relativ zueinander derart angeordnet sind, dass die zwei zweiten horizontalen Luftlager in der ersten Richtung relativ zueinander einen Abstand aufweisen, wobei die zwei zweiten horizontalen Luftlager bezüglich des zweiten Abschnitts der ebenen Führungsfläche vorgespannt sind. Dadurch, dass die zweite Luftlager-Anordnung zwei (in einem Abstand in der ersten Richtung relativ zueinander angeordnete) zweite horizontale Luftlager aufweist, ermöglicht die zweite Luftlager-Anordnung eine Erhöhung der Steifigkeit des zweiten Endes des Gantry-Balkens mit Bezug auf eine Drehung oder Torsion des Gantry-Balkens um die zweite Richtung, sodass eine Bewegung des zweiten Endes des Gantry-Balkens in der ersten Richtung bezüglich einer Drehung oder Torsion des Gantry-Balkens um die zweite Richtung stabilisiert ist. Die Erhöhung der Steifigkeit ist hierbei abhängig vom Abstand zwischen den zwei zweiten horizontalen Luftlagern in der ersten Richtung, sodass die Steifigkeit in der Regel umso grösser ist, je grösser der Abstand zwischen den zwei zweiten horizontalen Luftlagern in der ersten Richtung gewählt wird.

Eine andere Ausführungsform der Positioniervorrichtung ist derart ausgebildet, dass sie eine zweite Luftlager-Einrichtung mit mehreren mit dem beweglichen Element verbundenen Luftlagern zum Führen des beweglichen Elements am Gantry-Balken aufweist. Die zweite Luftlager-Einrichtung hat den Effekt, dass das bewegliche Element mittels der Luftlager der zweiten Luftlager-Einrichtung berührungslos und reibungsfrei ausschliesslich am Gantry-Balken geführt werden kann (ohne dass das bewegliche Element mittels Luftlagern an der ebenen Führungsfläche der Basis gestützt bzw. geführt werden muss). Die Luftlager der zweiten Luftlager-Einrichtung können hierbei relativ zum beweglichen Element und relativ zum Gantry-Balken und relativ zu den jeweiligen Luftlagern der ersten Luftlager-Einrichtung derart angeordnet werden, dass keines der Luftlager der zweiten Luftlager-Einrichtung mit einem der Luftlager der ersten Luftlager-Einrichtung kollidieren kann. Zu diesem Zweck können alle Luftlager der zweiten Luftlager-Einrichtung in einer Höhe mit Bezug auf die ebene Führungsfläche der Basis platziert werden, dass die Luftlager der zweiten Luftlager oberhalb der Luftlager der ersten Luftlager-Einrichtung angeordnet ist. Unter diesen Umständen können die Luftlager der zweiten Luftlager-Einrichtung am beweglichen Element mit Bezug auf den Gantry-Balken derart angeordnet sein, dass das bewegliche Element in der zweiten Richtung - geführt durch die Luftlager der zweiten Luftlager-Einrichtung - im Wesentlichen entlang der gesamten Erstreckung des Gantry-Balkens in der zweiten Richtung bewegt werden kann.

Die zweite Luftlager-Einrichtung und der Gantry-Balken können insbesondere so ausgebildet sein, dass das bewegliche Element - mittels der Luftlager der zweiten Luftlager-Einrichtung am Gantry-balken geführt - linear in der zweiten Richtung am Gantry-Balken bewegbar ist. Die Luftlager der zweiten Luftlager-Einrichtung und der Gantry-Balken bilden hierbei eine Linearführung für das bewegliche Element, derart, dass das bewegliche Element linear in der zweiten Richtung bewegbar ist. Diese Linearführung in Kombination mit dem Linearantrieb, der zum Bewegen des beweglichen Elements in der zweiten Richtung mit dem beweglichen Element verbunden ist, repräsentiert die "zweite Linearachse" der Positioniervorrichtung.

Eine Weiterentwicklung der vorstehend genannten Ausführungsform der Positioniervorrichtung ist derart ausgebildet, dass der Gantry-Balken eine ebene Führungsfläche aufweist, welche parallel zu der ersten Richtung und parallel zu der zweiten Richtung angeordnet ist, und dass der Gantry-Balken eine ebene Seitenfläche aufweist, welche sich parallel zur zweiten Richtung und parallel zu einer im Wesentlichen senkrecht zur ebenen Führungsfläche des Gantry-Balkens gerichteten dritten Richtung erstreckt (die Formulierung "im Wesentlichen senkrecht" soll andeuten, dass die "dritte Richtung" sich entlang einer Geraden erstreckt, welche entweder senkrecht zur ebenen Führungsfläche des Gantry-Balkens gerichtet oder mit einem Neigungswinkel im Bereich von 0° bis 5° bezüglich einer senkrecht zur ebenen Führungsfläche des Gantry-Balkens gerichteten Geraden geneigt ist). Hierbei umfasst die zweite Luftlager-Einrichtung mindestens ein erstes horizontales Luftlager und mindestens ein zweites horizontales Luftlager, welches mindestens eine erste horizontale Luftlager und welches mindestens eine zweite horizontale Luftlager am beweglichen Element derart angeordnet sind, dass das bewegliche Element mittels des mindestens einen ersten horizontalen Luftlagers und mittels des mindestens einen zweiten horizontalen Luftlagers der zweiten Luftlager-Einrichtung an der ebenen Führungsfläche des Gantry-Balkens geführt ist, wobei das mindestens eine erste horizontale Luftlager relativ zu dem mindestens einen zweiten horizontalen Luftlager der zweiten Luftlager-Einrichtung einen Abstand in der zweiten Richtung aufweist und das mindestens eine erste horizontale Luftlager und das mindestens eine zweite horizontale Luftlager der zweiten Luftlager-Einrichtung bezüglich der ebenen Führungsfläche des Gantry-Balkens vorgespannt sind. Ausserdem umfasst die zweite Luftlager-Einrichtung mindestens ein am beweglichen Element angeordnetes seitliches Luftlager zum Führen des beweglichen Elements an der einen ebenen Seitenfläche des Gantry-Balkens, wobei das mindestens eine seitliche Luftlager der zweiten Luftlager-Einrichtung bezüglich der einen ebenen Seitenfläche des Gantry-Balkens vorgespannt ist.

Bei dieser Weiterentwicklung der vorstehend genannten Ausführungsform sind das mindestens eine erste horizontale Luftlager und das mindestens eine zweite horizontale Luftlager der zweiten Luftlager-Einrichtung vorgesehen, um das bewegliche Element bei einer Bewegung in der zweiten Richtung auf der ebenen Führungsfläche des Gantry-Balkens zu stützen. Das mindestens eine seitliche Luftlager der zweiten Luftlager-Einrichtung ist dafür vorgesehen, das bewegliche Element bei einer Bewegung in der zweiten Richtung seitlich an der einen ebenen Seitenfläche des Gantry-Balkens zu führen, sodass das bewegliche Element linear in der zweiten Richtung bewegbar ist.

Die jeweiligen horizontalen Luftlager der zweiten Luftlager-Einrichtung und die jeweiligen seitlichen Luftlager der zweiten Luftlager-Einrichtung wirken mit der ebenen Führungsfläche des Gantry-Balkens und der ebenen Seitenfläche des Gantry-Balkens derart zusammen, dass das bewegliche Element mittels der horizontalen Luftlager und der seitlichen Luftlager der zweiten Luftlager-Einrichtung derart geführt ist, dass das bewegliche Element linear in der zweiten Richtung bewegbar ist. Diese Linearführung des beweglichen Elements repräsentiert in Kombination mit dem Linearantrieb, der zum Bewegen des beweglichen Elements in der zweiten Richtung mit dem beweglichen Element verbunden ist, die "zweite Linearachse" der Positioniervorrichtung.

Dadurch, dass das mindestens eine seitliche Luftlager der zweiten Luftlager-Einrichtung bezüglich der einen ebenen Seitenfläche des Gantry-Balkens vorgespannt ist, ist das eine seitliche Luftlager geeignet, das bewegliche Element bei einer Bewegung in der zweiten Richtung seitlich hinreichend stabil zu führen, und zwar ausschliesslich an einer einzigen Führungsfläche, d.h. an der einen ebenen Seitenfläche des Gantry-Balkens. Um eine hinreichend stabile seitliche Führung des beweglichen Element bei einer Bewegung in der zweiten Richtung zu gewährleisten, ist es deshalb nicht notwendig, ein zusätzliches seitliches Luftlager am beweglichen Element derart anzuordnen, das das bewegliche Element mit dem zusätzlichen seitlichen Luftlager an einer zweiten Seitenfläche des Gantry-Balkens, welche der vorstehend genannten einen ebenen Seitenfläche des Gantry-Balkens mit Bezug auf die erste Richtung gegenüberliegend angeordnet ist, seitlich geführt ist. Auf diese Weise ist gewährleistet, dass die Luftlager der zweiten Luftlager-Einrichtung mit einem relativ geringen Platzbedarf am Gantry-Balken angeordnet werden können. Da das bewegliche Element am Gantry-Balken seitlich ausschliesslich mit dem mindestens einen seitlichen Luftlager an der einen ebenen Seitenfläche des Gantry-Balkens geführt ist, kann eine der einen ebenen Seitenfläche in der ersten Richtung gegenüberliegende zweite Seitenfläche des Gantry-Balkens derart gestaltet sein, dass diese zweite Seitenfläche weder vom beweglichen Element noch von einem der Luftlager der zweiten Luftlager-Einrichtung bedeckt ist und deshalb derart frei zugänglich ist, dass diese zweite Seitenfläche Platz bietet, um an dieser zweiten Seitenfläche bestimmte funktionelle Elemente der Positioniervorrichtung zu befestigen (beispielsweise Versorgungsleitungen zur Versorgung der Luftlager mit Druckluft und/oder elektrische Leitungen zur Versorgung der Linearantriebe der zwei ersten Linearachsen und des Linearantriebs der zweiten Linearachse mit elektrischer Energie).

Dadurch, dass das mindestens eine erste horizontale Luftlager und das mindestens eine zweite horizontale Luftlager der zweiten Luftlager-Einrichtung relativ zueinander einen Abstand in der zweiten Richtung aufweisen, sind das vorstehend genannte erste horizontale Luftlager und das vorstehend genannte zweite horizontale Luftlager ausgebildet, bei einer beschleunigten Bewegung des beweglichen Elements in der zweiten Richtung entlang des Gantry-Balkens die räumliche Lage des beweglichen Elements hinsichtlich einer Drehung oder Torsion des beweglichen Elements um die erste Richtung zu stabilisieren. Des Weiteren sind das mindestens eine erste horizontale Luftlager, das mindestens eine zweite horizontale Luftlager und das mindestens eine seitliche Luftlager ausgebildet, gemeinsam bei einer beschleunigten Bewegung des beweglichen Elements in der ersten Richtung die räumliche Lage des beweglichen Elements hinsichtlich einer Drehung oder Torsion des beweglichen Elements um die zweite Richtung zu stabilisieren.

In einer Variante der oben beschriebenen Weiterentwicklung kann die Positioniervorrichtung derart ausgebildet sein, dass die zweite Luftlager-Einrichtung zwei am beweglichen Element angeordnete erste horizontale Luftlager zum Führen des beweglichen Elements an der ebenen Führungsfläche des Gantry-Balkens umfasst, wobei die zwei ersten horizontalen Luftlager der zweiten Luftlager-Einrichtung relativ zueinander einen Abstand in der ersten Richtung aufweisen und bezüglich der ebenen Führungsfläche des Gantry-Balkens vorgespannt sind. Alternativ oder zusätzlich kann die Positioniervorrichtung derart ausgebildet sein, dass die zweite Luftlager-Einrichtung zwei am beweglichen Element angeordnete zweite horizontale Luftlager zum Führen des beweglichen Elements an der ebenen Führungsfläche des Gantry-Balkens umfasst, wobei die zwei zweiten horizontalen Luftlager der zweiten Luftlager-Einrichtung relativ zueinander einen Abstand in der ersten Richtung aufweisen und bezüglich der ebenen Führungsfläche des Gantry-Balkens vorgespannt sind. Alternativ oder zusätzlich kann die Positioniervorrichtung ausserdem derart ausgebildet sein, dass die zweite Luftlager-Einrichtung zwei am beweglichen Element angeordnete seitliche Luftlager zum Führen des beweglichen Elements an der einen ebenen Seitenfläche des Gantry-Balkens umfasst, wobei die zwei seitlichen Luftlager der zweiten Luftlager-Einrichtung relativ zueinander einen Abstand in der zweiten Richtung aufweisen und bezüglich der ebenen Seitenfläche des Gantry-Balkens vorgespannt sind. Dadurch, dass die zweite Luftlager-Einrichtung in der vorstehend genannten Weise zwei am beweglichen Element angeordnete erste horizontale Luftlager und/oder zwei am beweglichen Element angeordnete zweite horizontale Luftlager und/oder zwei am beweglichen Element angeordnete seitliche Luftlager aufweist, wird erreicht, dass die räumliche Lage des beweglichen Elements bei einer beschleunigten Bewegung des beweglichen Elements in der ersten Richtung und/oder bei einer beschleunigten Bewegung des beweglichen Elements in der zweiten Richtung besonders effektiv stabilisiert werden kann, und zwar hinsichtlich einer Drehung oder Torsion des beweglichen Elements um die erste Richtung und/oder hinsichtlich einer Drehung oder Torsion des beweglichen Elements um die zweite Richtung und/oder hinsichtlich einer Drehung oder Torsion des beweglichen Elements um die dritte Richtung.

Um zu erreichen, dass die jeweiligen Luftlager der Positioniervorrichtung bezüglich einer Fläche vorgespannt sind, können beispielsweise geeignete magnetische Mittel bereitgestellt werden, beispielsweise derart, dass das mindestens eine (oder alternativ jedes) erste horizontale Luftlager und das mindestens eine (oder alternativ jedes) zweite horizontale Luftlager der zweiten Luftlager-Einrichtung mit magnetischen Mitteln bezüglich der ebenen Führungsfläche des Gantry-Balkens vorgespannt sind, und/oder das mindestens eine (oder alternativ jedes) seitliche Luftlager der zweiten Luftlager-Einrichtung mit magnetischen Mitteln bezüglich der einen ebenen Seitenfläche des Gantry-Balkens vorgespannt ist. Zu diesem Zweck kann beispielsweise der Gantry-Balken aus einem ferromagnetischen Werkstoff (beispielsweise Stahl) ausgebildet sein und das mindestens eine (oder alternativ jedes) erste horizontale Luftlager und das mindestens eine (oder alternativ jedes) zweite horizontale Luftlager der zweiten Luftlager-Einrichtung jeweils mit einem Permanentmagneten versehen sein. Aufgrund einer gegenseitigen magnetischen Anziehung zwischen dem ferromagnetischen Werkstoff des Gantry-Balkens und einem in dem jeweiligen Luftlager angeordneten Ferromagneten wird jeweils eine auf das jeweilige Luftlager wirkende, auf den Gantry-Balken gerichtete Vorspannkraft des jeweiligen Luftlagers erzeugt.

Um die Luftlager der ersten Luftlager-Anordnung vorzuspannen, können entsprechend magnetische Mittel derart bereitgestellt werden, dass das mindestens eine (oder alternativ jedes) erste horizontale Luftlager der ersten Luftlager-Anordnung mit magnetischen Mitteln bezüglich des ersten Abschnitts der ebenen Führungsfläche der Basis vorgespannt ist, und/oder das mindestens eine (oder alternativ jedes) zweite horizontale Luftlager der zweiten Luftlager-Anordnung mit magnetischen Mitteln bezüglich des zweiten Abschnitts der ebenen Führungsfläche vorgespannt ist, und/oder das mindestens eine (oder alternativ jedes) dritte horizontale Luftlager der dritten Luftlager-Anordnung und das mindestens eine (oder alternativ jedes) vierte horizontale Luftlager der dritten Luftlager-Anordnung mit magnetischen Mitteln bezüglich des dritten Abschnitts der ebenen Führungsfläche vorgespannt sind, und/oder das mindestens eine (oder alternativ jedes) seitliche Luftlager der dritten Luftlager-Anordnung mit magnetischen Mitteln bezüglich der einen ebenen Seitenfläche des Führungsbalkens vorgespannt ist. Zu diesem Zweck können beispielsweise ein horizontales (oder alternativ jedes horizontale) Luftlager der ersten Luftlager-Einrichtung mit einem Permanentmagneten versehen sein und die Basis aus einem ferromagnetischen Material gefertigt sein oder alternativ zumindest bestimmte Bereiche der Basis an der ebenen Führungsfläche aus einem ferromagnetischen Material gebildet sein. Analog kann beispielsweise ein seitliches Luftlager der dritten Luftlager-Anordnung mit einem Permanentmagneten versehen sein und der Führungsbalken aus einem ferromagnetischen Material gefertigt sein.

Ein Vorspannen der Luftlager mit magnetischen Mitteln hat den Vorteil, dass eine relativ grosse Vorspannkraft eines Luftlagers mit einem relativ kleinen Permanentmagneten erzeugt werden kann, was in vorteilhafter Weise den Platzbedarf reduziert, welcher für die Anordnung der jeweiligen Luftlager benötigt wird, und somit eine Voraussetzung für eine besonders kompakte, platzsparende Anordnung der Luftlager schafft.

Alternativ zu einem mit magnetischen Mitteln vorgespannten Luftlager ist es selbstverständlich auch möglich, vakuumvorgespannte Luftlager zu verwenden. Vakuumvorgespannte Luftlager haben in der Regel (im Vergleich zu einem mit magnetischen Mitteln vorgespannten Luftlager) einen grösseren Platzbedarf, um die Erzeugung einer bestimmten vorgegebenen Vorspannkraft zu gewährleisten.

Eine andere Ausführungsform der Positioniervorrichtung ist derart ausgebildet, dass jedes dritte horizontale Luftlager der dritten Luftlager-Anordnung, jedes vierte horizontale Luftlager der dritten Luftlager-Anordnung und jedes seitliche Luftlager der dritten Luftlager-Anordnung an einem gemeinsamen Träger befestigt sind und der Träger am Gantry-Balken befestigt ist, sodass die dritte Luftlager-Anordnung mittels des Trägers am Gantry-Balken gehalten ist. Dadurch, dass alle Luftlager der dritten Luftlager-Anordnung an einem gemeinsamen Träger befestigt sind, bilden die Luftlager der dritten Luftlager-Anordnung zusammen mit dem Träger eine einzige Baugruppe, welche als Ganzes (als eine Einheit) gehandhabt werden kann, beispielsweise um die Luftlager der dritten Luftlager-Anordnung relativ zum Gantry-Balken oder relativ zur ebenen Führungsfläche der Basis oder relativ zum Führungsbalken anzuordnen oder mit Bezug auf die erste Richtung, die zweite Richtung und/oder die dritte Richtung auszurichten. Dies erleichtert eine präzise räumliche Anordnung aller Luftlager der dritten Luftlager-Anordnung. Der Träger bietet zudem die Möglichkeit, Versorgungsleitungen zum Versorgen der Luftlager mit während eines Betriebs der Positioniervorrichtung benötigten Betriebsmitteln (z.B. zur Versorgung der jeweiligen Luftlager mit Druckluft) am Träger zu befestigen, sodass die Luftlager der dritten Luftlager-Anordnung zusammen mit dem Träger und den jeweiligen Versorgungsleitungen als eine einzige kompakte Baugruppe bereitgestellt werden können. Der Träger kann insbesondere als ein Gehäuse ausgebildet sein, welches dazu bestimmt ist, Komponenten der Luftlager der dritten Luftlager-Anordnung und/oder Versorgungsleitungen zum Versorgen dieser Luftlager mit Betriebsmitteln aufzunehmen.

Eine Weiterentwicklung der vorstehend genannten Ausführungsform der Positioniervorrichtung ist derart konzipiert, dass der Träger unterhalb des Gantry-Balkens in einem Zwischenraum zwischen dem Gantry-Balken und der ebenen Führungsfläche angeordnet ist. Auf diese Weise ist eine konstruktive Voraussetzung dafür gegeben, dass der Gantry-Balken während eines Betriebs der Positioniervorrichtung auf eine einfache Weise an einer der ebenen Führungsfläche zugewandten Seite von einer einzigen Baugruppe, welche den Träger und die am Träger angeordneten Luftlager umfasst und eine Einheit bildet, gestützt wird, wobei die vorstehend genannte Baugruppe als Ganzes mittels der Luftlager sowohl an der ebenen Führungsfläche der Basis als auch an der einen ebenen Seitenfläche des Führungsbalkens geführt ist und somit ein Gleitelement bildet, welches den Gantry-Balken bzw. insbesondere den mittleren Abschnitt des Gantry-Balkens berührungslos und reibungsfrei an der ebenen Führungsfläche der Basis stützt und führt und ausserdem seitlich an der einen ebenen Seitenfläche des Führungsbalkens führt.

Eine andere Weiterentwicklung der vorstehend genannten Ausführungsform der Positioniervorrichtung ist derart ausgebildet, dass der Träger an dem Gantry-Balken derart drehbar gelagert ist, dass der Träger gemeinsam mit jedem dritten horizontalen Luftlager der dritten Luftlager-Anordnung, jedem vierten horizontalen Luftlager der dritten Luftlager-Anordnung und jedem seitlichen Luftlager der dritten Luftlager-Anordnung relativ zu dem Gantry-Balken um eine sich in der dritten Richtung erstreckende Drehachse drehbar ist. Dadurch, dass der Träger um eine sich in der dritten Richtung erstreckende Drehachse drehbar ist, besteht die Möglichkeit, dass die räumliche Lage der dritten Luftlager-Anordnung als Ganzes während eines Betriebs der Positioniervorrichtung relativ zum Gantry-Balken mittels einer Drehung des Trägers um die Drehachse geändert werden kann. Auf diese Weise kann die dritte Luftlager-Anordnung immer in einer vorgegebenen stabilen Position mit Bezug auf die ebene Seitenfläche des Führungsbalkens angeordnet sein, selbst wenn während eines Betriebs der Positioniervorrichtung die Ausrichtung der Längsrichtung des Gantry-Balkens (entsprechend der zweiten Richtung) relativ zur ersten Richtung geändert werden sollte (beispielsweise dann, wenn die Linearmotoren der beiden ersten Linearachsen derart gesteuert werden sollten, dass das erste Ende des Gantry-Balkens und das zweite Ende des Gantry-Balkens nicht synchron mit jeweils derselben Geschwindigkeit in der ersten Richtung bewegt werden). Auf diese Weise können insbesondere Kollisionen der seitlichen Luftlager der dritten Luftlager-Anordnung mit der ebenen Seitenfläche des Führungsbalkens vermieden werden und somit die seitlichen Luftlager der dritten Luftlager-Anordnung vor einer Überlastung bzw. vor einer Beschädigung aufgrund einer Kollision mit dem Führungsbalken geschützt werden.

Eine andere Weiterentwicklung der vorstehend genannten Ausführungsform der Positioniervorrichtung ist derart ausgebildet, dass der Träger mit dem Gantry-Balken über ein Drehgelenk verbunden ist, welches aus einem oder mehreren Festkörpergelenken gebildet ist. Die Verwendung eines oder mehrerer Festkörpergelenke ermöglicht eine reibungsfreie und spielfreie Relativbewegung zwischen dem Träger und dem Gantry-Balken und bietet eine einfache Möglichkeit, die Anordnung des Trägers relativ zum Gantry-Balken präzise kontrollierbar und reproduzierbar zu ändern.

Eine andere Weiterentwicklung der vorstehend genannten Ausführungsform der Positioniervorrichtung umfasst ein erstes Festkörpergelenk und ein zweites Festkörpergelenk. Das erste Festkörpergelenk besteht aus einem ersten länglichen Festkörper, welcher sich entlang einer zur dritten Richtung parallelen ersten Ebene senkrecht zur dritten Richtung erstreckt und eine senkrecht zur dritten Richtung angeordnete Längsachse aufweist, wobei der erste längliche Festkörper folgende in Richtung der Längsachse des ersten länglichen Festkörpers hintereinander angeordnete Längsabschnitte aufweist:
- einen ersten Endabschnitt, welcher ein erstes Ende des ersten länglichen Festkörpers bildet;
- einen zweiten Endabschnitt, welcher ein dem ersten Ende des ersten länglichen Festkörpers in Richtung der Längsachse des ersten länglichen Festkörpers gegenüberliegendes zweites Ende des ersten länglichen Festkörpers bildet;
- einen zwischen dem ersten Endabschnitt und dem zweiten Endabschnitt des ersten länglichen Festkörpers angeordneten Mittelabschnitt;
- einen zwischen dem ersten Endabschnitt und dem Mittelabschnitt des ersten länglichen Festkörpers angeordneten, mit dem ersten Endabschnitt und dem Mittelabschnitt verbundenen ersten Stegteil;
- einen zwischen dem zweiten Endabschnitt und dem Mittelabschnitt angeordneten, mit dem zweiten Endabschnitt und dem Mittelabschnitt des ersten länglichen Festkörpers verbundenen zweiten Stegteil.

Das zweite Festkörpergelenk besteht aus einem zweiten länglichen Festkörper, welcher sich entlang einer zur dritten Richtung parallelen zweiten Ebene senkrecht zur dritten Richtung erstreckt und eine senkrecht zur dritten Richtung angeordnete Längsachse aufweist, wobei der zweite längliche Festkörper folgende in Richtung der Längsachse des zweiten länglichen Festkörpers hintereinander angeordnete Längsabschnitte aufweist:
- einen ersten Endabschnitt, welcher ein erstes Ende des zweiten länglichen Festkörpers bildet;
- einen zweiten Endabschnitt, welcher ein dem ersten Ende des zweiten länglichen Festkörpers in Richtung der Längsachse des zweiten länglichen Festkörpers gegenüberliegendes zweites Ende des zweiten länglichen Festkörpers bildet;
- einen zwischen dem ersten Endabschnitt und dem zweiten Endabschnitt des zweiten länglichen Festkörpers angeordneten Mittelabschnitt;
- einen zwischen dem ersten Endabschnitt und dem Mittelabschnitt des zweiten länglichen Festkörpers angeordneten, mit dem ersten Endabschnitt und dem Mittelabschnitt verbundenen ersten Stegteil;
- einen zwischen dem zweiten Endabschnitt und dem Mittelabschnitt des zweiten länglichen Festkörpers angeordneten, mit dem zweiten Endabschnitt und dem Mittelabschnitt des ersten länglichen Festkörpers verbundenen zweiten Stegteil.

Dabei ist der Träger mit dem Gantry-Balken über das erste Festkörpergelenk und das zweite Festkörpergelenk derart verbunden, dass der erste Endabschnitt des ersten länglichen Festkörpers und der zweite Endabschnitt des ersten länglichen Festkörpers starr mit dem Träger und der Mittelabschnitt des ersten länglichen Festkörpers starr mit dem Gantry-Balken verbunden sind und dass der erste Endabschnitt des zweiten länglichen Festkörpers und der zweite Endabschnitt des zweiten länglichen Festkörpers starr mit dem Träger und der Mittelabschnitt des zweiten länglichen Festkörpers starr mit dem Gantry-Balken verbunden sind, wobei die erste Ebene und die zweite Ebene relativ zueinander derart geneigt sind, dass die erste Ebene und die zweite Ebene eine sich parallel zur dritten Richtung erstreckende gemeinsame Schnittlinie bilden. Der erste Stegteil und der zweite Stegteil des ersten Festkörpergelenks und der erste Stegteil und der zweite Stegteil des zweiten Festkörpergelenks sind elastisch deformierbar ausgebildet, sodass der Mittelabschnitt des ersten Festkörpergelenks relativ zum ersten Endabschnitt des ersten Festkörpergelenks und zum zweiten Endabschnitt des ersten Festkörpergelenks bewegbar ist und der Mittelabschnitt des zweiten Festkörpergelenks relativ zum ersten Endabschnitt des zweiten Festkörpergelenks und zum zweiten Endabschnitt des zweiten Festkörpergelenks bewegbar ist, wobei der Träger mittels des ersten Festkörpergelenks und des zweiten Festkörpergelenks an dem Gantry-Balken um die gemeinsame Schnittlinie der ersten Ebene und der zweiten Ebene drehbar gelagert ist.

Die Anordnung des ersten Festkörpergelenk und des zweiten Festkörpergelenk sollen in Kombination miteinander gewährleisten, dass der Träger (zusammen mit allen am Träger angeordneten Luftlagern der dritten Luftlager-Anordnung) derart drehbar am Gantry-Balken angeordnet ist, dass die Anordnung des ersten Festkörpergelenks und des zweiten Festkörpergelenk sollen in Kombination miteinander eine möglichst geringe Rotationssteifigkeit hinsichtlich einer Drehung des Trägers relativ zum Gantry-Balken um die (sich in der dritten Richtung erstreckende) gemeinsame Schnittlinie der ersten Ebene und der zweiten Ebene aufweist. Letzteres dient dazu, eine Überlastung der seitlichen Luftlager der dritten Luftlager-Anordnung oder ein Abheben der seitlichen Luftlager der dritten Luftlager-Anordnung von der ebenen Seitenfläche des Führungsbalkens für den Fall zu vermeiden, dass die beiden Linearantriebe der zwei ersten Linearachsen die beiden Enden des Gantry-Balkens nicht synchron mit derselben Geschwindigkeit in die erste Richtung bewegen sollten.

Eine möglichst geringe Rotationssteifigkeit der Anordnung des ersten Festkörpergelenks und des zweiten Festkörpergelenk in Kombination miteinander hinsichtlich einer Drehung des Trägers relativ zum Gantry-Balken um die dritte Richtung hat ausserdem den Vorteil, dass der Träger und der Gantry-Balken gemeinsam ein mittels des ersten Festkörpergelenks und des zweiten Festkörpergelenk gekoppeltes System bilden, welches hinsichtlich einer Drehung des Trägers relativ zum Gantry-Balken um die dritte Richtung eine geringe Eigenfrequenz (z.B. im Bereich von weniger als 30 Hz) aufweist. Letzteres vereinfacht eine Regelung der beiden Linearantriebe der ersten Linearachsen.

Im Hinblick auf das dynamische Verhalten der Positioniervorrichtung bei einer beschleunigten Bewegung des Gantry-Balkens in der ersten Richtung und bei einer beschleunigten Bewegung des beweglichen Elements in der zweiten Richtung wäre es andererseits vorteilhaft, dass der Träger und der Gantry-Balken gemeinsam ein mittels des ersten Festkörpergelenks und des zweiten Festkörpergelenk gekoppeltes System bilden, welches bei einer beschleunigten Bewegung des Gantry-Balkens in der ersten Richtung und bei einer beschleunigten Bewegung des beweglichen Elements in der zweiten Richtung jeweils eine grosse Steifigkeit aufweist in Bezug auf eine Translation des Trägers relativ zum Gantry-Balken in der ersten Richtung und/ oder in der zweiten Richtung und/oder in der dritten Richtung und in Bezug auf eine Rotation des Trägers relativ zum Gantry-Balken um die erste Richtung und/oder um die zweite Richtung. Eine grosse Steifigkeit des aus dem Träger und dem Gantry-Balken gebildeten gekoppelten Systems in Bezug auf eine Translation des Trägers relativ zum Gantry-Balken in der ersten Richtung und/oder in der zweiten Richtung und/oder in der dritten Richtung und in Bezug auf eine Rotation des Trägers relativ zum Gantry-Balken um die erste Richtung und/oder um die zweite Richtung ermöglichen eine schnellere Regelung der Linearantriebe der ersten Linearachse und des Linearantriebs der zweiten Linearachse, verbessern das Schwingverhalten des Trägers bzw. des Gantry-Balkens bei einer beschleunigten Bewegung des Gantry-Balkens in der ersten Richtung und bei einer beschleunigten Bewegung des beweglichen Elements in der zweiten Richtung und ermöglicht eine höhere Genauigkeit einer Positionierung des beweglichen Elements.

Die jeweiligen Steifigkeiten des aus dem Träger und dem Gantry-Balken gebildeten gekoppelten Systems hängen wesentlich von der Anordnung des ersten Festkörpergelenks und des zweite Festkörpergelenk relativ zueinander und insbesondere von der Grösse der Neigung der ersten Ebene bezüglich der zweiten Ebene ab.

Die Neigung der ersten Ebene bezüglich der zweiten Ebene (bzw. ein entsprechender Neigungswinkel der ersten Ebene bezüglich der zweiten Ebene) kann geeignet derart gewählt werden, dass die Anordnung des ersten Festkörpergelenks und des zweiten Festkörpergelenks sowohl in einer geringen Rotationssteifigkeit des aus dem Träger und dem Gantry-Balken gebildeten gekoppelten Systems hinsichtlich einer Drehung des Trägers relativ zum Gantry-Balken um die dritte Richtung resultiert und ausserdem eine grosse Steifigkeit des aus dem Träger und dem Gantry-Balken gebildeten gekoppelten Systems in Bezug auf eine Translation des Trägers relativ zum Gantry-Balken in der ersten Richtung und/oder in der zweiten Richtung und in Bezug auf eine Rotation des Trägers relativ zum Gantry-Balken um die erste Richtung und/oder die zweite Richtung gewährleistet. Letzteres wird im Sinne eines akzeptablen Kompromisses hinsichtlich der vorstehend genannten Anforderungen beispielsweise erreicht, wenn die erste Ebene bezüglich der zweiten Ebene um einen Winkel im Bereich von 30° bis 90°, vorzugsweise um einen Winkel von etwa 60°, geneigt ist.

Das erste Festkörpergelenk und das zweite Festkörpergelenk können insbesondere symmetrisch bezüglich einer dritten Ebene angeordnet sein, welche sich parallel zur zweiten Richtung und parallel zur dritten Richtung erstreckt. Diese Anordnung des ersten Festkörpergelenks und des zweiten Festkörpergelenks gewährleistet eine besonders grosse Steifigkeit des aus dem Träger und dem Gantry-Balken gebildeten gekoppelten Systems in Bezug auf eine Translation des Trägers relativ zum Gantry-Balken in der zweiten Richtung bei einer Beschleunigung des beweglichen Elements in der zweiten Richtung. Ausserdem hat eine symmetrische Anordnung des ersten Festkörpergelenks und des zweiten Festkörpergelenk bezüglich der dritten Ebene den Effekt, dass das erste Festkörpergelenk und das zweite Festkörpergelenk bei einer Beschleunigung des beweglichen Elements in der zweiten Richtung jeweils auf dieselbe Weise beansprucht werden. Dies verhindert, dass das erste Festkörpergelenk und das zweiten Festkörpergelenks bei einer Beschleunigung des beweglichen Elements in der zweiten Richtung eine Drehung des Trägers mit Bezug auf den Gantry-Balken um die dritte Richtung ermöglichen könnten, und dient einer Stabilisierung der räumlichen Lage des Trägers mit Bezug auf den Führungsbalken während einer Beschleunigung des beweglichen Elements in der zweiten Richtung.

Eine andere Weiterentwicklung der vorstehend genannten Ausführungsform ist derart ausgebildet, dass der Träger mindestens einen Hohlraum aufweist, in welchem das erste Festkörpergelenk und/oder das zweite Festkörpergelenk angeordnet ist. Diese Ausgestaltung der Trägers bietet die Möglichkeit, das erste Festkörpergelenk und/oder das zweite Festkörpergelenk in den Träger zu integrieren, sodass das erste Festkörpergelenk und/oder das zweite Festkörpergelenk nicht oder allenfalls nur um eine verhältnismässig geringe Distanz in der dritten Richtung aus dem mindestens einen Hohlraum herausragen. Auf diese Weise können der Träger und der Gantry-Balken über das erste Festkörpergelenk und/oder das zweite Festkörpergelenk derart miteinander verbunden werden, dass der Gantry-Balken und der Träger zusammen mit der dritten Luftlager-Anordnung eine relativ geringe Bauhöhe mit Bezug auf die ebene Führungsfläche der Basis haben.

Die Anordnung des ersten Festkörpergelenks und des zweiten Festkörpergelenks hat bei den vorstehend genannten Ausführungsformen den technischen Effekt, dass der Träger mittels des ersten Festkörpergelenks und des zweiten Festkörpergelenks mit Bezug auf den Gantry-Balken in einer Ruhelage gehalten ist, derart, dass der Träger mittels einer Drehung des Trägers relativ zum Gantry-Balken um die gemeinsame Schnittlinie der ersten Ebene und der zweiten Ebene aus der Ruhelage herausbewegbar ist. Der Träger befindet sich dabei in der Ruhelage, wenn sich das erste Festkörpergelenk und das zweite Festkörpergelenk jeweils in einem undeformierten Zustand befinden, sodass jeder der Mittelabschnitte dieser Festkörpergelenke jeweils relativ zum ersten Endabschnitt und zum zweiten Endabschnitt des ersten Festkörpergelenks bzw. des zweiten Festkörpergelenks in einer stabilen Lage gehalten ist. Wird der Träger mittels einer Drehung des Trägers relativ zum Gantry-Balken aus der Ruhelage bewegt, werden die Stegteile des ersten Festkörpergelenks und des zweiten Festkörpergelenks elastisch deformiert, sodass das erste Festkörpergelenks und das zweiten Festkörpergelenk gemeinsam eine auf den Träger wirkende Rückstellkraft generieren, welche der Bewegung des Gantry-Balkens aus der Ruhelage entgegenwirkt.

Die Positioniervorrichtung umfasst vorzugsweise ein oder mehrere Anschlagselemente, welche als mechanische Anschläge dienen, um eine Bewegung des Trägers aus der Ruhelage zu limitieren. Zu diesem Zweck kann der Träger beispielsweise mindestens ein Anschlagselement aufweisen, welches derart angeordnet ist, dass das Anschlagselement einen Abstand zum Mittelabschnitt des ersten Festkörpergelenks aufweist, wenn der Träger relativ zum Gantry-Balken in der Ruhelage angeordnet ist, und welches Anschlagselement mittels einer Drehung des Trägers um einen vorgegebenen maximalen Drehwinkel um die gemeinsame Schnittlinie der ersten Ebene und der zweiten Ebene in Kontakt mit dem Mittelabschnitt des ersten Festkörpergelenks bringbar ist, sodass der Mittelabschnitt des ersten Festkörpergelenks einen die Drehung des Trägers limitierenden mechanischen Anschlag für den Träger bildet. Alternativ oder zusätzlich kann der Träger mindestens ein Anschlagselement aufweisen, welches derart angeordnet ist, dass das Anschlagselement einen Abstand zum Mittelabschnitt des zweiten Festkörpergelenks aufweist, wenn der Träger relativ zum Gantry-Balken in der Ruhelage angeordnet ist, und welches Anschlagselement mittels einer Drehung des Trägers um einen vorgegebenen maximalen Drehwinkel um die gemeinsame Schnittlinie der ersten Ebene und der zweiten Ebene in Kontakt mit dem Mittelabschnitt des zweiten Festkörpergelenks bringbar ist, sodass der Mittelabschnitt des zweiten Festkörpergelenks einen die Drehung des Trägers limitierenden mechanischen Anschlag für den Träger bildet. Auf diese Weise können eine mechanische Überlastung des ersten Festkörpergelenks und des zweiten Festkörpergelenks vermieden werden.

Als Linearantriebe der Positioniervorrichtung sind beispielsweise Linearmotoren geeignet. Die Positioniervorrichtung kann beispielsweise derart ausgebildet sein, dass jeder Linearantrieb der zwei ersten Linearachsen ein Linearmotor ist und/oder der Linearantrieb der zweiten Linearachse ein Linearmotor ist. Linearantriebe anderer Bauart sind prinzipiell ebenfalls geeignet, beispielsweise Linearantriebe mit Gewindespindel oder Kugel- oder Rollengewindetrieb.

### Kurze Beschreibung der Zeichnungen

Weitere Einzelheiten der Erfindung und insbesondere beispielhafte Ausführungsformen der erfindungsgemässen Positioniervorrichtung werden im Folgenden anhand der beigefügten Zeichnungen erläutert. Es zeigen:

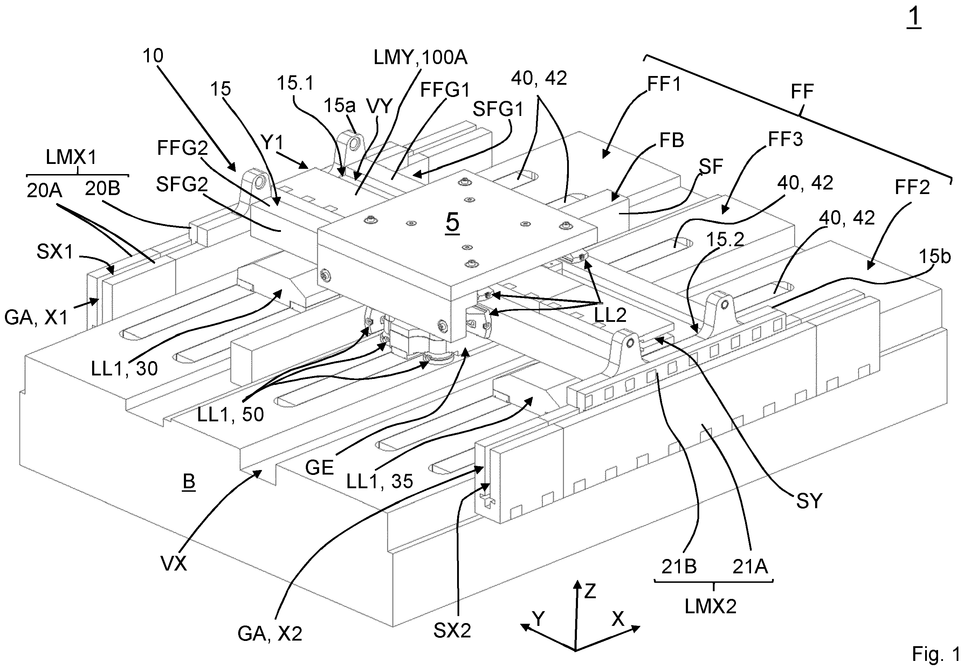

- Fig. 1: eine perspektivische Ansicht einer Ausführungsform der erfindungsgemässen Positioniervorrichtung in einer Darstellung mit Bezug auf ein Koordinatensystem mit drei Achsen X, Y, Z (X-Achse, Y-Achse, Z-Achse), mit einer Basis mit einer sich parallel zur X-Achse und parallel zur Y-Achse erstreckenden ebenen Führungsfläche, mit einer Bewegungseinrichtung in Gantry-Bauweise mit einem sich in Richtung der Y-Achse erstreckenden und mittels einer ersten Luftlagereinrichtung mit mehreren Luftlagern an der ebenen Führungsfläche der Basis geführten Gantry-Balken und mit einem Gantry-Antrieb zum Bewegen des Gantry-Balkens in Richtung der X-Achse, und mit einem beweglichen Element, welches mittels einer zweiten Luftlager-Einrichtung mit mehreren Luftlagern am Gantry-Balken geführt und linear in Richtung der Y-Achse bewegbar ist;
- Fig. 2: die Positioniervorrichtung gemäss Fig. 1 in einer Draufsicht in Richtung der Z-Achse;
- Fig. 3: eine perspektivische Ansicht der Positioniervorrichtung gemäss Fig. 1 in einer Explosionsdarstellung, welche insbesondere eine erste Luftlager-Anordnung, eine zweite Luftlager-Anordnung und eine dritte Luftlager-Anordnung einer Ausführungsform der ersten Luftlager-Einrichtung erkennen lässt;
- Fig. 4: eine perspektivische Ansicht von Teilen der Bewegungseinrichtung in Gantry-Bauweise und der ersten Luftlager-Anordnung und der zweiten Luftlager-Anordnung der ersten Luftlager-Einrichtung gemäss Fig. 3, in einer Explosionsdarstellung;
- Fig. 5: eine perspektivische Ansicht von Teilen der Bewegungseinrichtung in Gantry-Bauweise und der ersten Luftlager-Anordnung, der zweiten Luftlager-Anordnung und der dritten Luftlager-Anordnung der ersten Luftlager-Einrichtung gemäss Fig. 3, in einer Explosionsdarstellung in einer Ansicht aus einer anderen Perspektive als in Fig. 4;
- Fig. 6: eine perspektivische Ansicht der dritten Luftlager-Anordnung der ersten Luftlager-Einrichtung gemäss Fig. 3, mit zwei Festkörpergelenken zum Lagern der dritten Luftlager-Anordnung am Gantry-Balken, in einer Explosionsdarstellung;
- Fig. 7A: eine perspektivische Ansicht eines der zwei Festkörpergelenke gemäss Fig. 6;
- Fig. 7B: das Festkörpergelenk gemäss Fig. 7A, in einer Draufsicht in Richtung der Z-Achse;
- Fig. 8: eine perspektivische Ansicht der dritten Luftlager-Anordnung der ersten Luftlagereinrichtung gemäss Fig. 3, in einer vergrösserten Darstellung;
- Fig. 9: die dritte Luftlager-Anordnung der ersten Luftlager-Einrichtung gemäss Fig. 8, in einer Draufsicht in Richtung der Z-Achse;
- Fig. 10: eine perspektivische Ansicht des beweglichen Elements und einer Ausführungsform der zweiten Luftlager-Einrichtung mit mehreren Luftlagern zum Führen des beweglichen Elements am Gantry-Balken;
- Fig. 11: die Positioniervorrichtung gemäss Fig. 1 in einer Seitenansicht entlang der X-Achse, zur Darstellung einer ersten Seite der Positioniervorrichtung;
- Fig. 12: die Positioniervorrichtung gemäss Fig. 11 in einer Seitenansicht entlang der X-Achse, in einer Darstellung aus einer anderen Perspektive als in Fig. 11, welche eine (der ersten Seite der Positioniervorrichtung mit Bezug auf die X-Achse gegenüberliegende) zweite Seite der Positioniervorrichtung zeigt;
- Fig. 13: die Positioniervorrichtung gemäss Fig. 1 in einem Querschnitt senkrecht zur Y-Achse.

### Beschreibung von Ausführungsformen

Für dieselben Elemente in den Figuren sind jeweils dieselben Bezugszeichen verwendet, wenn nichts anderes erwähnt ist.

Die Fig. 1-13 zeigen eine erfindungsgemässe Positioniervorrichtung 1 (bzw. Teile dieser Positioniervorrichtung 1) zum Positionieren eines beweglichen Elements 5. Das bewegliche Element 5 ist im vorliegenden Beispiel konzipiert als eine bewegbare Plattform bzw. ein bewegbarer Tisch mit einer Auflagefläche, auf welcher beispielsweise ein Gegenstand platzierbar ist, welcher mittels der Positioniervorrichtung 1 zusammen mit dem beweglichen Element 5 positioniert werden soll.

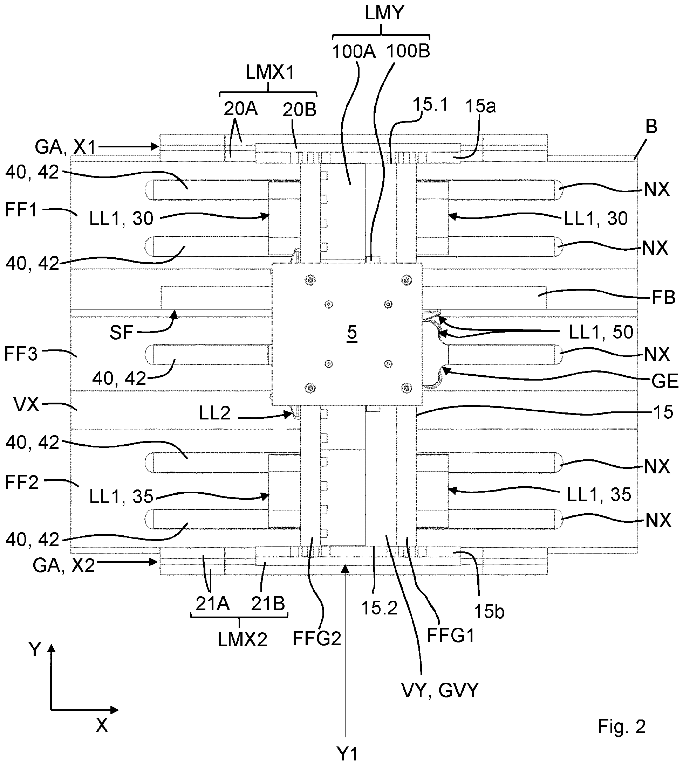

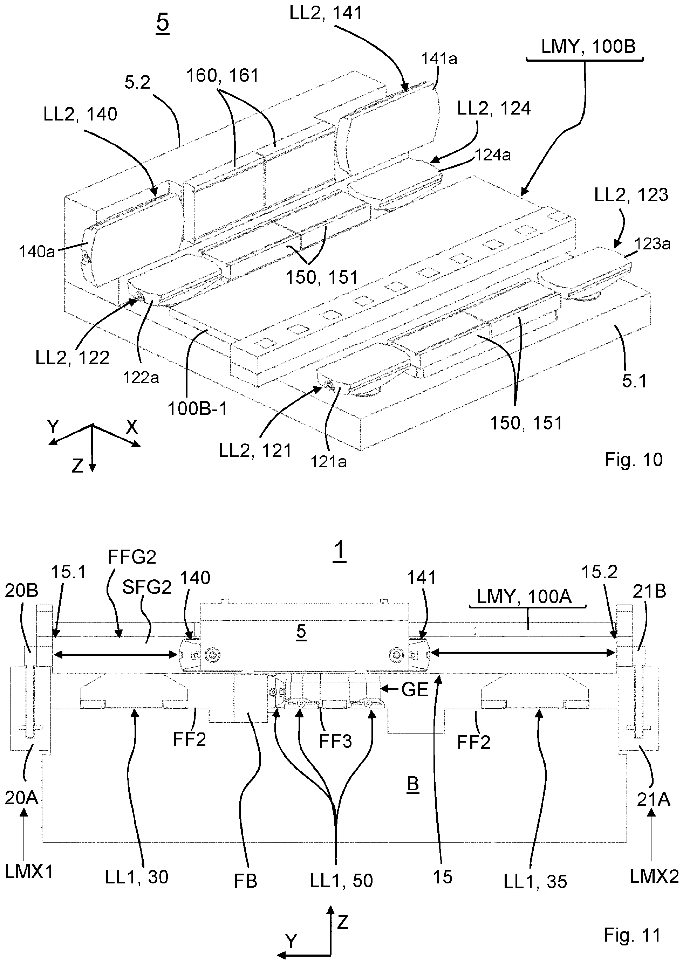

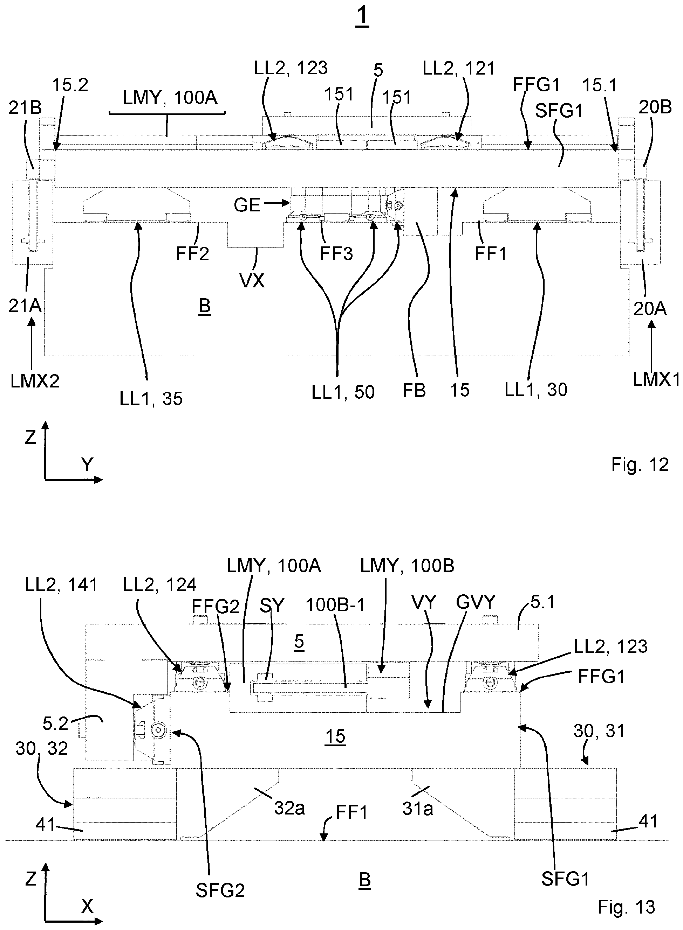

Fig. 1 zeigt die Positioniervorrichtung 1 in einer perspektivischen Ansicht mit Bezug auf ein in der Fig. 1 dargestelltes Koordinatensystem mit den drei Achsen X, Y, Z (X-Achse, Y-Achse, Z-Achse), die Fig. 2, 11-13 zeigen dieselbe Positioniervorrichtung 1 in anderen Ansichten aus anderen Perspektiven, insbesondere in Ansichten entlang der Z-Achse (Fig. 2), der X-Achse (Fig. 11, 12) und der Y-Achse (Fig. 13).

Wie aus Fig. 1-3 und 11-13 ersichtlich, umfasst die Positioniervorrichtung 1 eine Basis B, welche beispielsweise als eine Platte aus Granit realisiert sein kann und welche im vorliegenden Beispiel an einer oberen Seite eine ebene Führungsfläche FF aufweist, welche parallel zu einer ersten Richtung (entsprechend der Richtung der X-Achse gemäss Fig. 1, im Folgenden "erste Richtung X") und parallel zu einer zweiten Richtung (entsprechend der Richtung der Y-Achse gemäss Fig. 1, im Folgenden "zweite Richtung Y") angeordnet ist.

Die Positioniervorrichtung 1 ist konzipiert, das bewegliche Element 5 parallel zur ebenen Führungsfläche FF der Basis B in der ersten Richtung X und/oder in der zweiten Richtung Y zu bewegen und dabei in vorgegebenen Positionen jeweils mit einer Genauigkeit im Sub-Mikrometer-Bereich (d.h. weniger als 1 µm) zu positionieren. Um ein schnelles Positionieren zu ermöglichen, ist vorgesehen, das bewegliche Element 5 mit einer relativ grossen Beschleunigung (2g und mehr) in der ersten Richtung X und/oder in der zweiten Richtung Y bewegen zu können.

Zu diesem Zweck weist die Positioniervorrichtung 1 eine erste Bewegungseinrichtung 10 in Gantry-Bauweise auf, welche erste Bewegungseinrichtung 10 einen über der ebenen Führungsfläche FF angeordneten, sich in der zweiten Richtung Y in einem Abstand zur ebenen Führungsfläche FF erstreckenden Gantry-Balken 15 und einen Gantry-Antrieb GA zum Bewegen des Gantry-Balkens 15 relativ zur Basis B in der ersten Richtung X umfasst. Der Gantry-Balken 15 hat eine sich in der zweiten Richtung Y erstreckende Längsachse und weist mit Bezug auf diese Längsachse ein erstes Ende 15.1 und ein dem ersten Ende 15.1 gegenüberliegendes zweites Ende 15.2 auf, wobei der Gantry-Antrieb GA zwei sich in der ersten Richtung X erstreckende erste Linearachsen X1 bzw. X2 mit je einem Linearantrieb LMX1 bzw. LMX2 umfasst. Hierbei ist der Linearantrieb LMX1 der einen ersten Linearachse X1 mit dem ersten Ende 15.1 des Gantry-Balkens 15 verbunden, sodass das erste Ende 15.1 des Gantry-Balkens 15 mittels des Linearantriebs LMX1 in der ersten Richtung X bewegbar ist. Entsprechend ist der Linearantrieb LMX2 der anderen ersten Linear-Achse X2 mit dem zweiten Ende 15.2 des Gantry-Balkens 15 verbunden, sodass das zweite Ende 15.2 des Gantry-Balkens 15 mittels des Linearantriebs LMX2 ebenfalls in der ersten Richtung X bewegbar ist.

Im vorliegenden Beispiel sind die Linearantriebe LMX1 und LMX2 jeweils als konventionelle Linearmotoren ausgebildet. Dementsprechend umfasst der (als Linearmotor ausgebildete) Linearantrieb LMX1 einen sich linear in der ersten Richtung X erstreckenden Stator 20A, welcher an der Basis B befestigt ist, und einen relativ zum Stator 20A in der ersten Richtung X bewegbaren Läufer 20B, welcher über eine Adapterplatte 15a an dem ersten Ende 15.1 des Gantry-Balkens 15 befestigt ist. Entsprechend umfasst der (als Linearmotor ausgebildete) Linearantrieb LMX2 einen sich linear in der ersten Richtung X erstreckenden Stator 21A, welcher an der Basis B befestigt ist, und einen relativ zum Stator 21A in der ersten Richtung X bewegbaren Läufer 21B, welcher über eine Adapterplatte 15b an dem zweiten Ende 15.2 des Gantry-Balkens 15 befestigt ist.

Sowohl der Stator 20A des Linearantriebs LMX1 als auch der Stator 21A des Linearantriebs LMX2 weisen in einem Querschnitt senkrecht zur ersten Richtung X jeweils ein im Wesentlichen U-förmiges Profil mit zwei nebeneinander angeordneten Schenkeln auf, welche jeweils einen sich in der ersten Richtung X über die gesamte Länge des jeweiligen Stators 20A bzw. 20B erstreckenden Spalt, d.h. einen Spalt SX1 im Falle des Stators 20A und einen Spalt SX2 im Falle des Stators 21A, begrenzen. Wie bei konventionellen Linearmotoren üblich, umfasst der Stator 20A Mittel zum Bereitstellen eines statischen magnetischen Feldes im Spalt SX1 des Stators 20A und der Stator 21A umfasst Mittel zum Bereitstellen eines statischen magnetischen Feldes im Spalt SX2 des Stators 21A. Entsprechend umfasst der Läufer 20B des Linearantriebs LMX1 eine mit einem elektrischen Wechselstrom versorgbare (in den Figuren nicht dargestellte) Spule zur Erzeugung eines magnetischen Wechselfelds und erstreckt sich räumlich derart, dass ein die Spule des Läufers 20B umfassender Abschnitt 20B-1 des Läufers 20B in den Spalt SX1 des Stators 20A ragt und der Läufer 20B in der ersten Richtung X in diesem Spalt SX1 über eine Distanz bewegbar ist, welche der Erstreckung des Stators 20A in der ersten Richtung X entspricht. Entsprechend umfasst der Läufer 21B des Linearantriebs LMX2 eine mit einem elektrischen Wechselstrom versorgbare (in den Figuren nicht dargestellte) Spule zur Erzeugung eines magnetischen Wechselfelds und erstreckt sich räumlich derart, dass ein die Spule des Läufers 21B umfassender Abschnitt 21B-1 des Läufers 21B in den Spalt SX2 des Stators 21A ragt und der Läufer 21B in der ersten Richtung X in diesem Spalt SX2 über eine Distanz bewegbar ist, welche der Erstreckung des Stators 21A in der ersten Richtung X entspricht. Um eine Bewegung des Gantry-Balkens 15 in der ersten Richtung X zu steuern, sind die Linearantriebe LMX1 und LMX2 der beiden ersten Linearachsen X1 bzw. X2 unabhängig voneinander mittels einer (in den Figuren nicht dargestellten) Steuervorrichtung ansteuerbar.

Um eine platzsparende Anordnung der beiden ersten Linearachsen X1 bzw. X2 zu erreichen, sind die Statoren der Linearantriebe LMX1 und LMX2 der vorliegenden Ausführungsform der Positioniervorrichtung 1 gemäss Fig. 1 derart angeordnet, dass sich sowohl der Spalt SX1 des Stators 20A als auch der Spalt SX2 des Stators 21A und sowohl der Läufer 20B als auch der Läufer 21B im Wesentlichen parallel zu einer Ebene erstrecken, welche parallel zur ersten Richtung X und senkrecht zur ebenen Führungsfläche FF der Basis B angeordnet ist, sodass sowohl der Spalt SX1 des Stators 20A als auch der Spalt SX2 des Stators 21A und sowohl der Läufer 20B als auch der Läufer 21B jeweils in der zweiten Richtung Y eine wesentliche geringere Erstreckung aufweisen als in der Richtung senkrecht zur ebenen Führungsfläche FF. Diese Anordnung der beiden ersten Linearachsen X1 bzw. X2 ist vorteilhaft im Hinblick auf eine Beanspruchung einer möglichst geringen Grundfläche in einer Ebene, welche sich parallel zur ersten Richtung X und parallel zur zweiten Richtung Y erstreckt, zumal jeder der beiden Linearantriebe LMX1 und LMX2 aufgrund der jeweiligen Konstruktionen der Statoren 20A und 21A und der Konstruktionen der Läufer 20B und 21B in der vorstehend genannten Anordnung senkrecht zur ebenen Führungsfläche FF eine Erstreckung aufweisen, welche um ein Vielfaches (typischerweise um mehr als einen Faktor 2) grösser ist als die Erstreckung des jeweiligen Linearantriebs LMX1 bzw. LMX2 in der zweiten Richtung Y. Letzteres ist insbesondere anhand der Darstellungen der Positioniervorrichtung 1 in den Fig. 1, 2, 11 und 12 deutlich zu erkennen. Die vorstehend genannte Anordnung der beiden ersten Linearachsen X1 bzw. X2 ermöglicht deshalb eine Konstruktion der Positioniervorrichtung 1, welche in Richtung der zweiten Richtung Y (entsprechend der Längsrichtung des Gantry-Balkens 15) eine besonders geringe räumliche Erstreckung aufweist und insbesondere im Hinblick auf die Anordnung der beiden ersten Linearachsen X1 bzw. X2 minimiert ist.

Wie in Fig. 1-3 angedeutet, ist das bewegliche Element 5 am Gantry-Balken 15 derart gelagert, dass das bewegliche Element 5 am Gantry-Balken 15 linear in der zweiten Richtung Y bewegbar ist, wobei der Gantry-Balken 15 eine sich in der zweiten Richtung Y erstreckende zweite Linearachse Y1 mit einem mit dem beweglichen Element 5 verbundenen Linearantrieb LMY zum Bewegen des beweglichen Elements 5 in der zweiten Richtung Y aufweist.

Im vorliegenden Beispiel ist der Linearantrieb LMY der zweiten Linearachse Y1 ebenfalls als konventioneller Linearmotor ausgebildet und umfasst (analog zur Konstruktion der Linearantriebe LMX1 und LMX2) einen sich linear in der zweiten Richtung Y erstreckenden Stator 100A, welcher an der oberen Seite des Gantry-Balkens 15 befestigt ist und sich in der zweiten Richtung Y zwischen dem ersten Ende 15.1 und dem zweiten Ende 15.2 über die gesamte Länge des Gantry-Balkens 15 erstreckt, und einen relativ zum Stator 100A in der zweiten Richtung Y bewegbaren Läufer 100B, welcher am beweglichen Element 5 befestigt ist.

Der Stator 100A des Linearantriebs LMY weist in einem Querschnitt senkrecht zur zweiten Richtung Y ein im Wesentlichen U-förmiges Profil mit zwei nebeneinander angeordneten Schenkeln auf, welche jeweils einen sich in der zweiten Richtung Y über die gesamte Länge des Stators 100A erstreckenden Spalt SY begrenzen. Der Stator 100A umfasst Mittel zum Bereitstellen eines statischen magnetischen Feldes im Spalt SY des Stators 100A. Entsprechend umfasst der Läufer 100B des Linearantriebs LMY eine mit einem elektrischen Wechselstrom versorgbare (in den Figuren nicht dargestellte) Spule zur Erzeugung eines magnetischen Wechselfelds und erstreckt sich räumlich derart, dass ein die Spule des Läufers 100B umfassender Abschnitt 100B-1 des Läufers 100B in den Spalt SY des Stators 100A ragt und der Läufer 100B in der zweiten Richtung Y in diesem Spalt SY über eine Distanz bewegbar ist, welche der Erstreckung des Stators 100A in der zweiten Richtung Y entspricht. Um eine Bewegung des beweglichen Elements 5 in der zweiten Richtung Y zu steuern, ist der Linearantrieb LMY mittels einer (in den Figuren nicht dargestellten) Steuervorrichtung ansteuerbar.

Um eine platzsparende Anordnung der zweiten Linearachse Y1 zu erreichen, ist der Stator 100A des Linearantriebs LMY der vorliegenden Ausführungsform der Positioniervorrichtung 1 gemäss Fig. 1 derart angeordnet, dass sich sowohl der Spalt SY des Stators 100A und als auch der Läufer 100B im Wesentlichen parallel zu einer Ebene erstrecken, welche parallel zur ebenen Führungsfläche FF der Basis B angeordnet ist, sodass sowohl der Spalt SY des Stators 100A als auch der Läufer 100B in der ersten Richtung X eine wesentlich grössere Erstreckung aufweisen als in der Richtung senkrecht zur ebenen Führungsfläche FF der Basis B.

Um zusätzlich zu erreichen, dass der Gantry-Balken 15 und der Stator 100A der Linearantriebs LMY zusammen eine möglichst geringe Erstreckung senkrecht zur ebenen Führungsfläche FF der Basis B aufweisen, weist der Gantry-Balken 15 an seiner oberen Seite eine sich in der zweiten Richtung Y über die gesamte Länge des Gentry-Balkens 15 erstreckende (insbesondere in Fig. 1, 5 und 13 erkennbare) rinnenförmige Vertiefung VY in Richtung der Z-Achse auf. Diese Vertiefung hat mit Bezug auf eine Ebene senkrecht zur zweiten Richtung Y eine rechteckige Querschnittsfläche und ist an einer unteren Seite durch eine ebene Grundfläche GVY begrenzt, welche sich parallel zur ersten Richtung X und parallel zur zweiten Richtung Y erstreckt. Wie in Fig. 1, 5 und 13 ersichtlich, ist der Stator 100A auf der ebenen Grundfläche GVY der Vertiefung VY platziert, sodass auf diese Weise die Höhe des Stators 100A bezüglich der ebenen Führungsfläche FF reduziert ist. Die vorstehend genannte Anordnung der Linearachse Y1 ermöglicht deshalb eine Konstruktion der Positioniervorrichtung 1, welche in der Richtung senkrecht zur ebenen Führungsfläche FF der Basis B eine besonders geringe räumliche Erstreckung aufweist.

Weitere Einzelheiten bezüglich der Lagerung des beweglichen Elements 5 am Gantry-Balken 15 und Einzelheiten bezüglich der Anordnung des Läufers 100B am beweglichen Element 5 werden im Folgenden noch erläutert, insbesondere im Zusammenhang mit Fig. 10.

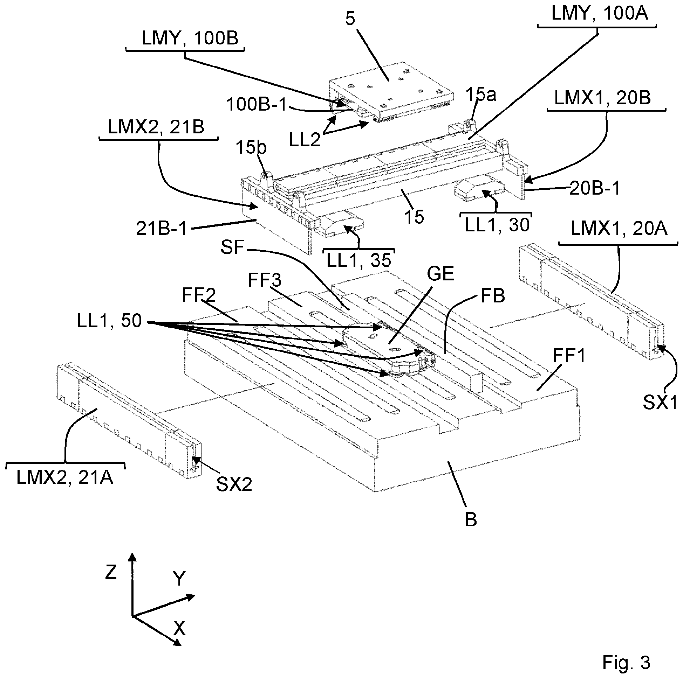

Wie in Fig. 1 angedeutet, umfasst die Positioniervorrichtung 1 eine erste Luftlager-Einrichtung LL1 mit mehreren mit dem Gantry-Balken 15 verbundenen Luftlagern zum Führen des Gantry-Balkens an der ebenen Führungsfläche FF der Basis B. Wie aus Fig. 1 ersichtlich, weist die erste Luftlager-Einrichtung LL1 eine erste Luftlager-Anordnung 30 auf, welche mindestens ein am ersten Ende 15.1 des Gantry-Balkens 15 angeordnetes erstes horizontales Luftlager zum Führen des ersten Endes 15.1 des Gantry-Balkens 15 an einem sich in der ersten Richtung X erstreckenden ersten Abschnitt FF1 der ebenen Führungsfläche FF umfasst. Zusätzlich weist die erste Luftlager-Einrichtung LL1 eine zweite Luftlager-Anordnung 35 auf, welche mindestens ein am zweiten Ende 15.2 des Gantry-Balkens 15 angeordnetes zweites horizontales Luftlager zum Führen des zweiten Endes 15.2 des Gantry-Balkens 15 an einem zweiten sich in der ersten Richtung X erstreckenden Abschnitt FF2 der ebenen Führungsfläche FF umfasst. Die jeweiligen Luftlager der ersten Luftlager-Anordnung 30 und der zweiten Luftlager-Anordnung 35 haben die Aufgabe, den Gantry-Balken 15 jeweils an einem Abschnitt am ersten Ende 15.1 des Gantry-Balkens 15 und an einem Abschnitt am zweiten Ende 15.2 des Gantry-Balkens 15 auf der ebenen Führungsfläche FF zu stützen bzw. zu führen. Einzelheiten der ersten Luftlager-Anordnung 30 und der zweiten Luftlager-Anordnung 35 werden im Folgenden noch erläutert, insbesondere im Zusammenhang mit Fig. 3-5.

Wie in Fig. 1 ausserdem angedeutet, weist die erste Luftlager-Einrichtung LL1 zusätzlich eine dritte Luftlager-Anordnung 50 auf, welche mindestens ein drittes horizontales Luftlager und mindestens ein viertes horizontales Luftlager umfasst, wobei das mindestens eine dritte horizontale Luftlager und das mindestens eine vierte horizontale Luftlager an einem "mittleren Abschnitt" des Gantry-Balkens 15 zwischen dem ersten Ende 15.1 des Gantry-Balkens 15 und dem zweiten Ende 15.2 des Gantry-Balkens 15 angeordnet sind, sodass der "mittlere Abschnitt" des Gantry-Balkens 15 mittels des dritten horizontalen Luftlagers und des vierten horizontales Luftlagers an einem sich in der ersten Richtung X erstreckenden dritten Abschnitt FF3 der ebenen Führungsfläche FF geführt ist, welcher mit Bezug auf die zweite Richtung Y zwischen dem ersten Abschnitt FF1 der ebenen Führungsfläche FF und dem zweiten Abschnitt FF2 der ebenen Führungsfläche angeordnet ist. Einzelheiten der dritten Luftlager-Anordnung 50 mit Bezug auf das vorstehend genannte mindestens eine dritte horizontale Luftlager und das vorstehend genannte mindestens ein vierte horizontale Luftlager werden im Folgenden noch erläutert, insbesondere im Zusammenhang mit Fig. 3, 5 und 6.

Als "mittlerer Abschnitt" des Gantry-Balkens 15 soll in diesem Zusammenhang ein sich in der zweiten Richtung Y erstreckender Längsabschnitt des Gantry-Balkens 15 angesehen werden, welcher sich in der zweiten Richtung Y über eine Länge erstreckt, welche höchstens 50% der Erstreckung des Gantry-Balkens 15 in der zweiten Richtung Y beträgt, und welcher bezüglich des ersten Endes 15.1 des Gantry-Balkens 15 und des zweiten Endes 15.2 Gantry-Balkens 15 jeweils einen Abstand in der zweiten Richtung Y aufweist, welcher mindestens 25% der Erstreckung des Gantry-Balkens 15 in der zweiten Richtung Y beträgt.

Wie in Fig. 1 ausserdem dargestellt, ist an der Basis B neben dem dritten Abschnitt FF3 der ebenen Führungsfläche FF ein sich in der ersten Richtung X erstreckender Führungsbalken FB angeordnet, welcher eine ebene Seitenfläche SF aufweist, welche sich parallel zur ersten Richtung X und parallel zu einer im Wesentlichen senkrecht zur ebenen Führungsfläche FF gerichteten dritten Richtung (entsprechend der Richtung der X-Achse gemäss Fig. 1, im Folgenden "dritte Richtung Z") erstreckt. Ausserdem umfasst die dritte Luftlager-Anordnung 50 mindestens ein an dem mittleren Abschnitt des Gantry-Balkens 15 angeordnetes seitliches Luftlager zum Führen des Gantry-Balkens an der einen ebenen Seitenfläche SF des Führungsbalkens FB. Einzelheiten der dritten Luftlager-Anordnung 50 mit Bezug auf das vorstehend genannte mindestens eine seitliche Luftlager werden im Folgenden noch erläutert, insbesondere im Zusammenhang mit Fig. 3, 5 und 6.

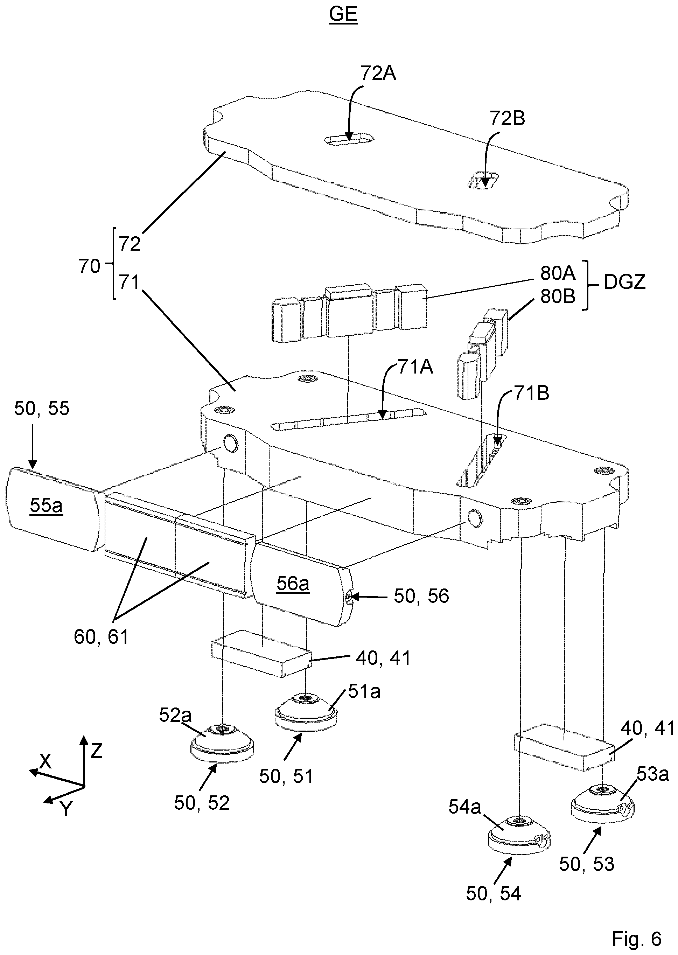

Wie im Folgenden noch detaillierter erläutert wird, sind im vorliegenden Beispiel alle Luftlager der dritten Luftlager-Anordnung 50 Bestandteil einer eine Einheit bildenden und am Gantry-Balken 15 befestigten "Baugruppe", welche unterhalb des Gantry-Balkens 15 in einem Zwischenraum zwischen dem Gantry-Balken 15 und der ebenen Führungsfläche FF angeordnet ist und die Aufgabe hat, den Gantry-Balken 15 im Bereich des mittleren Abschnitts des Gantry-Balkens 15 mittels der horizontalen Luftlager der dritten Luftlager-Anordnung 50 im Bereich des dritten Abschnitts FF3 der ebenen Führungsfläche FF zu stützen bzw. zu führen und bei einer Bewegung in der ersten Richtung X seitlich mittels des mindestens einen seitlichen Luftlagers der dritten Luftlager-Anordnung 50 an der ebenen Seitenfläche SF des Führungsbalkens FB zu führen. Die vorstehend genannte Baugruppe bildet demensprechend ein am Gantry-Balken 15 befestigtes "Gleitelement" GE, welches ausgebildet ist, im Betrieb der Positioniervorrichtung 1 berührungslos auf dem dritten Abschnitt FF3 der ebenen Führungsfläche FF und an der ebenen Seitenfläche SF des Führungsbalkens FB in der ersten Richtung X zu gleiten, und zwar auf Luftkissen, welche mittels der jeweiligen horizontalen Luftlager der dritten Luftlager-Anordnung 50 zwischen dem Gleitelement GE und dem dritten Abschnitt FF3 der ebenen Führungsfläche FF erzeugbar sind, und an Luftkissen, welche mittels der jeweiligen seitlichen Luftlager der dritten Luftlager-Anordnung 50 zwischen dem Gleitelement GE und der ebenen Seitenfläche SF des Führungsbalkens FB erzeugbar sind. Weitere konstruktive Details des Gleitelements GE und dessen Anordnung am Gantry-Balken 15 werden im Folgenden noch erläutert, insbesondere im Zusammenhang mit Fig. 6, 8 und 9.

Wie in Fig. 1 angedeutet, weist der Gantry-Balken 15 an einer oberen (von der ebenen Führungsfläche FF der Basis B abgewandten) Seite zwei ebene Führungsflächen FFG1 bzw. FFG2 auf, welche sich jeweils an der oberen Seite des Gantry-Balkens 15 in der zweiten Richtung Y über die gesamte Länge des Gantry-Balkens 15 zwischen dem ersten Ende 15.1 und dem zweiten Ende 15.2 des Gantry-Balkens 15 jeweils parallel zu der an der oberen Seite des Gantry-Balkens 15 ausgebildeten rinnenförmigen Vertiefung VY erstrecken, sodass die zwei ebenen Führungsflächen FFG1 bzw. FFG2 mit Bezug auf die erste Richtung X auf gegenüberliegenden Seiten der rinnenförmigen Vertiefung VY angeordnet sind. Die zwei ebenen Führungsflächen FFG1 bzw. FFG2 sind dabei jeweils parallel zu der ersten Richtung X und parallel zu der zweiten Richtung Y angeordnet.

Wie in Fig. 1 ausserdem angedeutet, weist der Gantry-Balken 15 ausserdem an zwei mit Bezug auf die erste Richtung X einander gegenüberliegenden Seiten jeweils eine ebene Seitenfläche SFG1 bzw. SFG2 auf, welche sich parallel zur zweiten Richtung Y und im Wesentlichen senkrecht zur ebenen Führungsfläche FFG1 bzw. FFG2 des Gantry-Balkens 15 über die gesamte Länge des Gantry-Balkens 15 in der zweiten Richtung Y erstrecken.

Wie in Fig. 1 sichtbar, umfasst die Positioniervorrichtung 1 ausserdem eine zweite Luftlager-Einrichtung LL2 mit mehreren mit dem beweglichen Element 5 verbundenen Luftlagern zum Führen des beweglichen Elements 5 am Gantry-Balken 15. Die jeweiligen Luftlager der zweiten Luftlager-Einrichtung LL2 sind ausgebildet, das bewegliche Element 5 sowohl an den ebenen Führungsflächen FFG1 bzw. FFG2 des Gantry-Balkens 15 zu stützen und zu führen als auch an der ebenen Seitenfläche SFG2 des Gantry-Balkens 15 zu führen. Weitere konstruktive Einzelheiten der zweiten Luftlager-Einrichtung LL2 werden im Folgenden noch erläutert, insbesondere im Zusammenhang mit Fig. 10.

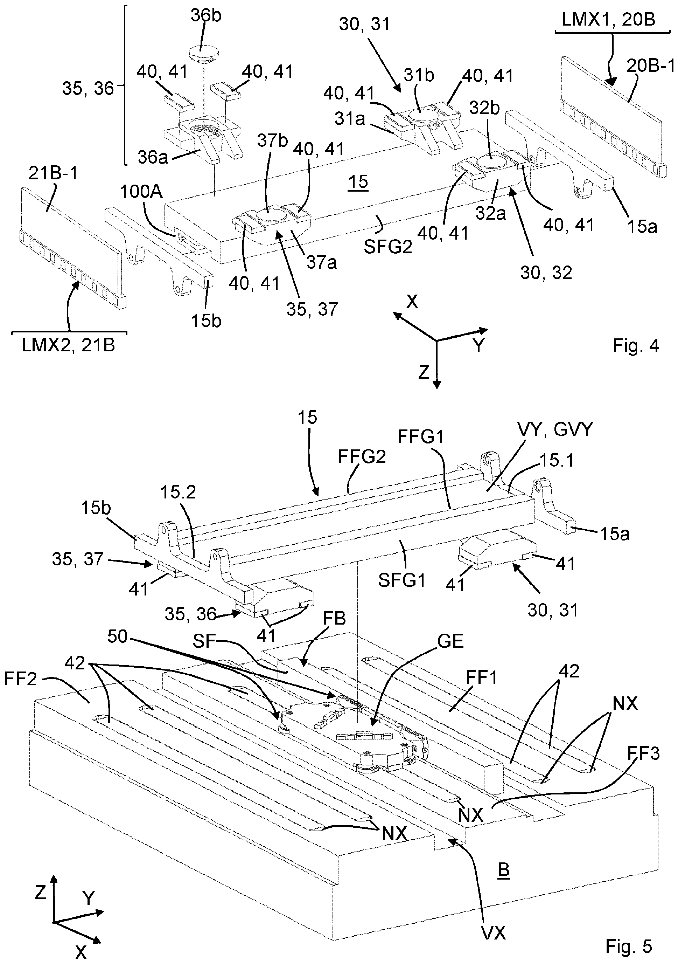

Es sei darauf hingewiesen, dass jedes horizontale Luftlager der ersten Luftlager-einrichtung LL1 bezüglich der ebenen Führungsfläche FF der Basis B und jedes seitliche Luftlager der ersten Luftlager-einrichtung LL1 bezüglich der ebenen Seitenfläche SF des Führungsbalkens FB vorgespannt ist. Entsprechend ist jedes Luftlager der zweiten Luftlager-Einrichtung LL2 bezüglich einer der ebenen Führungsflächen FFG1 bzw. FFG2 des Gantry-Balkens 15 oder bezüglich der ebenen Seitenfläche SFG2 des Gantry-Balkens 15 vorgespannt. Zum Vorspannen der jeweiligen Luftlager dienen im vorliegenden Beispiel magnetische Mittel, welche im Folgenden noch erläutert werden, insbesondere im Zusammenhang mit Fig. 4-6 und 10.

Mit Bezug auf Fig. 3-5 werden im Folgenden Einzelheiten der der ersten Luftlager-Anordnung 30 und der zweiten Luftlager-Anordnung 35 der ersten Luftlager-Einrichtung LL1 beschrieben. Im vorliegenden Beispiel umfasst die erste Luftlager-Anordnung 30 der ersten Luftlager-Einrichtung LL1 zwei erste horizontale Luftlager 31 bzw. 32 zum Führen des ersten Endes 15.1 des Gantry-Balkens 15 an dem ersten Abschnitt FF1 der ebenen Führungsfläche FF der Basis B. Das erste horizontale Luftlager 31 umfasst einen Lagerträger 31a, welcher am Gantry-Balken 15 befestigt ist, und ein Druckluft-Pad 31b, welches am Lagerträger 31a angeordnet ist und eine zur Abgabe von Druckluft bestimmte Frontfläche aufweist, welche sich im Wesentlichen parallel zur ebenen Führungsfläche FF der Basis B erstreckt. Entsprechend umfasst das erste horizontale Luftlager 32 einen Lagerträger 32a, welcher am Gantry-Balken 15 befestigt ist, und ein Druckluft-Pad 32b, welches am Lagerträger 32a angeordnet ist und eine zur Abgabe von Druckluft bestimmte Frontfläche aufweist, welche sich im Wesentlichen parallel zur ebenen Führungsfläche FF der Basis B erstreckt. Die zur Abgabe von Druckluft bestimmte Frontfläche des Druckluft-Pads 31b und die zur Abgabe von Druckluft bestimmte Frontfläche des Druckluft-Pads 32b haben im vorliegenden Beispiel die Form einer Kreisfläche (wobei von einer Kreisfläche abweichende Formen dieser Frontflächen im Hinblick auf die in diesem Zusammenhang relevante technische Funktion der zwei ersten horizontale Luftlager 31 bzw. 32 prinzipiell auch geeignet wären). Die zwei ersten horizontalen Luftlager 31 bzw. 32 sind relativ zueinander derart angeordnet, dass das erste horizontale Luftlager 31 und das erste horizontale Luftlager 32 relativ zueinander einen Abstand in der ersten Richtung X aufweisen, im vorliegenden Beispiel derart, dass die Luftlager-Pads 31b und 32b mit Bezug auf die erste Richtung X an gegenüberliegenden Rändern des Gantry-Balkens 15 angeordnet sind (wie aus Fig. 4 ersichtlich).

Dadurch, dass die zwei ersten horizontalen Luftlager 31 bzw. 32 in einem Abstand in der ersten Richtung X relativ zueinander angeordnet sind, sind die zwei ersten horizontalen Luftlager 31 bzw. 32 geeignet, im Betrieb der Positioniervorrichtung 1 eine Lagerung des ersten Endes 15.1 des Gantry-Balkens 15 an der ebenen Führungsfläche FF zu gewährleisten, welche relativ steif ist mit Bezug auf eine Drehung oder Torsion des Gantry-Balkens 15 um die zweite Richtung Y, sodass eine Bewegung des ersten Endes 15.1 des Gantry-Balkens 15 in der ersten Richtung X bezüglich einer Drehung oder Torsion des Gantry-Balkens um die zweite Richtung Y stabilisiert ist.

Es sei darauf hingewiesen, dass die erste Luftlager-Einrichtung LL1 im Rahmen der vorliegenden Erfindung nicht notwendigerweise zwei erste horizontale Luftlager 31 bzw. 32 zum Führen des ersten Endes 15.1 des Gantry-Balkens 15 an dem ersten Abschnitt FF1 der ebenen Führungsfläche FF der Basis B aufweisen muss. Die zwei ersten horizontalen Luftlager 31 bzw. 32 könnten auch durch ein einziges horizontales Luftlager mit einem einzigen Druckluft-Pad ersetzt werden, insbesondere mit einem Druckluft-Pad, dessen zur Abgabe von Druckluft bestimmte Frontfläche in der ersten Richtung X eine grössere Erstreckung aufweist als in der zweiten Richtung Y.

Analog zur Konstruktion der ersten Luftlager-Anordnung 30 umfasst die zweite Luftlager-Anordnung 35 der ersten Luftlager-Einrichtung LL1 im vorliegenden Beispiel zwei zweite horizontale Luftlager 36 bzw. 37 zum Führen des zweiten Endes 15.2 des Gantry-Balkens 15 an dem zweiten Abschnitt FF2 der ebenen Führungsfläche FF der Basis B. Das zweite horizontale Luftlager 36 umfasst einen Lagerträger 36a, welcher am Gantry-Balken 15 befestigt ist, und ein Druckluft-Pad 36b, welches am Lagerträger 36a angeordnet ist und eine zur Abgabe von Druckluft bestimmte Frontfläche aufweist, welche sich im Wesentlichen parallel zur ebenen Führungsfläche FF der Basis B erstreckt. Entsprechend umfasst das zweite horizontale Luftlager 37 einen Lagerträger 37a, welcher am Gantry-Balken 15 befestigt ist, und ein Druckluft-Pad 37b, welches am Lagerträger 37a angeordnet ist und eine zur Abgabe von Druckluft bestimmte Frontfläche aufweist, welche sich im Wesentlichen parallel zur ebenen Führungsfläche FF der Basis B erstreckt. Die zur Abgabe von Druckluft bestimmte Frontfläche des Druckluft-Pads 36b und die zur Abgabe von Druckluft bestimmte Frontfläche des Druckluft-Pads 37b haben im vorliegenden Beispiel die Form einer Kreisfläche (wobei von einer Kreisfläche abweichende Formen dieser Frontflächen im Hinblick auf die in diesem Zusammenhang relevante technische Funktion der zwei zweiten horizontalen Luftlager 36 bzw. 37 prinzipiell auch geeignet wären). Die zwei zweiten horizontalen Luftlager 36 bzw. 37 sind relativ zueinander derart angeordnet, dass das zweite horizontale Luftlager 36 und das zweite horizontale Luftlager 37 relativ zueinander einen Abstand in der ersten Richtung X aufweisen, im vorliegenden Beispiel derart, dass die Luftlager-Pads 36b und 36b mit Bezug auf die erste Richtung X an gegenüberliegenden Rändern des Gantry-Balkens 15 angeordnet sind (wie aus Fig. 4 ersichtlich).

Dadurch, dass die zwei zweiten horizontalen Luftlager 36 bzw. 37 in einem Abstand in der ersten Richtung X relativ zueinander angeordnet sind, sind die zwei zweiten horizontalen Luftlager 36 bzw. 37 geeignet, im Betrieb der Positioniervorrichtung 1 eine Lagerung des zweiten Endes 15.2 des Gantry-Balkens 15 an der ebenen Führungsfläche FF zu gewährleisten, welche relativ steif ist mit Bezug auf eine Drehung oder Torsion des Gantry-Balkens 15 um die zweite Richtung Y, sodass eine Bewegung des zweiten Endes 15.2 des Gantry-Balkens 15 in der ersten Richtung X bezüglich einer Drehung oder Torsion des Gantry-Balkens um die zweite Richtung Y stabilisiert ist.

Es sei darauf hingewiesen, dass die erste Luftlager-Einrichtung LL1 im Rahmen der vorliegenden Erfindung nicht notwendigerweise zwei zweite horizontale Luftlager 36 bzw. 37 zum Führen des zweiten Endes 15.2 des Gantry-Balkens 15 an dem zweiten Abschnitt FF2 der ebenen Führungsfläche FF der Basis B aufweisen muss. Die zwei zweiten horizontalen Luftlager 36 bzw. 37 könnten auch durch ein einziges horizontales Luftlager mit einem einzigen Druckluft-Pad ersetzt werden, insbesondere mit einem Druckluft-Pad, dessen zur Abgabe von Druckluft bestimmte Frontfläche in der ersten Richtung X eine grössere Erstreckung aufweist als in der zweiten Richtung Y.

Mit Bezug auf Fig. 3, 5 und 6 werden im Folgenden Einzelheiten des Gleitelements GE im Zusammenhang mit den Luftlagern der dritten Luftlager-Anordnung 50 erläutert. Wie insbesondere aus Fig. 6 ersichtlich, umfasst das Gleitelement GE als wesentlichen Bestandteil einen Träger 70, welcher bestimmt ist, die Luftlager der dritten Luftlager-Anordnung 50 aufzunehmen und am Gantry-Balken 15 befestigt zu werden, um die Luftlager der dritten Luftlager-Anordnung 50 in vorgegebenen Positionen mit Bezug auf den Gantry-Balken 15 zu halten. Der Träger 70 ist im vorliegenden Beispiel als ein zweiteiliges Gehäuse ausgebildet, umfassend einen mehrere Hohlräume aufweisenden Grundkörper 71 und eine Deckplatte 72, welche dazu bestimmt ist, auf den Grundköper 71 aufgesetzt zu werden, um den Grundkörper 71 und insbesondere im Grundkörper 71 ausgebildete Hohlräume auf einer der ebenen Führungsfläche FF abgewandten Oberseite des Grundkörpers 71 abzudecken.

Der Grundkörper 71 und die Deckplatte 72 haben jeweils die Form einer flachen ebenen Platte, sodass der aus dem Grundkörper 71 und der Deckplatte 72 gebildete Träger 70 ebenfalls die Form einer ebenen Platte aufweist. Wie aus Fig. 3, 5, 11 und 12 ersichtlich, ist der Träger 70 am Gantry-Balken 15 derart montiert, dass sich der Träger 70 unterhalb des Gantry-Balkens 15 in einem Zwischenraum zwischen dem Gantry-Balken 15 und dem dritten Abschnitt FF3 der ebenen Führungsfläche FF parallel zur ebenen Führungsfläche FF der Basis B und parallel zur ebenen Seitenfläche SF des Führungsbalkens FB erstreckt.

Wie aus Fig. 6 ersichtlich, umfasst die dritte Luftlager-Anordnung 50 im vorliegenden Beispiel insgesamt vier horizontale Luftlager, welche an einer der ebenen Führungsfläche FF der Basis B zugewandten Unterseite des Grundkörpers 71 des Trägers 70 angeordnet sind, und zwar zwei dritte horizontale Luftlager 51 bzw. 52 und zwei vierte horizontale Luftlager 53 bzw. 54 zum Führen des mittleren Abschnitts des Gantry-Balkens 15 an dem dritten Abschnitt FF3 der ebenen Führungsfläche FF. Die zwei dritten horizontalen Luftlager 51 bzw. 52 umfassen je ein Druckluft-Pad 51a bzw. 52a, wobei die Druckluft-Pads 51a und 52a jeweils eine zur Abgabe von Druckluft bestimmte Frontfläche aufweisen, welche sich im Wesentlichen parallel zur ebenen Führungsfläche FF der Basis B erstreckt. Entsprechend umfassen die zwei vierten horizontalen Luftlager 53 bzw. 54 je ein Druckluft-Pad 53a bzw. 54a, wobei die Druckluft-Pads 53a und 54a jeweils eine zur Abgabe von Druckluft bestimmte Frontfläche aufweisen, welche sich im Wesentlichen parallel zur ebenen Führungsfläche FF der Basis B erstreckt.

Die zur Abgabe von Druckluft bestimmten Frontflächen der Druckluft-Pads 51a, 52a, 53a bzw. 54a haben im vorliegenden Beispiel die Form einer Kreisfläche (wobei von einer Kreisfläche abweichende Formen dieser Frontflächen im Hinblick auf die in diesem Zusammenhang relevante technische Funktion zwei dritten horizontalen Luftlager 51 bzw. 52 und der zwei vierten horizontalen Luftlager 53 bzw. 54 prinzipiell auch geeignet wären).

Wie aus Fig. 6 ersichtlich, sind die zwei dritten horizontalen Luftlager 51 und 52 relativ zueinander derart angeordnet, dass die zwei dritten horizontalen Luftlager 51 und 52 relativ zueinander einen Abstand in der zweiten Richtung Y aufweisen, und die zwei vierten horizontalen Luftlager 53 und 54 sind relativ zueinander derart angeordnet, dass die zwei vierten horizontalen Luftlager 53 und 54 relativ zueinander ebenfalls einen Abstand in der zweiten Richtung Y aufweisen. Die zwei dritten horizontalen Luftlager 51 und 52 sind wiederum relativ zu den zwei vierten horizontalen Luftlager 53 und 54 derart angeordnet, dass jedes der zwei dritten horizontalen Luftlager 51 und 52 zu jedem der zwei vierten horizontalen Luftlager 53 und 54 jeweils einen Abstand in der ersten Richtung X aufweisen.

Wie aus Fig. 6 ersichtlich, umfasst die dritte Luftlager-Anordnung 50 im vorliegenden Beispiel zwei seitliche Luftlager 55 bzw. 56 zum Führen des Gantry-Balkens 15 an der ebenen Seitenfläche SF des Führungsbalkens FB, wobei die zwei seitlichen Luftlager 55 und 56 relativ zueinander derart angeordnet sind, dass sie relativ zueinander einen Abstand in der ersten Richtung X aufweisen. Das seitliche Luftlager 55 umfasst ein Druckluft-Pad 55a und das seitliche Luftlager 56 umfasst ein Druckluft-Pad 56a, wobei die beiden Druckluft-Pads 55a und 56a jeweils an einer der ebenen Seitenfläche SF des Führungsbalkens FB zugewandten Seite des Grundkörpers 71 des Trägers 70 angeordnet sind und jeweils eine zur Abgabe von Druckluft bestimmte Frontfläche aufweisen, welche sich im Wesentlichen parallel zur ebenen Seitenfläche SF des Führungsbalkens FB erstreckt. Die zur Abgabe von Druckluft bestimmten Frontflächen der Druckluft-Pads 55a und 56a haben im vorliegenden Beispiel die Form einer im Wesentlichen rechteckigen Fläche (wobei von einer rechteckigen Fläche abweichende Formen dieser Frontflächen im Hinblick auf die in diesem Zusammenhang relevante technische Funktion der zwei seitlichen Luftlager 55 bzw. 56 prinzipiell auch geeignet wären) .

Wie aus Fig. 6 ersichtlich, sind im Grundkörper 71 des Trägers 70 an einer dem Gantry-Balken 15 zugewandten Oberseite des Grundkörpers 71 zwei längliche, im Wesentlichen quaderförmige Hohlräume 71A bzw. 71B ausgebildet, welche jeweils eine sich senkrecht zur dritten Richtung Z bzw. sich parallel zur ebenen Führungsfläche FF der Basis B erstreckende Längsachse aufweisen und mit Bezug auf die erste Richtung X derart angeordnet sind, dass der längliche Hohlraum 71A und der längliche Hohlraum 71B relativ zueinander einen Abstand in der ersten Richtung X aufweisen. Wie in Fig. 6 angedeutet, dienen die länglichen Hohlräume 71A und 71 B zur Aufnahme eines ersten Festkörpergelenks 80A bzw. eines zweiten Festkörpergelenks 80B, wobei das erste Festkörpergelenk 80A dazu bestimmt ist, in den Hohlraum 71A eingesetzt zu werden, und das zweite Festkörpergelenk 80B dazu bestimmt ist, in den Hohlraum 71B eingesetzt zu werden, und die zwei Festköpergelenke 80A bzw. 80B dafür vorgesehen sind, eine Verbindung zwischen dem Träger 70 und dem Gantry-Balken 15 derart herzustellen, dass das Gleitelement GE über die zwei Festköpergelenke 80A bzw. 80B mit Bezug auf den Gantry-Balken 15 einerseits in einer stabilen Lage gehalten ist und andererseits über die zwei Festköpergelenke 80A bzw. 80B derart am Gantry-Balken 15 gelagert ist, dass das Gleitelement GE um eine sich in der dritten Richtung Z erstreckende Drehachse relativ zum Gantry-Balken 15 drehbar ist, sodass die Anordnung der zwei Festköpergelenke 80A bzw. 80B dementsprechend ein "Drehgelenk" DGZ repräsentiert, welches dazu dient, das Gleitelement GE mit dem Gantry-Balken 15 zu verbinden und am Gantry-Balken 15 beweglich (drehbar) zu halten.

Wie aus Fig. 6 ausserdem ersichtlich, sind in der Deckplatte 72 zwei in der dritten Richtung Z durchgehende Öffnungen 72A bzw. 72B ausgebildet. Die räumliche Anordnung und die Form der in der Deckplatte 72 ausgebildeten Öffnungen 72A und 72B sind an die räumliche Anordnung und die Form der im Grundkörper 71 des Trägers 70 ausgebildeten länglichen Hohlräume 71A bzw. 71B angepasst, und zwar derart, dass - wenn die Deckplatte 72 an der dem Gantry-Balken 15 zugewandten Oberseite des Grundkörpers 71 angeordnet ist, sodass der Grundkörper 71 und die Deckplatte 72 zusammengesetzt sind und gemeinsam den Träger 70 bilden - die Deckplatte 72 die länglichen Hohlräume 71A bzw. 71B an der dem Gantry-Balken 15 zugewandten Oberseite des Grundkörpers 71 einerseits teilweise bedeckt und die in der Deckplatte 72 ausgebildeten Öffnungen 72A und 72B relativ zu den im Grundkörper 71 ausgebildeten länglichen Hohlräumen 71A und 71B derart angeordnet sind, dass die Öffnung 72A unmittelbar über dem länglichen Hohlraum 71A platziert ist und ein Längsabschnitt des länglichen Hohlraums 71A von der dem Gantry-Balken 15 zugewandten Seite her durch die Öffnung 72A zugänglich ist und dass die Öffnung 72B unmittelbar über dem länglichen Hohlraum 71B platziert ist und ein Längsabschnitt des länglichen Hohlraums 71B von der dem Gantry-Balken 15 zugewandten Seite her durch die Öffnung 72B zugänglich ist.

Die vorstehend beschriebene Konstruktion des Trägers 70 ermöglicht eine Integration der zwei Festköpergelenke 80A bzw. 80B in den Träger 70. Zu diesem Zweck kann das Festköpergelenk 80A als Ganzes in den Hohlraum 71A eingesetzt werden und ein oder mehrere Abschnitte des ersten Festköpergelenks 80A können am Träger 70 (d.h. wahlweise am Grundkörper 71 oder an der Deckplatte 72) fixiert werden, während ein durch die Öffnung 72a zugänglicher Abschnitt des ersten Festköpergelenks 80A am Gantry-Balken 15 befestigt werden kann, um durch die Öffnung 72A eine Verbindung zwischen dem durch die Öffnung 72A zugänglichen Abschnitt des ersten Festköpergelenks 80A und dem Gantry-Balken 15 herzustellen (mit konventionellen, für eine derartige Verbindung geeignete Befestigungsmitteln, z.B. mit Schrauben und/oder mittels Kleben). In analoger Weise kann das zweite Festköpergelenk 80B als Ganzes in den Hohlraum 71B eingesetzt werden und ein oder mehrere Abschnitte des zweiten Festköpergelenks 80B können am Träger 70 (d.h. wahlweise am Grundkörpers 71 oder an der Deckplatte 72) fixiert werden, während ein durch die Öffnung 72B zugänglicher Abschnitt des zweiten Festköpergelenks 80B am Gantry-Balken 15 befestigt werden kann, um durch die Öffnung 72B eine Verbindung zwischen dem durch die Öffnung 72B zugänglichen Abschnitt des zweiten Festköpergelenks 80B und dem Gantry-Balken 15 herzustellen (mit konventionellen, für eine derartige Verbindung geeignete Befestigungsmitteln, z.B. mit Schrauben und/oder mittels Kleben).

Weitere konstruktive Details bezüglich des ersten Festköpergelenks 80A bzw. des zweiten Festköpergelenks 80B und eine Anordnung dieser Festkörpergelenke 80A und 80B zum Ausbilden eines das Gleitelement GE mit dem Gantry-Balken 15 verbindenden Drehgelenks DGZ werden im Folgenden noch erläutert, insbesondere im Zusammenhang mit Fig. 6-9.

Mit Bezug auf Fig. 1, 3, 10-13 werden zunächst Einzelheiten der Konstruktion des beweglichen Elements 5 im Zusammenhang mit Einzelheiten hinsichtlich der zweiten Luftlager-Einrichtung LL2 mit den mit dem beweglichen Element 5 verbundenen Luftlagern zum Führen des beweglichen Elements 5 am Gantry-Balken 15 beschrieben.

Wie aus Fig. 1, 3, 10 und 13 ersichtlich, ist das bewegliche Element 5 im vorliegenden Beispiel konzipiert als eine "L-förmige" Plattform, welche aus einer flachen Grundplatte 5.1 und einer mit der Grundplatte 5.1 verbundenen Seitenwand 5.2 zusammengesetzt ist. Die Bezeichnung "L-förmig" bezieht sich in diesem Zusammenhang auf die Form einer Querschnittsfläche des (aus der Grundplatte 5.1 und der Seitenwand 5.2 zusammengesetzten) beweglichen Elements 5 mit Bezug auf eine sich senkrecht zur zweiten Richtung Y erstreckenden Ebene für den Fall, dass das bewegliche Element 5 auf dem Gantry-Balken 15 der Positioniervorrichtung 1 - wie in Fig. 1 und 13 dargestellt - platziert ist.

Das bewegliche Element 5 ist am Gantry-Balken 15 derart gelagert, dass die Grundplatte 5.1 über den an der oberen Seite des Gantry-Balkens 15 ausgebildeten ebenen Führungsflächen FFG1 und FFG2 angeordnet ist und sich parallel zur ersten Richtung X und parallel zur zweiten Richtung Y derart erstreckt, dass die Grundplatte 5.1 mit Bezug auf eine sich parallel zur ersten Richtung X und parallel zur zweiten Richtung Y erstreckende Ebene eine im Wesentlichen rechteckige Querschnittsfläche aufweist. Die Grundplatte 5.1 hat in der zweiten Richtung Y eine Erstreckung, welche kleiner ist als die Erstreckung des Gantry-Balkens 15 in der zweiten Richtung Y, und in der ersten Richtung X eine Erstreckung, welche grösser ist als die Erstreckung des Gantry-Balkens 15 in der ersten Richtung X.

Wie aus Fig. 1 und 13 ersichtlich, sind die ebenen Führungsflächen FFG1 und FFG2 des Gantry-Balkens 15 einerseits und die Seitenflächen SFG1 und SFG2 des Gantry-Balkens 15 anderseits an mit Bezug auf die erste Richtung X gegenüberliegenden "Randbereichen" des Gantry-Balkens angeordnet, derart, dass die ebene Führungsfläche FFG1 an einem dieser "Randbereiche" unmittelbar an die Seitenfläche SFG1 grenzt und die ebene Führungsfläche FFG2 an dem anderen dieser "Randbereiche" unmittelbar an die Seitenfläche SFG2 grenzt, im vorliegenden Beispiel insbesondere derart, dass die Führungsfläche FFG1 und die Seitenfläche SFG1 zwei relativ zueinander in einem rechten Winkel aneinander angrenzende Flächen und die Führungsfläche FFG2 und die Seitenfläche SFG2 zwei relativ zueinander in einem rechten Winkel aneinander angrenzende Flächen bilden.

Das bewegliche Element 5 ist dabei derart angeordnet, dass die Grundplatte 5.1 oberhalb des Gantry-Balkens 15 über den ebenen Führungsflächen FFG1 und FFG2 des Gantry-Balkens 15 platziert ist und ein Abschnitt der Grundplatte 5.1 im Bereich der ebenen Seitenfläche SFG2 des Gantry-Balkens 15 die an die ebene Seitenfläche SFG2 angrenzende ebene Führungsfläche FFG2 in der ersten Richtung X um eine Distanz überragt, welche grösser ist als die Erstreckung der Seitenwand 5.2 in der ersten Richtung X. Die Seitenwand 5.2 ist mit der Grundplatte 5.1 an dem in der ersten Richtung X über die ebene Führungsfläche FFG2 hinausragenden Abschnitt der Grundplatte 5.1 derart verbunden, dass sich die Seitenwand 5.2 an einer Unterseite der Grundplatte 5.1 in der zweiten Richtung Y im Wesentlichen parallel zur ebenen Seitenfläche SFG2 erstreckt und dabei einen Abstand zur ebene Seitenfläche SFG2 aufweist.

Wie aus Fig. 1, 10 und 13 ersichtlich, sind ein Teil der Luftlager der zweiten Luftlager-Einrichtung LL2 an der Grundplatte 5.1 des bewegliche Elements 5 (in einem Zwischenraum zwischen der Grundplatte 5.1 und einer der ebenen Führungsflächen FFG1 bzw. FFG2 des Gantry-Balkens 15) und ein anderer Teil der Luftlager der zweiten Luftlager-Einrichtung LL2 an der Seitenwand 5.2 des beweglichen Elements 5 (in einem Zwischenraum zwischen der Seitenwand 5.2 und der ebenen Seitenfläche SFG2 des Gantry-Balkens 15) angeordnet.

Die zweite Luftlager-Einrichtung LL2 umfasst mindestens ein erstes horizontales Luftlager und mindestens ein zweites horizontales Luftlager, welches mindestens eine erste horizontale Luftlager und welches mindestens eine zweite horizontale Luftlager am beweglichen Element 5 derart angeordnet sind, dass das bewegliche Element mittels des mindestens einen ersten horizontalen Luftlagers und mittels des mindestens einen zweiten horizontalen Luftlagers der zweiten Luftlager-Einrichtung LL2 an einer der ebenen Führungsflächen FFG1 oder FFG2 des Gantry-Balkens 15 geführt ist, wobei das mindestens eine erste horizontale Luftlager und das mindestens eine zweite horizontale Luftlager der zweiten Luftlager-Einrichtung LL2 bezüglich einer der ebenen Führungsflächen FFG1 oder FFG2 des Gantry-Balkens 15 vorgespannt sind. Ausserdem umfasst die zweite Luftlager-Einrichtung LL2 mindestens ein am beweglichen Element 5 angeordnetes seitliches Luftlager zum Führen des beweglichen Elements 5 an der einen ebenen Seitenfläche SFG2 des Gantry-Balkens 15, wobei das mindestens eine seitliche Luftlager der zweiten Luftlager-Einrichtung LL2 bezüglich der einen ebenen Seitenfläche SFG2 des Gantry-Balkens 15 vorgespannt ist.

Im vorliegenden Beispiel (wie aus Fig. 10 und 13 ersichtlich) umfasst die zweite Luftlager-Einrichtung LL2 insgesamt zwei an der Grundplatte 5.1 des bewegliche Elements 5 angeordnete erste horizontale Luftlager 121 bzw. 122 zum Führen des beweglichen Elements 5 an der ebenen Führungsfläche FFG1 bzw. FFG2 des Gantry-Balkens 15, wobei die zwei ersten horizontalen Luftlager 121 bzw. 122 der zweiten Luftlager-Einrichtung LL2 relativ zueinander einen Abstand in der ersten Richtung X aufweisen und bezüglich der ebenen Führungsfläche FFG1 bzw. FFG2 des Gantry-Balkens 15 vorgespannt sind. Die zweite Luftlager-Einrichtung LL2 umfasst gemäss dem vorliegenden Beispiel ausserdem insgesamt zwei an der Grundplatte 5.1 des bewegliche Elements 5 angeordnete zweite horizontale Luftlager 123 bzw. 124 zum Führen des beweglichen Elements 5 an der ebenen Führungsfläche FFG1 bzw. FFG2 des Gantry-Balkens 15, wobei die zwei zweiten horizontalen Luftlager 123 bzw. 124 der zweiten Luftlager-Einrichtung LL2 relativ zueinander einen Abstand in der ersten Richtung X aufweisen und bezüglich der ebenen Führungsfläche FFG1 bzw. FFG2 des Gantry-Balkens 15 vorgespannt sind. Weiterhin umfasst die zweite Luftlager-Einrichtung LL2 gemäss dem vorliegenden Beispiel zwei an der Seitenwand 5.2 des beweglichen Elements 5 angeordnete seitliche Luftlager 140 bzw. 141 zum Führen des beweglichen Elements 5 an der einen ebenen Seitenfläche SFG2 des Gantry-Balkens 15, wobei die zwei seitlichen Luftlager 140 bzw. 141 der zweiten Luftlager-Einrichtung LL2 relativ zueinander einen Abstand in der zweiten Richtung Y aufweisen und bezüglich der ebenen Seitenfläche SFG2 des Gantry-Balkens 15 vorgespannt sind.

Dadurch, dass die zwei ersten horizontalen Luftlager 121 bzw. 122 der zweiten Luftlager-Einrichtung LL2 relativ zueinander einen Abstand in der ersten Richtung X aufweisen und dass die zwei zweiten horizontalen Luftlager 123 bzw. 124 der zweiten Luftlager-Einrichtung LL2 ebenfalls relativ zueinander einen Abstand in der ersten Richtung X aufweisen, ist an der dem Gantry-Balken 15 zugewandten Seite der Grundplatte 5.1 zwischen den zwei ersten horizontalen Luftlagern 121 bzw. 122 und zwischen den zweiten horizontalen Luftlager 123 bzw. 124 ein Raum vorhanden, welcher für eine Anordnung des Läufers 100B des Linearantriebs LMY der zweiten Linearachse Y1 zur Verfügung steht. Dementsprechend ist im vorliegenden Beispiel der Läufer 100B des Linearantriebs LMY derart an der Grundplatte 5.1 an der dem Gantry-Balken 15 zugewandten Seite der Grundplatte 5 angeordnet, dass sich der Läufer 100B in der zweiten Richtung Y durch einen zwischen den zwei ersten horizontalen Luftlagern 121 bzw. 122 ausgebildeten Zwischenraum und durch einen zwischen den zwei zweiten horizontalen Luftlagern 123 bzw. 124 ausgebildeten Zwischenraum erstreckt, wobei die zwei ersten horizontalen Luftlager 121 bzw. 122 mit Bezug auf die erste Richtung X jeweils an gegenüberliegenden Seiten des Läufers 100B angeordnet sind und die zwei zweiten horizontalen Luftlager 123 bzw. 124 mit Bezug auf die erste Richtung X ebenfalls jeweils an gegenüberliegenden Seiten des Läufers 100B angeordnet sind (Fig. 10 und 13). Der Läufer 100B des Linearantriebs LMY ist dabei derart an der Grundplatte 5.1 befestigt, dass sich der Abschnitt 100B-1 des Läufers 100B parallel zur ersten Richtung X und parallel zur zweiten Richtung Y in einem Abstand zur Grundplatte 5.1 erstreckt und derart in den Spalt SY des Stators 100A des Linearantriebs LMY ragt, dass das bewegliche Element 5 zusammen mit dem Läufer 100B in der zweiten Richtung Y über die gesamte Erstreckung des Gantry-Balkens 15 zwischen dem ersten Ende 15.1 und dem zweiten Ende 15.2 bewegbar ist (Fig. 1, 10 und 13).

Wie aus Fig. 10 ersichtlich, umfassen die horizontalen Luftlager 121, 122, 123 bzw. 124 der zweiten Luftlager-Einrichtung LL2 jeweils ein Druckluft-Pad 121a, 122a, 123a bzw. 124a (in dieser Reihenfolge) und die zwei seitlichen Luftlager 140 bzw. 141 der zweiten Luftlager-Einrichtung LL2 umfassen jeweils ein Druckluft-Pad 140a bzw. 141a (in dieser Reihenfolge). Dabei sind das Druckluft-Pad 121a des einen ersten horizontalen Luftlagers 121 und das Druckluft-Pad 123a des einen zweiten horizontalen Luftlagers 123 an einer der ebenen Führungsfläche FFG1 des Gantry-Balkens 15 zugewandten Seite der Grundplatte 5.1 des bewegliche Elements 5 angeordnet und weisen jeweils eine zur Abgabe von Druckluft bestimmte Frontfläche auf, welche sich im Wesentlichen parallel zur ebenen Führungsfläche FFG1 des Gantry-Balkens 15 erstreckt. Entsprechend sind das Druckluft-Pad 122a des anderen ersten horizontalen Luftlagers 122 und das Druckluft-Pad 124a des anderen zweiten horizontalen Luftlagers 123 an einer der ebenen Führungsfläche FFG2 des Gantry-Balkens 15 zugewandten Seite der Grundplatte 5.1 des beweglichen Elements 5 angeordnet und weisen jeweils eine zur Abgabe von Druckluft bestimmte Frontfläche auf, welche sich im Wesentlichen parallel zur ebenen Führungsfläche FFG2 des Gantry-Balkens 15 erstreckt. Entsprechend sind die Druckluft-Pads 140a bzw. 141a der zwei seitlichen Luftlager 140 bzw. 141 der zweiten Luftlager-Einrichtung LL2 an einer der ebenen Seitenfläche SFG2 des Gantry-Balkens 15 zugewandten Seite der Seitenwand 5.2 des beweglichen Elements 5 angeordnet und weisen jeweils eine zur Abgabe von Druckluft bestimmte Frontfläche auf, welche sich im Wesentlichen parallel zur ebenen Seitenfläche SFG2 des Gantry-Balkens 15 erstreckt.

Wie aus Fig. 10 ersichtlich, haben die zur Abgabe von Druckluft bestimmten Frontflächen der Druckluft-Pads 121a, 122a, 123a bzw. 124a der horizontalen Luftlager 121, 122, 123 bzw. 124 der zweiten Luftlager-Einrichtung LL2 und die zur Abgabe von Druckluft bestimmten Frontflächen der Druckluft-Pads 140a bzw. 141a der zwei seitlichen Luftlager 140 bzw. 141 der zweiten Luftlager-Einrichtung LL2 die Form einer im Wesentlichen rechteckigen Fläche (wobei von einer rechteckigen Fläche abweichende Formen dieser Frontflächen im Hinblick auf die in diesem Zusammenhang relevante technische Funktion der jeweiligen Luftlager der zweiten Luftlager-Einrichtung LL2 prinzipiell auch geeignet wären).

Es sei darauf hingewiesen, dass die zweite Luftlager-Einrichtung LL2 im Rahmen der vorliegenden Erfindung (abweichend von der in Fig. 10-13 dargestellten Ausführung der Positioniervorrichtung 1) nicht notwendigerweise vier am beweglichen Element 5 angeordnete horizontale Luftlager (entsprechend den zwei ersten horizontale Luftlagern 121 bzw. 122 zum Führen des beweglichen Elements 5 an der ebenen Führungsfläche FFG1 bzw. FFG2 des Gantry-Balkens 15 und den zwei zweiten horizontale Luftlagern 123 bzw. 124 zum Führen des beweglichen Elements 5 an der ebenen Führungsfläche FFG1 bzw. FFG2 des Gantry-Balkens 15) und nicht notwendigerweise zwei seitliche Luftlager (entsprechend den zwei seitlichen Luftlagern 140 bzw. 141 zum Führen des beweglichen Elements 5 an der einen ebenen Seitenfläche SFG2 des Gantry-Balkens 15) aufweisen muss.

Die zwei seitlichen Luftlager 140 und 141 könnten auch durch ein einziges seitliches Luftlager mit einem einzigen Druckluft-Pad ersetzt werden, insbesondere mit einem Druckluft-Pad, dessen zur Abgabe von Druckluft bestimmte Frontfläche in der zweiten Richtung Y eine grössere Erstreckung aufweist als jedes der in Fig. 10 dargestellten Druckluft-Pads 140a und 141a.

Ausserdem könnte die in Fig. 10 dargestellte Anordnung der horizontalen Luftlager 121 und 123 derart modifiziert werden, dass anstelle der Anordnung des einen ersten horizontalen Luftlagers 121 und des einen zweiten horizontalen Luftlagers 123 zum Führen des beweglichen Elements 5 an der ebenen Führungsfläche FFG1 ein einziges horizontales Luftlager mit einem einzigen Druckluft-Pad verwendet wird, insbesondere mit einem einzigen Druckluft-Pad, dessen zur Abgabe von Druckluft bestimmte Frontfläche in der zweiten Richtung Y eine grössere Erstreckung aufweist als jedes der in Fig. 10 dargestellten Druckluft-Pads 121a und 123a.

Analog könnte die in Fig. 10 dargestellte Anordnung der horizontalen Luftlager 122 und 124 derart modifiziert werden, dass anstelle der Anordnung des ersten horizontalen Luftlagers 122 und des zweiten horizontalen Luftlagers 124 zum Führen des beweglichen Elements 5 an der ebenen Führungsfläche FFG2 ein einziges horizontales Luftlager mit einem einzigen Druckluft-Pad verwendet wird, insbesondere mit einem einzigen Druckluft-Pad, dessen zur Abgabe von Druckluft bestimmte Frontfläche in der zweiten Richtung Y eine grössere Erstreckung aufweist als jedes der in Fig. 10 dargestellten Druckluft-Pads 122a und 124a.

Alternativ wäre es auch denkbar, die in Fig. 10 dargestellte Anordnung der zwei ersten horizontalen Luftlager 121 und 122 derart zu modifizieren, dass anstelle der Anordnung der zwei ersten horizontalen Luftlager 121 und 122 ein einziges horizontales Luftlager mit einem einzigen Druckluft-Pad verwendet wird, insbesondere mit einem einzigen Druckluft-Pad, dessen zur Abgabe von Druckluft bestimmte Frontfläche in der ersten Richtung X eine grössere Erstreckung aufweist als jedes der in Fig. 10 dargestellten Druckluft-Pads 121a und 122a. Analog wäre auch denkbar, alternativ oder zusätzlich die in Fig. 10 dargestellte Anordnung der zwei zweiten horizontalen Luftlager 123 und 124 derart zu modifizieren, dass anstelle der Anordnung der zwei zweiten horizontalen Luftlager 123 und 124 ein einziges horizontales Luftlager mit einem einzigen Druckluft-Pad verwendet wird, insbesondere mit einem einzigen Druckluft-Pad, dessen zur Abgabe von Druckluft bestimmte Frontfläche in der ersten Richtung X eine grössere Erstreckung aufweist als jedes der in Fig. 10 dargestellten Druckluft-Pads 123a und 124a.

Zur Realisierung der vorstehend genannten Alternative wäre es zweckmässig, zusätzliche konstruktive Änderungen hinsichtlich der Anordnung des Linearantriebs LMY und der Ausbildung der ebenen Führungsfläche FFG1 bzw. FFG2 des Gantry-Balkens 15 vorzunehmen, um eine Führung des beweglichen Elements mittels mindestens zwei horizontalen Luftlagern an einer ebenen Führungsfläche für den Fall zu ermöglichen, dass anstelle der Anordnung der zwei ersten horizontalen Luftlager 121 und 122 ein einziges horizontales Luftlager mit einem einzigen Druckluft-Pad verwendet wird und/oder anstelle der Anordnung der zwei zweiten horizontalen Luftlager 123 und 124 ein einziges horizontales Luftlager mit einem einzigen Druckluft-Pad verwendet wird. Beispielsweise wäre es zweckmässig, die Konstruktion des Gantry-Balkens 15 derart zu modifizieren, dass an der Oberseite des Gantry-Balkens 15 eine sich parallel zur ersten Richtung X und parallel zur zweiten Richtung 15 ersteckende ebene Führungsfläche ausgebildet ist, welche sich in der ersten Richtung X über die gesamte Breite des Gantry-Balkens 15 (entsprechend der Erstreckung des Gantry-Balkens 15 in der ersten Richtung X) erstreckt. In diesem Falle könnte das eine horizontale Luftlager, welches anstelle der Anordnung der zwei ersten horizontalen Luftlager 121 und 122 zum Führen des beweglichen Elements 5 an der einen ebenen Führungsfläche verwendet werden soll, und/oder das eine horizontale Luftlager, welches anstelle der Anordnung der zwei zweiten horizontalen Luftlager 123 und 124 zum Führen des beweglichen Elements 5 an der einen ebenen Führungsfläche verwendet werden soll, in der ersten Richtung X eine Erstreckung aufweisen, welche in etwa der Erstreckung des Gantry-Balkens 15 in der ersten Richtung X entspricht.

Im Falle einer Ausbildung der ebenen Führungsfläche in der vorstehend genannten Weise wäre es zweckmässig, den Linearantrieb LMY derart am Gantry-Balken 15 anzuordnen, dass der Stator 100A des Linearantriebs LMY nicht an der Oberseite des Gantry-Balkens 15, sondern beispielsweise an der ebenen Seitenfläche SFG2 des Gantry-Balkens 15 platziert ist, sodass sich der Stator 100A in der zweiten Richtung Y über die gesamte Länge des Gantry-Balkens 15 erstreckt. Analog könnte der Läufer 100B des Linearantriebs LMY an der Grundplatte 5.1 des beweglichen Elements 5 angeordnet sein, sodass der Abschnitt 100B-1 des Läufers 100B in den Spalt SY des an der ebenen Seitenfläche SFG2 platzierten Stators 100A ragt und der Läufer 100B in der zweiten Richtung Y in diesem Spalt SY über eine Distanz bewegbar ist, welche der Erstreckung des Stators 100A in der zweiten Richtung Y entspricht.

Mit Bezug auf Fig. 1, 2, 4-6 und 10 werden im Folgenden die bereits erwähnten magnetischen Mittel zum Vorspannen der Luftlager der ersten Luftlager-Einrichtung LL1 und der zweiten Luftlager-Einrichtung LL2 charakterisiert. Die Positioniervorrichtung 1 umfasst im vorliegenden Beispiel
- eine Einrichtung 40 zum Vorspannen der jeweiligen horizontalen Luftlager 31, 32, 36, 37, 51, 52, 53 bzw. 54 der ersten Luftlager-Anordnung 30, der zweiten Luftlager-Anordnung 35 und der dritten Luftlager-Anordnung 50 der ersten Luftlager-Einrichtung LL1,
- eine Einrichtung 60 zum Vorspannen der jeweiligen seitlichen Luftlager 55 bzw. 56 der dritten Luftlager-Anordnung 50 der ersten Luftlager-Einrichtung LL1,
- eine Einrichtung 150 zum Vorspannen der jeweiligen horizontalen Luftlager 121-124 der zweiten Luftlager-Einrichtung LL2 und
- eine Einrichtung 160 zum Vorspannen der jeweiligen seitlichen Luftlager 140 bzw. 141 der zweiten Luftlager-Einrichtung LL2.

Die Einrichtung 40 zum Vorspannen der jeweiligen horizontalen Luftlager der ersten Luftlager-Anordnung 30 der ersten Luftlager-Einrichtung LL1 umfasst (wie aus Fig. 1, 2 und 4-6 ersichtlich) einerseits eine Anordnung einer Mehrzahl von Permanentmagneten 41, welche unmittelbar neben den jeweiligen Druckluft-Pads 31b, 32b, 36b bzw. 37b der horizontalen Luftlager 31, 32, 36 bzw. 37 am Gantry-Balken 15 bzw. unmittelbar neben den Druckluft-Pads 51a, 52a, 53a bzw. 54a der horizontalen Luftlager 51, 52, 53 bzw. 54 am Träger 70 angeordnet sind, und eine Anordnung von mehreren jeweils aus einem ferromagnetischen Material gebildeten Leisten 42, welche jeweils an der Basis B befestigt sind und insbesondere in die jeweiligen Abschnitte FF1, FF2 und FF3 der ebenen Führungsfläche FF der Basis integriert sind. Wie aus Fig. 1 und 4 ersichtlich, sind an jedem der Lagerträger 31a, 32a, 35a und 36a der horizontalen Luftlager der ersten Luftlager-Anordnung 30 und der zweiten Luftlager-Anordnung 35 jeweils zwei Permanentmagnete 41 derart befestigt, dass sich jeder dieser zwei Permanentmagnete 41 jeweils parallel zur ebenen Führungsfläche FF erstreckt und diese zwei Permanentmagnete 41 jeweils relativ zueinander einen Abstand in der zweiten Richtung Y aufweisen und jeweils (mit Bezug auf die zweite Richtung Y) unmittelbar neben dem an dem jeweiligen Lagerträger 31a, 32a, 35a bzw. 36a angeordneten Druckluft-Pad 31b, 32b, 35b bzw. 36b an jeweils gegenüberliegenden Seiten des jeweiligen Druckluft-Pads 31b, 32b, 35b bzw. 36b platziert sind. Wie aus Fig. 6 ersichtlich, sind am Grundkörper 71 des Trägers 70 an dessen der ebenen Führungsfläche FF zugewandten Unterseite zwei Permanentmagnete 41 derart angeordnet, dass einer dieser zwei Permanentmagnete 41 (mit Bezug auf die zweite Richtung Y) in der Mitte zwischen den zwei dritten horizontalen Luftlagern 51 bzw. 52 und der andere dieser zwei Permanentmagnete 41 (mit Bezug auf die zweite Richtung Y) in der Mitte zwischen den zwei vierten horizontalen Luftlagern 53 bzw. 54 angeordnet ist. Wie aus Fig. 1, 4 und 6 ersichtlich, haben die Permanentmagnete 41 gemäss dem vorliegenden Beispiel jeweils die Form einer quaderförmigen Platte und sind jeweils derart angeordnet, dass sich eine der ebenen Führungsfläche FF zugewandte Oberfläche eines jeweiligen Permanentmagnets 41 parallel zur ebenen Führungsfläche FF der Basis B erstrecken.

Um zu gewährleisten, dass alle horizontalen Luftlager der ersten Luftlager-Einrichtung LL1 vorgespannt sind, sind insgesamt fünf der oben erwähnten, aus einem ferromagnetischen Material gebildeten Leisten 42 in die jeweiligen Abschnitte FF1, FF2 und FF3 der ebenen Führungsfläche FF der Basis derart integriert, dass sich jede der fünf Leisten 42 linear in der ersten Richtung X erstreckt und dabei derart platziert ist, dass jeder der Permanentmagnete 41 unmittelbar über einer der fünf Leisten 42 angeordnet ist und relativ zu der jeweiligen Leiste 42 einen Abstand in der dritten Richtung Z aufweist. Die Permanentmagnete 41 sind dabei derart magnetisiert, dass auf jeden der Permanentmagnete 41 aufgrund der magnetischen Anziehung zwischen dem jeweiligen Permanentmagneten 41 und der jeweils unmittelbar unter dem jeweiligen Permanentmagneten 41 angeordneten Leiste 42 eine magnetische Anziehungskraft wirkt, welche senkrecht zur ebenen Führungsfläche FF in Richtung der ebenen Führungsfläche FF gerichtet ist.

Die jeweils zwei Permanentmagnete 41, welche jeweils am Druckluft-Pad 31b bzw. am Druckluft-Pad 32b angeordnet sind, haben deshalb den Effekt, das erste horizontale Luftlager 31 bzw. das erste horizontale Luftlager 32 der ersten Luftlager-Anordnung 30 mit Bezug auf den Abschnitt FF1 der ebenen Führungsfläche FF vorzuspannen. Die jeweils zwei Permanentmagnete 41, welche jeweils am Druckluft-Pad 36b bzw. am Druckluft-Pad 37b angeordnet sind, haben deshalb den Effekt, das zweite horizontale Luftlager 36 bzw. das zweite horizontale Luftlager 37 der zweiten Luftlager-Anordnung 35 mit Bezug auf den Abschnitt FF2 der ebenen Führungsfläche FF vorzuspannen. Entsprechend hat einer der zwei am Grundkörper 71 des Trägers 70 angeordneten Permanentmagnete 41 den Effekt, die zwei dritten horizontalen Luftlager 51 bzw. 52 der dritten Luftlager-Anordnung 50 mit Bezug auf den Abschnitt FF3 der ebenen Führungsfläche FF vorzuspannen, während der andere der zwei am Grundkörper 71 des Trägers 70 angeordneten Permanentmagnete 41 den Effekt hat, die zwei vierten horizontalen Luftlager 53 bzw. 54 mit Bezug auf den Abschnitt FF3 der ebenen Führungsfläche FF vorzuspannen.

Um eine einfache Integration der jeweiligen Leisten 42 in die jeweiligen Abschnitte FF1, FF2 und FF3 der ebenen Führungsfläche FF der Basis B zu ermöglichen, sind in den Abschnitten FF1, FF2 und FF3 der ebenen Führungsfläche FF insgesamt fünf sich geradlinig in der ersten Richtung X erstreckende Nuten NX ausgebildet und in jede der Nuten NX jeweils eine der Leisten 42 derart angeordnet, dass eine obere Oberfläche der jeweiligen Leiste 42 und einer der Abschnitte FF1, FF2 und FF3 der ebenen Führungsfläche FF jeweils bündig angeordnet sind. Entsprechend der räumlichen Anordnung der Permanentmagnete 41 sind gemäss dem vorliegenden Bespiel: zwei Leisten 42, welche sich parallel zueinander in der ersten Richtung X erstrecken und relativ zueinander einen Abstand in der zweiten Richtung Y aufweisen, in den ersten Abschnitt FF1 der ebenen Führungsfläche FF integriert; zwei Leisten 42, welche sich parallel zueinander in der ersten Richtung X erstrecken und relativ zueinander einen Abstand in der zweiten Richtung Y aufweisen, in den zweiten Abschnitt FF2 der ebenen Führungsfläche FF integriert; und eine Leiste 42 in den dritten Abschnitt FF3 der ebenen Führungsfläche FF integriert (wie aus Fig. 1, 2 und 5 ersichtlich).

Die Einrichtung 60 zum Vorspannen der jeweiligen seitlichen Luftlager der dritten Luftlager-Anordnung 50 der ersten Luftlager-Einrichtung LL1 umfasst (wie aus Fig. 5-6 ersichtlich) einerseits eine Anordnung von zwei Permanentmagneten 61, welche an einer der ebenen Seitenfläche SF des Führungsbalkens FB zugewandten Seite des Grundkörpers 71 des Trägers 70 angeordnet sind, und andererseits den Führungsbalken FB, wobei der Führungsbalken FB im vorliegenden Beispiel aus einem ferromagnetischen Material gebildet ist. Die zwei Permanentmagnete 61 haben gemäss dem vorliegenden Beispiel jeweils die Form einer quaderförmigen Platte und sind jeweils derart angeordnet, dass sich eine der ebenen Seitenfläche SF des Führungsbalkens FB zugewandte Oberfläche eines jeweiligen Permanentmagneten 61 jeweils parallel zur ebenen Seitenfläche SF des Führungsbalkens FB erstreckt und dabei einen Abstand zur ebenen Seitenfläche SF des Führungsbalkens FB aufweist. Die zwei Permanentmagnete 61 sind insbesondere gemeinsam mit den zwei seitlichen Luftlagern 55 bzw. 56 der dritten Luftlager-Anordnung 50 in einer sich in der ersten Richtung X erstreckenden Reihe am Grundkörper 71 des Trägers 70 angeordnet, und zwar derart, dass die zwei Permanentmagnete 61 mit Bezug auf die erste Richtung X unmittelbar nebeneinander angeordnet und dabei beide in einem Zwischenraum zwischen dem Druckluft-Pad 55a des seitlichen Luftlagers 55 und dem Druckluft-Pad 56a des seitlichen Luftlagers 56 platziert sind.

Die zwei Permanentmagnete 61 sind dabei derart magnetisiert, dass auf jeden der Permanentmagnete 61 aufgrund der magnetischen Anziehung zwischen dem jeweiligen Permanentmagneten 61 und dem Führungsbalken FB eine magnetische Anziehungskraft wirkt, welche senkrecht zur ebenen Seitenfläche SF des Führungsbalkens FB in Richtung der ebenen Seitenfläche SF gerichtet ist. Die zwei Permanentmagnete 61 haben daher den Effekt, die zwei seitlichen Luftlager 55 bzw. 56 der dritten Luftlager-Anordnung 50 mit Bezug auf die ebenen Seitenfläche SF des Führungsbalkens FB vorzuspannen.

Die Einrichtung 150 zum Vorspannen der jeweiligen horizontalen Luftlager 121-124 der zweiten Luftlager-Einrichtung LL2 umfasst (wie aus Fig. 10 ersichtlich) einerseits eine Anordnung von vier Permanentmagneten 151, welche an der Grundplatte 5.1 des beweglichen Elements 5 an einer den ebenen Führungsflächen FFG1 bzw. EFG2 des Gantry-Balkens 15 zugewandten Seite der Grundplatte 5.1 des bewegliche Elements 5 angeordnet sind, und andererseits den Gantry-Balken 15, wobei der Gantry-Balken 15 im vorliegenden Beispiel aus einem ferromagnetischen Material gebildet ist.

Die vier Permanentmagnete 151 haben gemäss dem vorliegenden Beispiel jeweils die Form einer quaderförmigen Platte und sind jeweils derart angeordnet, dass sich eine der ebenen Führungsfläche FFG1 des Gantry-Balkens 15 bzw. der ebenen Führungsfläche FFG2 des Gantry-Balkens 15 zugewandte Oberfläche eines jeweiligen Permanentmagnets 151 jeweils parallel zur ebenen Führungsfläche FFG1 des Gantry-Balkens 15 bzw. zur ebenen Führungsfläche FFG2 des Gantry-Balkens 15 erstreckt und dabei einen Abstand zur ebenen Führungsfläche FFG1 des Gantry-Balkens 15 bzw. zur ebenen Führungsfläche FFG2 des Gantry-Balkens 15 aufweist.

Zwei der Permanentmagnete 151 sind insbesondere gemeinsam mit dem ersten horizontalen Luftlager 121 und dem zweiten horizontalen Luftlager 123 der zweiten Luftlager-Einrichtung LL2 in einer sich in der zweiten Richtung Y erstreckenden Reihe angeordnet, und zwar derart, dass die zwei Permanentmagnete 151 mit Bezug auf die zweite Richtung Y unmittelbar nebeneinander angeordnet sind und dabei in einem Zwischenraum zwischen dem Druckluft-Pad 121a des ersten horizontalen Luftlagers 121 und dem Druckluft-Pad 123a des zweiten horizontalen Luftlagers 123 an der Grundplatte 5.1 des bewegliche Elements 5 unmittelbar über der ebenen Führungsfläche FFG1 des Gantry-Balkens 15 in einem Abstand zur ebenen Führungsfläche FFG1 platziert sind.

Die zwei im Zwischenraum zwischen dem Druckluft-Pad 121a und dem Druckluft-Pad 123a angeordneten Permanentmagnete 151 sind dabei derart magnetisiert, dass auf jeden der Permanentmagnete 151 aufgrund der magnetischen Anziehung zwischen dem jeweiligen Permanentmagneten 151 und dem Gantry-Balken 15 eine magnetische Anziehungskraft wirkt, welche senkrecht zu der ebenen Führungsfläche FFG1 des Gantry-Balkens 15 in Richtung der ebenen Führungsfläche FFG1 gerichtet ist. Diese zwei Permanentmagnete 151 haben daher den Effekt, das erste horizontale Luftlager 121 und das zweite horizontale Luftlager 123 der zweiten Luftlager-Einrichtung LL2 mit Bezug auf die ebene Führungsfläche FFG1 des Gantry-Balkens 15 vorzuspannen.

Ausserdem sind zwei der Permanentmagnete 151 gemeinsam mit dem ersten horizontalen Luftlager 122 und dem zweiten horizontalen Luftlager 124 der zweiten Luftlager-Einrichtung LL2 in einer sich in der zweiten Richtung Y erstreckenden Reihe angeordnet, und zwar derart, dass die zwei Permanentmagnete 151 mit Bezug auf die zweite Richtung Y unmittelbar nebeneinander angeordnet sind und dabei in einem Zwischenraum zwischen dem Druckluft-Pad 122a des ersten horizontalen Luftlagers 122 und dem Druckluft-Pad 124a des zweiten horizontalen Luftlagers 124 an der Grundplatte 5.1 des bewegliche Elements 5 unmittelbar über der ebenen Führungsfläche FFG2 des Gantry-Balkens 15 in einem Abstand zur ebenen Führungsfläche FFG2 platziert sind.

Die zwei im Zwischenraum zwischen dem Druckluft-Pad 122a und dem Druckluft-Pad 124a angeordneten Permanentmagnete 151 sind dabei derart magnetisiert, dass auf jeden der Permanentmagnete 151 aufgrund der magnetischen Anziehung zwischen dem jeweiligen Permanentmagneten 151 und dem Gantry-Balken 15 eine magnetische Anziehungskraft wirkt, welche senkrecht zu ebenen Führungsfläche FFG2 des Gantry-Balkens 15 in Richtung der ebenen Führungsfläche FFG2 gerichtet ist. Diese zwei Permanentmagnete 151 haben daher den Effekt, das erste horizontale Luftlager 122 und das zweite horizontale Luftlager 124 der zweiten Luftlager-Einrichtung LL2 mit Bezug auf die ebene Führungsfläche FFG2 des Gantry-Balkens 15 vorzuspannen.

Die Einrichtung 160 zum Vorspannen der jeweiligen seitlichen Luftlager 140 bzw. 141 der zweiten Luftlager-Einrichtung LL2 umfasst (wie aus Fig. 10 ersichtlich) einerseits eine Anordnung von zwei Permanentmagneten 161, welche an der Seitenwand 5.2 des beweglichen Elements 5 an einer der ebenen Seitenfläche SFG2 des Gantry-Balkens 15 zugewandten Seite der Seitenwand 5.2 des beweglichen Elements 5 angeordnet sind, und andererseits den Gantry-Balken 15, wobei der Gantry-Balken 15 (wie bereits erwähnt) aus einem ferromagnetischen Material gebildet ist.

Die zwei Permanentmagnete 161 haben gemäss dem vorliegenden Beispiel jeweils die Form einer quaderförmigen Platte und sind jeweils derart angeordnet, dass sich eine der ebenen Seitenfläche SFG2 des Gantry-Balkens 15 zugewandte Oberfläche eines jeweiligen Permanentmagneten 161 parallel zur ebenen Seitenfläche SFG2 des Gantry-Balkens 15 erstreckt und dabei einen Abstand zur ebenen Seitenfläche SFG2 des Gantry-Balkens 15 aufweist. Ausserdem sind zwei der Permanentmagnete 161 gemeinsam mit den zwei seitlichen Luftlagern 140 bzw. 141 der zweiten Luftlager-Einrichtung LL2 in einer sich in der zweiten Richtung Y erstreckenden Reihe angeordnet, und zwar derart, dass die zwei Permanentmagnete 161 mit Bezug auf die zweite Richtung Y unmittelbar nebeneinander angeordnet sind und dabei an der Seitenwand 5.2 des beweglichen Elements 5 in einem Zwischenraum zwischen dem Druckluft-Pad 140a des seitlichen Luftlagers 140 und dem Druckluft-Pad 141a des seitlichen Luftlagers 141 unmittelbar neben der ebenen Seitenfläche SFG2 des Gantry-Balkens 15 in einem Abstand zur ebenen Seitenfläche SFG2 platziert sind. Die zwei Permanentmagnete 161 sind dabei derart magnetisiert, dass auf jeden der Permanentmagnete 161 aufgrund der magnetischen Anziehung zwischen dem jeweiligen Permanentmagneten 161 und dem Gantry-Balken 15 eine magnetische Anziehungskraft wirkt, welche senkrecht zur ebenen Seitenfläche SFG2 des Gantry-Balkens 15 in Richtung der ebenen Seitenfläche SFG2 gerichtet ist. Die zwei Permanentmagnete 161 haben daher den Effekt, die zwei seitlichen Luftlager 140 bzw. 141 der zweiten Luftlager-Einrichtung LL2 mit Bezug auf die ebene Seitenfläche SFG2 des Gantry-Balkens 15 vorzuspannen.

Die Anordnung der Permanentmagnete 41, 61, 151 und 161 (relativ zu einer Leiste 42 bzw. relativ zur ebenen Seitenfläche SF des Führungsbalkens FB bzw. relativ zur ebenen Führungsfläche FFG1 des Gantry-Balkens 15 bzw. relativ zur ebenen Führungsfläche FFG2 des Gantry-Balkens 15 bzw. relativ zur ebenen Seitenfläche SFG2 des Gantry-Balkens 15, in dieser Reihenfolge) kann variiert werden, um die Grösse der jeweiligen Vorspannkräfte der einzelnen Luftlager der ersten Luftlager-Einrichtung LL1 und der einzelnen Luftlager der zweiten Luftlager-Einrichtung LL1 nach Bedarf geeignet zu wählen (beispielsweise in Abhängigkeit von der gesamten Masse der mittels der zwei Linearantriebe LMX1 und LMX2 der zwei ersten Linearachsen X1 und X2 im Betrieb der Positioniervorrichtung 1 zu bewegenden Teile der der Positioniervorrichtung 1).

Die Vorspannkräfte der einzelnen Luftlager der ersten Luftlager-Einrichtung LL1 und der einzelnen Luftlager der zweiten Luftlager-Einrichtung LL1 können beispielweise so gewählt werden, dass im Betrieb der Positioniervorrichtung 1 (d.h. bei einer entsprechenden Versorgung der Luftdruck-Pads 31b, 32b, 36b, 37b, 51a, 52a, 53a, 54a, 55a und 56a der Luftlager 31, 32, 36, 37, 51, 52, 53, 54, 55 und 55 der ersten Luftlager-Einrichtung LL1 mit Druckluft und bei einer entsprechenden Versorgung der Luftdruck-Pads 121a, 122a, 123a, 124a, 140a und 141a der Luftlager 121, 122, 123, 124, 140 und 141 der zweiten Luftlager-Einrichtung LL2):
- die einzelnen Luftdruck-Pads 31b, 32b, 36b, 37b mit Bezug auf die ebene Führungsfläche FF der Basis B jeweils in einer stabilen Lage gehalten werden, in welcher die einzelnen Luftdruck-Pads 31b, 32b, 36b, 37b, 51a, 52a, 53a, 54a bezüglich der ebenen Führungsfläche FF der Basis B einen vorgegebenen Abstand (z.B. 4 µm) aufweisen;
- die einzelnen Luftdruck-Pads 55a und 56a mit Bezug auf die ebene Seitenfläche SF des Führungsbalkens FB jeweils in einer stabilen Lage gehalten werden, in welcher die einzelnen Luftdruck-Pads 55a und 56a bezüglich der ebenen Seitenfläche SF des Führungsbalkens FB einen vorgegebenen Abstand (z.B. 4 µm) aufweisen;
- die einzelnen Luftdruck-Pads 121a, 122a, 123a, 124a mit Bezug auf den Gantry-Balken 15 in einer stabilen Lage gehalten werden, in welcher die Luftdruck-Pads 121a und 123a bezüglich der ebenen Führungsfläche FFG1 und die Luftdruck-Pads 122a und 124a bezüglich der ebenen Führungsfläche FFG2 einen vorgegebenen Abstand (z.B. 4 µm) aufweisen; und
- die einzelnen Luftdruck-Pads 140a und 141a mit Bezug auf den Gantry-Balken 15 in einer stabilen Lage gehalten werden, in welcher die Luftdruck-Pads bezüglich der ebenen Seitenfläche SFG2 einen vorgegebenen Abstand (z.B. 4 µm) aufweisen.

Mit Bezug auf Fig. 5, 6, 7A, 7B, 8 und 9 werden im Folgenden konstruktive Details bezüglich des ersten Festköpergelenks 80A bzw. des zweiten Festköpergelenks 80B und eine Anordnung dieser Festkörpergelenke 80A und 80B zum Ausbilden eines das Gleitelement GE mit dem Gantry-Balken 15 verbindenden Drehgelenks DGZ beschrieben.

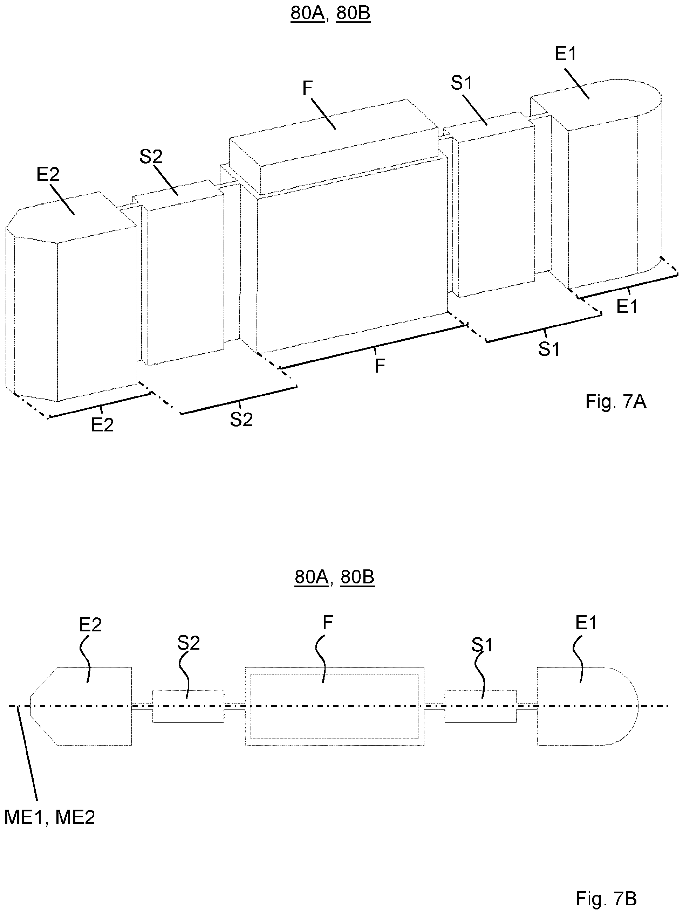

Wie bereits erwähnt, sind das erste Festkörpergelenk 80A und das zweite Festköpergelenk 80B räumlich unterschiedlich am Träger 70 des Gleitelements GE angeordnet, um eine Verbindung zwischen dem Träger 70 und dem Gantry-Balken 15 herzustellen, sodass das Gleitelement GE um eine sich in der dritten Richtung Z erstreckende Drehachse relativ zum Gantry-Balken 15 drehbar ist. Wie Fig. 7A und 7B andeuten, können das erste Festkörpergelenk 80A und das zweite Festköpergelenk 80B im vorliegenden Beispiel hinsichtlich ihrer physischen Struktur allerdings identisch ausgebildet sein.

Fig. 7A und 7B zeigen das erste Festkörpergelenk 80A bzw. das zweite Festköpergelenk 80B aus verschieden Perspektiven, d.h. in einer perspektivischen Ansicht (Fig. 7A) und in einer Draufsicht entlang der dritten Richtung Z.

Wie Fig. 7A, 7B, 8 und 9 andeuten, besteht sowohl das erste Festkörpergelenk 80A als auch das zweite Festkörpergelenk 80B jeweils aus einem länglichen Festkörper (z.B. aus Stahl), welcher sich entlang einer zur dritten Richtung Z parallelen Ebene senkrecht zur dritten Richtung Z erstreckt und eine senkrecht zur dritten Richtung Z angeordnete Längsachse aufweist.

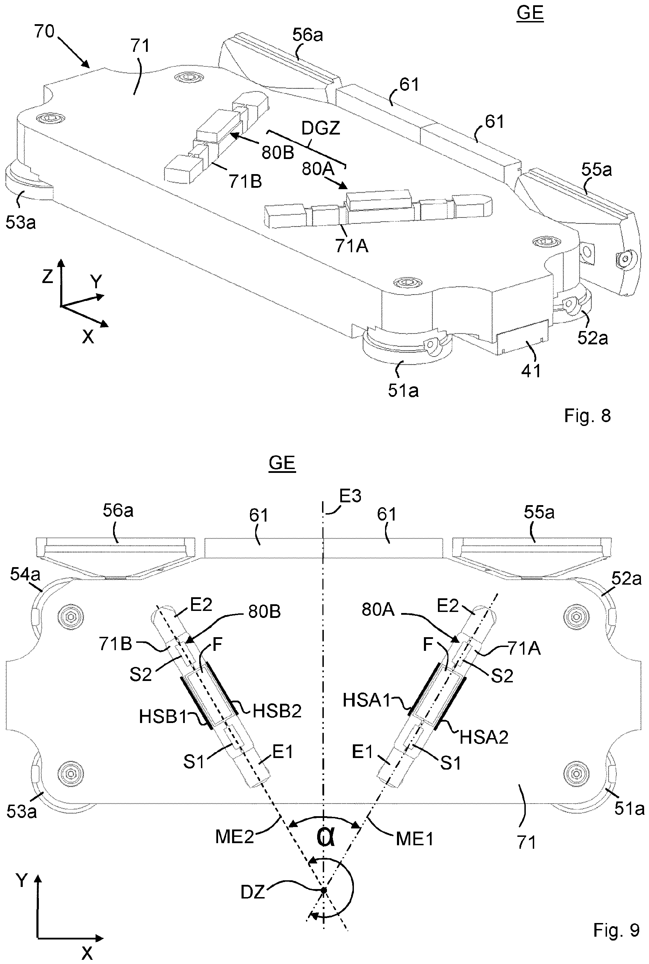

Wie in Fig. 7A und 9 angedeutet, wird in diesem Zusammenhang angenommen, dass ein das erste Festkörpergelenk 80A bildendender erster länglicher Festköper sich entlang einer zur dritten Richtung Z parallelen ersten Ebene ME1 erstreckt und dass ein das zweite Festkörpergelenk 80B bildendender zweiter länglicher Festköper sich entlang einer zur dritten Richtung Z parallelen zweiten Ebene ME2 erstreckt.

Fig. 7A und 7B stellen das erste Festkörpergelenk 80A bzw. das zweite Festkörpergelenk 80B jeweils in einem "undeformierten Grundzustand" dar, in welchem der jeweilige längliche Festkörper des ersten Festkörpergelenks 80A bzw. des zweiten Festkörpergelenks 80B keiner mechanischen Belastung ausgesetzt und demensprechend "undeformiert" ist. Im undeformierten Grundzustand ist der erste längliche Festkörper des ersten Festkörpergelenks 80A symmetrisch zur ersten Ebene ME1 und der zweite längliche Festkörper des zweiten Festkörpergelenks 80A symmetrisch zur zweiten Ebene ME2 ausgebildet.

Wie aus Fig. 7A und 7B ersichtlich, weisen der erste längliche Festkörper des ersten Festkörpergelenks 80A in Richtung seiner sich entlang der ersten Ebene ME1 erstreckenden Längsachse und der zweite längliche Festkörper des zweiten Festkörpergelenks 80B in Richtung seiner sich entlang der zweiten Ebene ME2 erstreckenden Längsachse jeweils die folgenden hintereinander angeordneten Längsabschnitte auf:
- einen ersten Endabschnitt E1, welcher ein erstes Ende des jeweiligen (ersten bzw. zweiten) länglichen Festkörpers bildet;
- einen zweiten Endabschnitt E2, welcher ein dem ersten Ende des jeweiligen (ersten bzw. zweiten) länglichen Festkörpers in Richtung der Längsachse des jeweiligen (ersten bzw. zweiten) länglichen Festkörpers gegenüberliegendes zweites Ende des jeweiligen (ersten bzw. zweiten) länglichen Festkörpers bildet;
- einen zwischen dem ersten Endabschnitt E1 und dem zweiten Endabschnitt E2 des jeweiligen (ersten bzw. zweiten) länglichen Festkörpers angeordneten Mittelabschnitt F;
- einen zwischen dem ersten Endabschnitt E1 und dem Mittelabschnitt F des jeweiligen (ersten bzw. zweiten) länglichen Festkörpers angeordneten, mit dem ersten Endabschnitt E1 und dem Mittelabschnitt F verbundenen ersten Stegteil S1;
- einen zwischen dem zweiten Endabschnitt E2 und dem Mittelabschnitt F angeordneten, mit dem zweiten Endabschnitt E2 und dem Mittelabschnitt F des jeweiligen (ersten bzw. zweiten) länglichen Festkörpers verbundenen zweiten Stegteil S2.

Wie Fig. 7A und 7B andeuten, sind der erste längliche Festkörper des ersten Festkörpergelenks 80A und der zweite längliche Festkörper des zweiten Festkörpergelenks 80B jeweils derart geformt, dass jeweils der erste Stegteil S1 und der zweite Stegteil S2 des ersten Festkörpergelenks 80A in einer Richtung senkrecht zur ersten Ebene ME1 eine geringere Erstreckung aufweist als der erste Endabschnitt E1, der zweite Endabschnitt E2 und der Mittelabschnitt F des ersten Festkörpergelenks 80A und dass jeweils der erste Stegteil S1 und der zweite Stegteil S2 des zweiten Festkörpergelenks 80B in einer Richtung senkrecht zur zweiten Ebene ME2 eine geringere Erstreckung aufweist als der erste Endabschnitt E1, der zweite Endabschnitt E2 und der Mittelabschnitt F des zweiten Festkörpergelenks 80B. Die vorstehend genannte Ausbildung der Stegteile S1 und S2 hat den Effekt, dass sowohl der erste längliche Festkörper des ersten Festkörpergelenks 80A als auch der zweite längliche Festkörper des zweiten Festkörpergelenks 80B hauptsächlich im Bereich der Stegteile S1 und S2 elastisch deformierbar sind.

Der Träger 70 ist mit dem Gantry-Balken 15 über das erste Festkörpergelenk 80A und das zweite Festkörpergelenk 80B derart verbunden, dass der erste Endabschnitt E1 des ersten Festkörpergelenks 80A und der zweite Endabschnitt E2 des ersten Festkörpergelenks 80A starr mit dem Träger 70 und der Mittelabschnitt F des ersten Festkörpergelenks 80A starr mit dem Gantry-Balken 15 verbunden sind und dass der erste Endabschnitt E1 des zweiten Festkörpergelenks 80B und der zweite Endabschnitt E2 des zweiten Festkörpergelenks 80B starr mit dem Träger 70 und der Mittelabschnitt F des zweiten Festkörpergelenks 80B starr mit dem Gantry-Balken 15 verbunden sind.

Zur Realisierung der vorstehend genannten Anordnung des ersten Festkörpergelenks 80A und des zweiten Festkörpergelenks 80B ist (wie in Fig. 6-9 angedeutet) das erste Festkörpergelenk 80A in dem im Grundkörper 71 des Trägers 70 ausgebildeten länglichen Hohlraum 71A angeordnet, sodass der erste Endabschnitt E1 und der zweite Endabschnitt E2 des ersten Festkörpergelenks 80A starr mit dem Träger 70 verbunden sind (z.B. mittels einer Verbindung mittels einer Schraube) und der Mittelabschnitt F des ersten Festkörpergelenks 80A durch die in der Deckplatte 72 des Trägers 70 ausgebildete Öffnung 72A starr mit dem Gantry-Balken 15 verbunden ist (z.B. mittels einer Verbindung mittels einer Schraube). Entsprechend ist das zweite Festkörpergelenk 80B in dem im Grundkörper 71 des Trägers 70 ausgebildeten länglichen Hohlraum 71B angeordnet, sodass der erste Endabschnitt E1 und der zweite Endabschnitt E2 des zweiten Festkörpergelenks 80B starr mit dem Träger 70 verbunden sind (z.B. mittels einer Verbindung mittels einer Schraube) und der Mittelabschnitt F des zweiten Festkörpergelenks 80B durch die in der Deckplatte 72 des Trägers 70 ausgebildete Öffnung 72B starr mit dem Gantry-Balken 15 verbunden ist (z.B. mittels einer Verbindung mittels einer Schraube).

Wie in Fig. 6-9 angedeutet, erstreckt sich der längliche Hohlraum 71A entlang der erste Ebene ME1 derart, dass eine Längsachse des länglichen Hohlraums 71A parallel zur ersten Ebene ME1 und senkrecht dritten Richtung Z angeordnet ist und der längliche Hohlraum 71A seitlich mit Bezug auf die erste Ebene ME1 durch Seitenwände des Grundkörpers 71 begrenzt ist, welche sich parallel zur ersten Ebene ME1 und senkrecht dritten Richtung Z erstrecken. Die den länglichen Hohlraums 71A begrenzenden Seitenwände des Grundkörpers 71 sind dabei im Vergleich zum ersten Festkörpergelenk 80A derart geformt, dass der erste Endabschnitt E1 und der zweite Endabschnitt E2 des ersten Festkörpergelenks 80A formschlüssig mit dem Grundkörper 71 verbunden sind, während der Mittelabschnitt F des ersten Festkörpergelenks 80A in einer Richtung senkrecht zur ersten Ebene ME1 eine Erstreckung aufweist, welche geringer ist als der Abstand zwischen einem ersten Wandabschnitt HSA1 des Grundkörpers 71 und einem dem ersten Wandabschnitt HSA1 mit Bezug auf die erste Ebene ME1 gegenüberliegenden zweiten Wandabschnitt HSA2 des Grundkörpers 71, welche Wandabschnitte HSA1 und HSA2 den länglichen Hohlraum 71A im Bereich des Mittelabschnitts F des ersten Festkörpergelenks 80A seitlich begrenzen.

Zur Verdeutlichung des vorstehend genannten Sachverhalts sind die den länglichen Hohlraum 71A seitlich begrenzenden Wandabschnitte HSA1 und HSA2 des Grundkörpers 71 in Fig. 9 jeweils durch eine relativ dicke (mit dem Bezugszeichen HSA1 bzw. HSA2 versehene) schwarze Linie dargestellt: Wie in Fig. 9 erkennbar, ist der Mittelabschnitt F des ersten Festkörpergelenks 80A (im undeformierten Grundzustand des Festkörpergelenks 80A) mit Bezug auf den ersten Endabschnitt E1 und den zweiten Endabschnitt E2 des ersten Festkörpergelenks 80A und mit Bezug auf die Wandabschnitte HSA1 und HSA2 des länglichen Hohlraums 71A derart angeordnet, dass sich der Mittelabschnitt F des ersten Festkörpergelenks 80A in etwa in einer mittleren Position zwischen dem Wandabschnitt HSA1 und dem Wandabschnitt HSA2 befindet und dabei in einer Richtung senkrecht zur ersten Ebene ME1 sowohl zum Wandabschnitt HSA1 als auch zum Wandabschnitt HSA2 jeweils einen Abstand aufweist.

Entsprechend erstreckt sich der längliche Hohlraum 71B entlang der zweiten Ebene ME2 derart, dass eine Längsachse des länglichen Hohlraums 71B parallel zur zweiten Ebene ME2 und senkrecht dritten Richtung Z angeordnet ist und der längliche Hohlraum 71B seitlich mit Bezug auf die zweite Ebene ME2 durch Seitenwände des Grundkörpers 71 begrenzt ist, welche sich parallel zur zweiten Ebene ME2 und senkrecht dritten Richtung Z erstrecken. Die den länglichen Hohlraums 71B begrenzenden Seitenwände des Grundkörpers 71 sind dabei im Vergleich zum zweiten Festkörpergelenk 80B derart geformt, dass der erste Endabschnitt E1 und der zweite Endabschnitt E2 des zweiten Festkörpergelenks 80B formschlüssig mit dem Grundkörper 71 verbunden sind, während der Mittelabschnitt F des zweiten Festkörpergelenks 80B in einer Richtung senkrecht zur zweiten Ebene ME2 eine Erstreckung aufweist, welche geringer ist als der Abstand zwischen einem ersten Wandabschnitt HSB1 des Grundkörpers 71 und einem dem ersten Wandabschnitt HSB1 mit Bezug auf die zweite Ebene ME2 gegenüberliegenden zweiten Wandabschnitt HSB2 des Grundkörpers 71, welche Wandabschnitte HSB1 und HSB2 den länglichen Hohlraum 71B im Bereich des Mittelabschnitts F des zweiten Festkörpergelenks 80B seitlich begrenzen.

Zur Verdeutlichung des vorstehend genannten Sachverhalts sind die den länglichen Hohlraum 71B seitlich begrenzenden Wandabschnitte HSB1 und HSB2 des Grundkörpers 71 in Fig. 9 jeweils durch eine relativ dicke (mit dem Bezugszeichen HSB1 bzw. HSB2 versehene) schwarze Linie dargestellt: Wie in Fig. 9 erkennbar, ist der Mittelabschnitt F des zweiten Festkörpergelenks 80B (im undeformierten Grundzustand des zweiten Festkörpergelenks 80B) mit Bezug auf den ersten Endabschnitt E1 und den zweiten Endabschnitt E2 des zweiten Festkörpergelenks 80B und mit Bezug auf die Wandabschnitte HSB1 und HSB2 des länglichen Hohlraums 71B derart angeordnet, dass sich der Mittelabschnitt F des zweiten Festkörpergelenks 80B in etwa in einer mittleren Position zwischen dem Wandabschnitt HSB1 und dem Wandabschnitt HSB2 befindet und dabei in einer Richtung senkrecht zur zweiten Ebene ME2 sowohl zum Wandabschnitt HSB1 als auch zum Wandabschnitt HSB2 jeweils einen Abstand aufweist.

Das erste Festkörpergelenk 80A und das zweite Festkörpergelenk 80B sind ausgebildet, den Träger 70 bzw. das Gleitelement GE in einer stabilen Ruhelage mit Bezug auf den Gantry-Balken 15 zu halten, wenn sich beide Festkörpergelenke 80A und 80B jeweils in ihrem undefomierten Grundzustand befinden (wie in Fig. 9 dargestellt). Dadurch, dass der erste Stegteil S1 und der zweite Stegteil S2 des ersten Festkörpergelenks 80A und der erste Stegteil S1 und der zweite Stegteil S2 des zweiten Festkörpergelenks 80B jeweils elastisch deformierbar ausgebildet sind, und dadurch, dass der Mittelabschnitt F des ersten Festkörpergelenks 80A (im undeformierten Grundzustand des ersten Festkörpergelenks 80A) in einer Richtung senkrecht zur ersten Ebene ME1 sowohl zum Wandabschnitt HSA1 als auch zum Wandabschnitt HSA2 jeweils einen Abstand aufweist und ausserdem der Mittelabschnitt F des zweiten Festkörpergelenks 80B (im undeformierten Grundzustand des zweiten Festkörpergelenks 80B) in einer Richtung senkrecht zur zweiten Ebene ME2 sowohl zum Wandabschnitt HSB1 als auch zum Wandabschnitt HSB2 jeweils einen Abstand aufweist, ist der Träger 70 bzw. das Gleitelement GE mittels des ersten Festkörpergelenks 80A und des zweiten Festkörpergelenks 80B derart am Gantry-Balken 15 gehalten, dass der Träger 70 bzw. das Gleitelement GE relativ zum Gantry-Balken 15 bewegbar ist, sofern der Mittelabschnitt F des ersten Festkörpergelenks 80A nicht an einen der Wandabschnitte HSA1 bzw. HSA2 stösst und nicht einer der Wandabschnitte HSA1 bzw. HSA2 eine entsprechende Bewegung des Trägers 70 bzw. des Gleitelements GE relativ zum Gantry-Balken 15 blockiert und/oder sofern der Mittelabschnitt F des zweiten Festkörpergelenks 80B nicht an einen der Wandabschnitte HSB1 bzw. HSB2 stösst und nicht einer der Wandabschnitte HSB1 bzw. HSB2 eine entsprechende Bewegung des Trägers 70 bzw. des Gleitelements GE relativ zum Gantry-Balken 15 blockiert.

Eine Bewegung des Trägers 70 bzw. des Gleitelements GE relativ zum Gantry-Balken 15 hat den Effekt, dass bei dieser Bewegung der erste Stegteil S1 und der zweite Stegteil S2 des ersten Festkörpergelenks 80A und der erste Stegteil S1 und der zweite Stegteil S2 des zweiten Festkörpergelenks 80B elastisch deformiert werden und dabei der Mittelabschnitt F des ersten Festkörpergelenks 80A relativ zum ersten Endabschnitt E1 des ersten Festkörpergelenks 80A und zum zweiten Endabschnitt E2 des ersten Festkörpergelenks 80A bewegt wird und ausserdem der Mittelabschnitt F des zweiten Festkörpergelenks 80B relativ zum ersten Endabschnitt E1 des zweiten Festkörpergelenks 80B und zum zweiten Endabschnitt E2 des zweiten Festkörpergelenks 80B bewegt wird.

Aufgrund der Form des ersten Festkörpergelenks 80A hat der Mittelabschnitt F des ersten Festkörpergelenks 80A mit Bezug auf den ersten Endabschnitt E1 und mit Bezug auf den zweiten Endabschnitt E2 des ersten Festkörpergelenks 80A verschiedene Bewegungsfreiheitsgrade, welche Bewegungen des Mittelabschnitts F des ersten Festkörpergelenks 80A in unterschiedlichen Richtungen mit Bezug auf den ersten Endabschnitt E1 und den zweiten Endabschnitt E2 des ersten Festkörpergelenks 80A entsprechen. In diesem Zusammenhang ist relevant, dass das erste Festkörpergelenk 80A bei Bewegungen des Mittelabschnitts F in jeweils unterschiedlichen Richtungen mit Bezug auf den ersten Endabschnitt E1 bzw. den zweiten Endabschnitt E2 des ersten Festkörpergelenks 80A unterschiedlich steif ist (abhängig von der Richtung der Bewegung). Dadurch, dass im Falle des ersten Festkörpergelenks 80A sowohl der erste Endabschnitt E1 als auch der zweite Endabschnitt E2 des ersten Festkörpergelenks 80A starr mit dem Träger 70 verbunden sind, weist das erste Festkörpergelenk 80A eine relativ grosse Steifigkeit im Hinblick auf eine Deformation des ersten Festkörpergelenks 80A auf, bei welcher der Mittelabschnitt F in Richtung der Längsachse des ersten Festkörpergelenks 80A (d.h. parallel zur ersten Ebene ME1) relativ zum ersten Endabschnitt E1 und zum zweiten Endabschnitt E2 des ersten Festkörpergelenks 80A bewegt wird, zumal bei einer derartigen Bewegung des Mittelabschnitts F der erste Stegteil S1 bzw. der zweite Stegteil S2 des ersten Festkörpergelenks 80A im Wesentlichen auschliesslich auf einen Zug bzw. auf einen Druck in Richtung der Längsachse des ersten Festkörpergelenks 80A belastet wird. Andererseits weist das erste Festkörpergelenk 80A eine relativ geringe Steifigkeit im Hinblick auf Deformationen des ersten Festkörpergelenk 80A auf, bei welcher der Mittelabschnitt F relativ zum ersten Endabschnitt E1 und zum zweiten Endabschnitt E2 des ersten Festkörpergelenk 80A entweder linear in einer Richtung senkrecht zur ersten Ebene ME1 bewegt oder um eine sich in der dritten Richtung Z erstreckende Drehachse gedreht wird, zumal bei einer der vorstehend genannten Bewegungen des Mittelabschnitts F der erste Stegteil S1 und der zweite Stegteil S2 des ersten Festkörpergelenks 80A jeweils durch eine Kombination aus Zugspannung und Biegung um eine sich in der dritten Richtung Z erstreckende Achse belastet werden und der erste Stegteil S1 und der zweite Stegteil S2 mit Bezug auf eine Biegung um eine sich in der dritten Richtung Z erstreckende Achse eine besonders geringe Steifigkeit aufweisen.

Entsprechend hat aufgrund der Form des zweiten Festkörpergelenks 80B der Mittelabschnitt F des zweiten Festkörpergelenks 80B mit Bezug auf den ersten Endabschnitt E1 und den zweiten Endabschnitt E2 des zweiten Festkörpergelenks 80B verschiedene Bewegungsfreiheitsgrade, welche Bewegungen des Mittelabschnitts F des zweiten Festkörpergelenks 80B in unterschiedlichen Richtungen mit Bezug auf den ersten Endabschnitt E1 und den zweiten Endabschnitt E2 des zweiten Festkörpergelenks 80B entsprechen.

Dadurch, dass im Falle des zweiten Festkörpergelenks 80B sowohl der erste Endabschnitt E1 als auch der zweite Endabschnitt E2 des zweiten Festkörpergelenks 80B starr mit dem Träger 70 verbunden sind, weist das zweite Festkörpergelenk 80B eine relativ grosse Steifigkeit im Hinblick auf eine Deformation des zweiten Festkörpergelenks 80B auf, bei welcher der Mittelabschnitt F in Richtung der Längsachse des zweiten Festkörpergelenks 80B (d.h. parallel zur zweiten Ebene ME2) relativ zum ersten Endabschnitt E1 und zum zweiten Endabschnitt E2 des zweiten Festkörpergelenks 80B bewegt wird, zumal bei einer derartigen Bewegung des Mittelabschnitts F der erste Stegteil S1 bzw. der zweite Stegteil S2 des zweiten Festkörpergelenks 80B im Wesentlichen auschliesslich auf einen Zug bzw. auf einen Druck in Richtung der Längsachse des zweiten Festkörpergelenks 80B belastet wird. Andererseits weist das zweite Festkörpergelenk 80B eine relativ geringe Steifigkeit im Hinblick auf Deformationen des zweiten Festkörpergelenks 80B auf, bei welcher der Mittelabschnitt F relativ zum ersten Endabschnitt E1 und zum zweiten Endabschnitt E2 des zweiten Festkörpergelenks 80B entweder linear in einer Richtung senkrecht zur zweiten Ebene ME2 bewegt oder um eine sich in der dritten Richtung Z erstreckende Drehachse gedreht wird, zumal bei einer der vorstehend genannten Bewegungen des Mittelabschnitts F der erste Stegteil S1 und der zweite Stegteil S2 des zweiten Festkörpergelenks 80B jeweils durch eine Kombination aus Zugspannung und Biegung um eine sich in der dritten Richtung Z erstreckende Achse belastet werden und der erste Stegteil S1 und der zweite Stegteil S2 mit Bezug auf eine Biegung um eine sich in der dritten Richtung Z erstreckende Achse eine besonders geringe Steifigkeit aufweisen.

Im Falle der Positioniervorrichtung 1 ist von Interesse, dass die Anordnung des ersten Festkörpergelenks 80A und des zweiten Festkörpergelenks 80B eine Verbindung zwischen dem Träger 70 bzw. dem Gleitelement GE und dem Gantry-Balken 15 repräsentiert, welche einerseits eine möglichst hohe Steifigkeit mit Bezug auf eine Translation des Trägers 70 bzw. des Gleitelements GE relativ zum Gantry-Balken 15 in der ersten Richtung X und in der zweiten Richtung Y und in der dritten Richtung Z gewährleistet, andererseits aber eine möglichst geringe Steifigkeit mit Bezug auf eine Rotation des Trägers 70 bzw. des Gleitelements GE relativ zum Gantry-Balken 15 um eine sich in der dritten Richtung Z erstreckende Drehachse aufweist.

Um die vorstehend genannten Anforderungen zu erfüllen, sind das erste Festkörpergelenk 80A und das zweite Festkörpergelenk 80B relativ zueinander derart am Träger 70 angeordnet, dass die erste Ebene ME1 und die zweite Ebene ME2 nicht parallel zueinander angeordnet sind, sondern relativ zueinander derart geneigt sind, dass die erste Ebene ME1 und die zweite Ebene ME2 eine sich parallel zur dritten Richtung Z erstreckende gemeinsame Schnittlinie DZ bilden (wie in Fig. 9 dargestellt). In diesem Fall bilden die erste Ebene ME1 und die zweite Ebene ME2 mit Bezug auf die gemeinsame Schnittlinie DZ einen Winkel α, welcher grösser als 0° und kleiner als 180° sein muss. Um eine hinreichend hohe Steifigkeit der Anordnung des ersten Festkörpergelenks 80A und des zweiten Festkörpergelenks 80B mit Bezug auf eine Translation des Trägers 70 bzw. des Gleitelements GE relativ zum Gantry-Balken 15 in der ersten Richtung X und in der zweiten Richtung Y zu gewährleisten, sollte der Winkel α vorzugsweise die Bedingung 30° ≤ α ≤ 90° erfüllen.

Im Falle des in Fig. 6, 8 und 9 dargestellten Beispiels beträgt der Winkel α ca. 60°.

Eine Anordnung des ersten Festkörpergelenks 80A und des zweiten Festkörpergelenks 80B derart, dass die erste Ebene ME1 und die zweite Ebene ME2 mit Bezug auf die gemeinsame Schnittlinie DZ einen Winkel α von ca. 60° bilden, stellt im vorliegenden Fall eine guten Kompromiss dar, derart, dass die Steifigkeit der Anordnung des ersten Festkörpergelenks 80A und des zweiten Festkörpergelenks 80B mit Bezug auf eine Rotation des Trägers 70 bzw. des Gleitelements GE relativ zum Gantry-Balken 15 um die gemeinsame Schnittlinie DZ der ersten Ebene ME1 und der zweiten Ebene ME2 hinreichend gering ist und die Steifigkeit der Anordnung des ersten Festkörpergelenks 80A und des zweiten Festkörpergelenks 80B mit Bezug auf eine Translation des Trägers 70 bzw. des Gleitelements GE relativ zum Gantry-Balken 15 in der ersten Richtung X und in der zweiten Richtung Y hinreichend hoch ist.

Die gemeinsame Schnittlinie DZ der ersten Ebene ME1 und der zweiten Ebene ME2 bilden in diesem Zusammenhang eine (sich in der dritten Richtung Z erstreckende) "virtuelle" Drehachse, um welche der Trägers 70 bzw. das Gleitelements GE relativ zum Gantry-Balken 15 mittels der Anordnung des ersten Festkörpergelenks 80A und des zweiten Festkörpergelenks 80B drehbar gelagert ist.

Wie in Fig. 9 angedeutet, kann sich die "virtuelle" Drehachse DZ räumlich derart erstrecken, dass die Drehachse DZ ausserhalb des Trägers 70 bzw. des Gleitelements GE angeordnet ist. Die räumliche Anordnung des ersten Festkörpergelenks 80A und des zweiten Festkörpergelenks 80B kann demnach nach Bedarf geeignet gewählt werden, um eine bestimmte vorgegebene Lage der Drehachse DZ zu realisieren.

Wie in Fig. 9 angedeutet, sind das erste Festkörpergelenk 80A und das zweite Festkörpergelenk 80B symmetrisch bezüglich einer dritten Ebene E3 angeordnet sind, welche sich parallel zur zweiten Richtung Y und parallel zur dritten Richtung Z erstreckt. Eine derartige Anordnung hat den Vorteil, dass das erste Festkörpergelenk 80A und das zweite Festkörpergelenk 80B bei einer Beschleunigung des beweglichen Elements 5 in der zweiten Richtung Y jeweils auf dieselbe Weise beansprucht werden.

Die den länglichen Hohlraum 71A seitlich begrenzenden Wandabschnitte HSA1 und HSA2 des Grundkörpers 71 können im vorliegenden Beispiel derart angeordnet sein, dass der Wandabschnitt HSA1 und/oder der Wandabschnitt HSA2 einen Abstand zu dem (starr mit dem Gantry-Balken 15 verbundenen) Mittelabschnitt F des ersten Festkörpergelenks 80A aufweist, wenn das erste Festkörpergelenk 80A sich im undeformierten Grundzustand befindet, und dass der Wandabschnitt HSA1 und/oder der Wandabschnitt HSA2 mittels einer Drehung des Trägers 70 um einen vorgegebenen maximalen Drehwinkel um die "virtuelle" Drehachse DZ in Kontakt mit dem Mittelabschnitt F des ersten Festkörpergelenks 80A bringbar ist, sodass der Mittelabschnitt F des ersten Festkörpergelenks 80A einen die Drehung des Trägers 70 limitierenden mechanischen Anschlag für den Träger 70 bildet (Fig. 9).

In analoger Weise können die den länglichen Hohlraum 71B seitlich begrenzenden Wandabschnitte HSB1 und HSB2 des Grundkörpers 71 im vorliegenden Beispiel derart angeordnet sein, dass der Wandabschnitt HSB1 und/oder der Wandabschnitt HSB2 einen Abstand zu dem (starr mit dem Gantry-Balken 15 verbundenen) Mittelabschnitt F des zweiten Festkörpergelenks 80B aufweist, wenn das zweite Festkörpergelenk 80B sich im undeformierten Grundzustand befindet, und dass der Wandabschnitt HSB1 und/oder der Wandabschnitt HSB2 mittels einer Drehung des Trägers 70 um einen vorgegebenen maximalen Drehwinkel um die "virtuelle" Drehachse DZ in Kontakt mit dem Mittelabschnitt F des zweiten Festkörpergelenks 80B bringbar ist, sodass der Mittelabschnitt F des zweiten Festkörpergelenks 80B einen die Drehung des Trägers 70 limitierenden mechanischen Anschlag für den Träger 70 bildet (Fig. 9).

Durch eine geeignete Wahl der Anordnung der Wandabschnitte HSA1 und/oder HSA2 und/oder HSB1 und/oder HSB2 des Grundkörpers 71 kann demnach ein maximaler Drehwinkel vorgeben werden, um welchen der Träger 70 aus seiner Ruhelage um die "virtuelle" Drehachse DZ drehbar ist. Auf diese Weise können das erste Festkörpergelenk 80A und das zweite Festkörpergelenk 80B vor einer mechanischen Überlastung bewahrt werden. Im Falle der Positioniervorrichtung 1 kann es beispielsweise zweckmässig sein, dass der Träger 70 relativ zum Gantry-Balken 15 um die "virtuelle" Drehachse DZ zumindest um einen Winkel von ±0.1° drehbar ist.

Wie aus Fig. 11 und 13 ersichtlich, sind die Luftlager 121-124, 140 und 141 der zweiten Luftlager-Einrichtung LL2 relativ zum beweglichen Element 5 und relativ zum Gantry-Balken 15 und relativ zu den jeweiligen Luftlagern der ersten Luftlager-Einrichtung LL1 derart angeordnet, dass keines der Luftlager 121-124, 140 und 141 der zweiten Luftlager-Einrichtung LL2 mit einem der Luftlager der ersten Luftlager-Einrichtung LL1 kollidieren kann, wenn das bewegliche Element 5 in der zweiten Richtung Y bewegt wird.

Das bewegliche Element 5 kann deshalb in der zweiten Richtung - geführt durch die Luftlager der zweiten Luftlager-Einrichtung LL2 - im Wesentlichen entlang der gesamten Erstreckung des Gantry-Balkens 15 in der zweiten Richtung Y bewegt werden, z.B. in Richtung des ersten Endes 15.1 derart weit, bis das seitliche Luftlager 140 der zweiten Luftlager-Einrichtung LL2 das erste Ende 15.1 des Gantry-Balkens 15 erreicht (wie in Fig. 11 durch einen sich zwischen dem seitlichen Luftlager 140 und dem ersten Ende 15.1 des Gantry-Balkens 15 erstreckenden Doppelpfeil angedeutet), und in Richtung des zweiten Endes 15.2 derart weit, bis das seitliche Luftlager 141 der zweiten Luftlager-Einrichtung LL2 das zweite Ende 15.2 des Gantry-Balkens 15 erreicht (wie in Fig. 11 durch einen sich zwischen dem seitlichen Luftlager 141 und dem zweiten Ende 15.2 des Gantry-Balkens 15 erstreckenden Doppelpfeil angedeutet) .

Wie aus Fig. 12 und 13 ersichtlich, ist das bewegliche Element 5 mittels der Luftlager der zweiten Luftlager-Einrichtung LL2 am Gantry-Balken 15 derart geführt, dass das bewegliche Element 5 bei einer Bewegung in der zweiten Richtung Y seitlich mittels der seitlichen Luftlager 140 bzw. 141 ausschliesslich an der einen ebenen Seitenfläche SFG2 des Gantry-Balken 15 geführt ist, während die der ebenen Seitenfläche SFG2 in der ersten Richtung X gegenüberliegende Seitenfläche SFG1 des Gantry-Balkens 15 frei zugänglich ist. Die Seitenfläche SFG1 des Gantry-Balkens 15 bietet deshalb die Möglichkeit, beispielsweise Versorgungsleitungen zur Versorgung der Luftlager der ersten Luftlager-Einrichtung LL1 und der zweiten Luftlager-Einrichtung LL2 mit Druckluft und/oder elektrische Leitungen zur Versorgung der Linearantriebe der zwei ersten Linearachsen X1 und X2 und des Linearantriebs der zweiten Linearachse Y1 mit elektrischer Energie an der ebenen Seitenfläche SFG2 zu befestigen (entsprechende Versorgungsleitungen bzw. elektrische Leitungen sind in den Figuren nicht dargestellt).

Dadurch, dass das bewegliche Element 5 mittels der Luftlager der zweiten Luftlager-Einrichtung LL2 bei einer Bewegung in der zweiten Richtung Y ausschliesslich am Gantry-Balken 15 (und nicht an der ebenen Führungsfläche FF der Basis B) geführt ist, bietet die Basis B der Positioniervorrichtung 1 an der oberen Seite der Basis B Platz, die an der ebenen Seitenfläche SFG2 befestigten Versorgungsleitungen zur Versorgung der Luftlager der ersten Luftlager-Einrichtung LL1 und der zweiten Luftlager-Einrichtung LL2 mit Druckluft und/oder die die an der ebenen Seitenfläche SFG2 befestigten elektrischen Leitungen zur Versorgung der Linearantriebe der zwei ersten Linearachsen X1 und X2 und des Linearantriebs der zweiten Linearachse Y1 mit elektrischer Energie durch eine rinnenartige Vertiefung VX zu führen, welche an der Oberseite der Basis B ausgebildet ist und sich gemäss der in Fig. 1, 2, 5 und 12 dargestellten Ausführung der Positioniervorrichtung 1 zwischen dem zweiten Abschnitt FF2 und dem dritten Abschnitt FF2 der ebenen Führungsfläche FF linear in der ersten Richtung X erstreckt.

Die vorstehend genannten Massnahmen ermöglichen eine Anordnung aller Komponenten der Positioniervorrichtung 1 derart, dass die Positioniervorrichtung 1 kompakt aufgebaut ist (mit einer verhältnismässig kleinen Grundfläche, über welche die jeweiligen Teile der Positioniervorrichtung 1 räumlich verteilt angeordnet sind).

## Patentansprüche

1. Positioniervorrichtung (1) zum Positionieren eines beweglichen Elements (5), umfassend:
eine Basis (B) mit einer ebenen Führungsfläche (FF), welche parallel zu einer ersten Richtung (X) und parallel zu einer zweiten Richtung (Y) angeordnet ist;
eine erste Bewegungseinrichtung (10) in Gantry-Bauweise, welche erste Bewegungseinrichtung einen über der ebenen Führungsfläche (FF) angeordneten, sich in der zweiten Richtung (Y) in einem Abstand zur ebenen Führungsfläche (FF) erstreckenden Gantry-Balken (15) und einen Gantry-Antrieb (GA) zum Bewegen des Gantry-Balkens relativ zur Basis (B) in der ersten Richtung (X) umfasst, wobei der Gantry-Balken (15) ein erstes Ende (15.1) und ein dem ersten Ende (15.1) gegenüberliegendes zweites Ende (15.2) aufweist und der Gantry-Antrieb (GA) zwei sich in der ersten Richtung (X) erstreckende erste Linearachsen (X1, X2) mit je einem Linearantrieb (LMX1, LMX2) umfasst, wobei der Linearantrieb (LMX1) einer der zwei ersten Linearachsen (X1, X2) mit dem ersten Ende (15.1) des Gantry-Balkens (15) und der Linearantrieb (LMX2) der anderen der zwei ersten Linear-Achsen (X1, X2) mit dem zweiten Ende (15.2) des Gantry-Balkens (15) verbunden ist;
eine erste Luftlager-Einrichtung (LL1) mit mehreren mit dem Gantry-Balken (15) verbundenen Luftlagern zum Führen des Gantry-Balkens an der ebenen Führungsfläche (FF) der Basis (B);
wobei das bewegliche Element (5) am Gantry-Balken (15) derart gelagert ist, dass das bewegliche Element (5) am Gantry-Balken linear in der zweiten Richtung (Y) bewegbar ist, und der Gantry-Balken (15) eine sich in der zweiten Richtung (Y) erstreckende zweite Linearachse (Y1) mit einem mit dem beweglichen Element (5) verbundenen Linearantrieb (LMY) zum Bewegen des beweglichen Elements (5) in der zweiten Richtung (Y) aufweist;
wobei die erste Luftlager-Einrichtung (LL1) eine erste Luftlager-Anordnung (30) aufweist, welche mindestens ein am ersten Ende (15.1) des Gantry-Balkens (15) angeordnetes erstes horizontales Luftlager (31, 32) zum Führen des ersten Endes (15.1) des Gantry-Balkens (15) an einem sich in der ersten Richtung (X) erstreckenden ersten Abschnitt (FF1) der ebenen Führungsfläche (FF) umfasst, welches mindestens eine erste horizontale Luftlager (31, 32) bezüglich des ersten Abschnitts (FF1) der ebenen Führungsfläche (FF) vorgespannt ist;
wobei die erste Luftlager-Einrichtung (LL1) eine zweite Luftlager-Anordnung (35) aufweist, welche mindestens ein am zweiten Ende (15.2) des Gantry-Balkens (15) angeordnetes zweites horizontales Luftlager (36, 37) zum Führen des zweiten Endes (15.2) des Gantry-Balkens an einem zweiten sich in der ersten Richtung (X) erstreckenden Abschnitt (FF2) der ebenen Führungsfläche (FF) umfasst, welches mindestens eine zweite horizontale Luftlager (36, 37) bezüglich des zweiten Abschnitts (FF2) der ebenen Führungsfläche (FF) vorgespannt ist;
wobei die erste Luftlager-Einrichtung (LL1) eine dritte Luftlager-Anordnung (50) aufweist, welche mindestens ein drittes horizontales Luftlager (51, 52) und mindestens ein viertes horizontales Luftlager (53, 54) umfasst, wobei das mindestens eine dritte horizontale Luftlager (51, 52) und das mindestens eine vierte horizontale Luftlager (53, 54) an einem mittleren Abschnitt des Gantry-Balkens (15) zwischen dem ersten Ende (15.1) des Gantry-Balkens (15) und dem zweiten Ende (15.2) des Gantry-Balkens (15) angeordnet sind, sodass der mittlere Abschnitt des Gantry-Balkens mittels des dritten horizontalen Luftlagers (51, 52) und des vierten horizontales Luftlagers (53, 54) an einem sich in der ersten Richtung (X) erstreckenden dritten Abschnitt (FF3) der ebenen Führungsfläche (FF) geführt ist, welcher mit Bezug auf die zweite Richtung (Y) zwischen dem ersten Abschnitt (FF1) der ebenen Führungsfläche (FF) und dem zweiten Abschnitt (FF2) der ebenen Führungsfläche (FF) angeordnet ist, wobei das mindestens eine dritte horizontale Luftlager (51, 52) und das mindestens eine vierte horizontale Luftlager (53, 54) relativ zueinander einen Abstand in der ersten Richtung (X) aufweisen und das mindestens eine dritte horizontale Luftlager (51, 52) und das mindestens eine vierte horizontale Luftlager (53, 54) bezüglich des dritten Abschnitts (FF3) der ebenen Führungsfläche (FF) vorgespannt sind;
wobei an der Basis (B) neben dem dritten Abschnitt (FF3) der ebenen Führungsfläche (FF) ein sich in der ersten Richtung (X) erstreckender Führungsbalken (FB) angeordnet ist, welcher eine ebene Seitenfläche (SF) aufweist, welche sich parallel zur ersten Richtung (X) und parallel zu einer im Wesentlichen senkrecht zur ebenen Führungsfläche (FF) gerichteten dritten Richtung (Z) erstreckt;
wobei die dritte Luftlager-Anordnung (50) mindestens ein an dem mittleren Abschnitt des Gantry-Balkens (15) angeordnetes seitliches Luftlager (55, 56) zum Führen des Gantry-Balkens (15) an der einen ebenen Seitenfläche (SF) des Führungsbalkens (FB) umfasst, wobei das mindestens eine seitliche Luftlager (55, 56) bezüglich der einen ebenen Seitenfläche (SF) des Führungsbalkens (FB) vorgespannt ist.

2. Positioniervorrichtung (1) gemäss Anspruch 1,
wobei die dritte Luftlager-Anordnung (50) zwei dritte horizontale Luftlager (51, 52) und zwei vierte horizontale Luftlager (53, 54) zum Führen des mittleren Abschnitts des Gantry-Balkens (15) an dem dritten Abschnitt (FF3) der ebenen Führungsfläche (FF) umfasst, wobei die zwei dritten horizontalen Luftlager (51, 52) relativ zueinander derart angeordnet sind, dass die zwei dritten horizontalen Luftlager (51, 52) relativ zueinander einen Abstand in der zweiten Richtung (Y) aufweisen, und die zwei vierten horizontalen Luftlager (53, 54) relativ zueinander derart angeordnet, dass die zwei vierten horizontalen Luftlager (53, 54) relativ zueinander einen Abstand in der zweiten Richtung (Y) aufweisen,
wobei die zwei dritten horizontalen Luftlager (51, 52) und die zwei vierten horizontalen Luftlager (53, 54) bezüglich des dritten Abschnitts (FF3) der ebenen Führungsfläche (FF) vorgespannt sind.

3. Positioniervorrichtung (1) gemäss Anspruch 1 oder 2, wobei die dritte Luftlager-Anordnung (50) zwei seitliche Luftlager (55, 56) zum Führen des Gantry-Balkens (15) an der ebenen Seitenfläche (SF) des Führungsbalkens (FB) umfasst, wobei die zwei seitlichen Luftlager (55, 56) relativ zueinander derart angeordnet sind, dass sie relativ zueinander einen Abstand in der ersten Richtung (X) aufweisen, und
wobei die zwei seitlichen Luftlager (55, 56) bezüglich der ebenen Seitenfläche (SF) des Führungsbalkens (FB) vorgespannt sind.

4. Positioniervorrichtung (1) gemäss einem der Ansprüche 1-3,
wobei jedes dritte horizontale Luftlager (51, 52) der dritten Luftlager-Anordnung (50), jedes vierte horizontale Luftlager (53, 54) der dritten Luftlager-Anordnung (50) und jedes seitliche Luftlager (55, 56) der dritten Luftlager-Anordnung (50) an einem gemeinsamen Träger (70) befestigt sind und der Träger (70) am Gantry-Balken (15) befestigt ist, sodass die dritte Luftlager-Anordnung (50) mittels des Trägers (70) am Gantry-Balken (15) gehalten ist.

5. Positioniervorrichtung (1) gemäss Anspruch 4,
wobei der Träger (70) unterhalb des Gantry-Balkens (15) in einem Zwischenraum zwischen dem Gantry-Balken (15) und der ebenen Führungsfläche (FF) angeordnet ist.

6. Positioniervorrichtung (1) gemäss einem der Ansprüche 4-5,
wobei der Träger (70) an dem Gantry-Balken (15) derart drehbar gelagert ist, dass der Träger (70) gemeinsam mit jedem dritten horizontalen Luftlager (51, 52) der dritten Luftlager-Anordnung (50), jedem vierten horizontalen Luftlager (53, 54) der dritten Luftlager-Anordnung (50) und jedem seitlichen Luftlager (55, 56) der dritten Luftlager-Anordnung (50) relativ zu dem Gantry-Balken (15) um eine sich in der dritten Richtung (Z) erstreckende Drehachse (DZ) drehbar ist.

7. Positioniervorrichtung (1) gemäss einem der Ansprüche 4-6,
wobei der Träger (70) mit dem Gantry-Balken (15) über ein Drehgelenk (DGZ) verbunden ist, welches aus einem oder mehreren Festkörpergelenken (80A, 80B) gebildet ist.

8. Positioniervorrichtung (1) gemäss einem der Ansprüche 1-7,
wobei die erste Luftlager-Anordnung (30) zwei erste horizontale Luftlager (31, 32) zum Führen des ersten Endes (15.1) des Gantry-Balkens an dem ersten Abschnitt (FF1) der ebenen Führungsfläche (FF) umfasst, wobei die zwei ersten horizontalen Luftlager (31, 32) relativ zueinander derart angeordnet sind, dass die zwei ersten horizontalen Luftlager (31, 32) relativ zueinander einen Abstand in der ersten Richtung (X) aufweisen, wobei die zwei ersten horizontalen Luftlager (31, 32) bezüglich des ersten Abschnitts (FF1) der ebenen Führungsfläche (FF) vorgespannt sind.

9. Positioniervorrichtung (1) gemäss einem der Ansprüche 1-8,
wobei die zweite Luftlager-Anordnung (35) zwei zweite horizontale Luftlager (36, 37) zum Führen des zweiten Endes (15.2) des Gantry-Balkens (15) an dem zweiten Abschnitt (FF2) der ebenen Führungsfläche (FF) umfasst, wobei die zwei zweiten horizontalen Luftlager (36, 37) relativ zueinander derart angeordnet sind, dass die zwei zweiten horizontalen Luftlager (36, 37) in der ersten Richtung (X) relativ zueinander einen Abstand aufweisen, wobei die zwei zweiten horizontalen Luftlager (36, 37) bezüglich des zweiten Abschnitts (FF2) der ebenen Führungsfläche (FF) vorgespannt sind.

10. Positioniervorrichtung (1) gemäss einem der Ansprüche 1-9,
mit einer zweiten Luftlager-Einrichtung (LL2) mit mehreren mit dem beweglichen Element (5) verbundenen Luftlagern zum Führen des beweglichen Elements (5) am Gantry-Balken (15).

11. Positioniervorrichtung (1) gemäss Anspruch 10,
wobei der Gantry-Balken (15) eine ebene Führungsfläche (FFG1, FFG2) aufweist, welche parallel zu der ersten Richtung (X) und parallel zu der zweiten Richtung (Y) angeordnet ist, und
der Gantry-Balken (15) eine ebene Seitenfläche (SFG2) aufweist, welche sich parallel zur zweiten Richtung (Y) und parallel zu einer im Wesentlichen senkrecht zur ebenen Führungsfläche (FFG1, FFG2) des Gantry-Balkens (15) gerichteten dritten Richtung (Z) erstreckt, und
wobei die zweite Luftlager-Einrichtung (LL2) mindestens ein erstes horizontales Luftlager (121, 122) und mindestens ein zweites horizontales Luftlager (123, 124) umfasst, welches mindestens eine erste horizontale Luftlager (121, 122) und welches mindestens eine zweite horizontale Luftlager (123, 124) am beweglichen Element (5) derart angeordnet sind, dass das bewegliche Element (5) mittels des mindestens einen ersten horizontalen Luftlagers (121, 122) und mittels des mindestens einen zweiten horizontalen Luftlagers (123, 124) der zweiten Luftlager-Einrichtung (LL2) an der ebenen Führungsfläche (FFG1, FFG2) des Gantry-Balkens (15) geführt ist, wobei das mindestens eine erste horizontale Luftlager (121, 122) relativ zu dem mindestens einen zweiten horizontalen Luftlager (123, 124) der zweiten Luftlager-Einrichtung (LL2) einen Abstand in der zweiten Richtung (Y) aufweist und das mindestens eine erste horizontale Luftlager (121, 122) und das mindestens eine zweite horizontale Luftlager (123, 124) der zweiten Luftlager-Einrichtung (LL2) bezüglich der ebenen Führungsfläche (FFG1, FFG2) des Gantry-Balkens (15) vorgespannt sind, und
wobei die zweite Luftlager-Einrichtung (LL2) mindestens ein am beweglichen Element (5) angeordnetes seitliches Luftlager (140, 141) zum Führen des beweglichen Elements (5) an der einen ebenen Seitenfläche (SFG2) des Gantry-Balkens (15) umfasst und das mindestens eine seitliche Luftlager (140, 141) der zweiten Luftlager-Einrichtung (LL2) bezüglich der einen ebenen Seitenfläche (SFG2) des Gantry-Balkens (15) vorgespannt ist.

12. Positioniervorrichtung (1) gemäss Anspruch 11,
wobei die zweite Luftlager-Einrichtung (LL2) zwei am beweglichen Element (5) angeordnete erste horizontale Luftlager (121, 122) zum Führen des beweglichen Elements (5) an der ebenen Führungsfläche (FFG1, FFG2) des Gantry-Balkens (15) umfasst, wobei die zwei ersten horizontalen Luftlager (121, 122) der zweiten Luftlager-Einrichtung (LL2) relativ zueinander einen Abstand in der ersten Richtung (X) aufweisen und bezüglich der ebenen Führungsfläche (FFG1, FFG2) des Gantry-Balkens (15) vorgespannt sind; und/oder
wobei die zweite Luftlager-Einrichtung (LL2) zwei am beweglichen Element (5) angeordnete zweite horizontale Luftlager (123, 124) zum Führen des beweglichen Elements (5) an der ebenen Führungsfläche (FFG1, FFG2) des Gantry-Balkens (15) umfasst, wobei die zwei zweiten horizontalen Luftlager (123, 124) der zweiten Luftlager-Einrichtung (LL2) relativ zueinander einen Abstand in der ersten Richtung (X) aufweisen und bezüglich der ebenen Führungsfläche (FFG1, FFG2) des Gantry-Balkens (15) vorgespannt sind; und/oder
wobei die zweite Luftlager-Einrichtung (LL2) zwei am beweglichen Element (5) angeordnete seitliche Luftlager (140, 141) zum Führen des beweglichen Elements (5) an der einen ebenen Seitenfläche (SFG2) des Gantry-Balkens (15) umfasst, wobei die zwei seitlichen Luftlager (140, 141) der zweiten Luftlager-Einrichtung (LL2) relativ zueinander einen Abstand in der zweiten Richtung (Y) aufweisen und bezüglich der ebenen Seitenfläche (SFG2) des Gantry-Balkens (15) vorgespannt sind.

13. Positioniervorrichtung (1) gemäss einem der Ansprüche 11-12, wobei
das mindestens eine erste horizontale Luftlager (121, 122) und das mindestens eine zweite horizontale Luftlager (123, 124) der zweiten Luftlager-Einrichtung (LL2) mit magnetischen Mitteln (150, 151) bezüglich der ebenen Führungsfläche (FFG) des Gantry-Balkens (15) vorgespannt sind, und/oder
das mindestens eine seitliche Luftlager (140, 141) der zweiten Luftlager-Einrichtung (LL2) mit magnetischen Mitteln (160, 161) bezüglich der einen ebenen Seitenfläche (SFG2) des Gantry-Balkens (15) vorgespannt ist.

14. Positioniervorrichtung (1) gemäss einem der Ansprüche 1-13, wobei
das mindestens eine erste horizontale Luftlager (31, 32) der ersten Luftlager-Anordnung (30) mit magnetischen Mitteln (40, 41, 42) bezüglich des ersten Abschnitts (FF1) der ebenen Führungsfläche (FF) der Basis (B) vorgespannt ist, und/oder
das mindestens eine zweite horizontale Luftlager (36, 37) der zweiten Luftlager-Anordnung (35) mit magnetischen Mitteln (40, 41, 42) bezüglich des zweiten Abschnitts (FF2) der ebenen Führungsfläche (FF) vorgespannt ist, und/oder
das mindestens eine dritte horizontale Luftlager (51, 52) der dritten Luftlager-Anordnung (50) und das mindestens eine vierte horizontale Luftlager (53, 54) der dritten Luftlager-Anordnung (50) mit magnetischen Mitteln (40, 41, 42) bezüglich des dritten Abschnitts (FF3) der ebenen Führungsfläche (FF) vorgespannt sind, und/oder
das mindestens eine seitliche Luftlager (55, 56) der dritten Luftlager-Anordnung (50) mit magnetischen Mitteln (60, 61) bezüglich der einen ebenen Seitenfläche (SF) des Führungsbalkens (FB) vorgespannt ist.

15. Positioniervorrichtung (1) gemäss einem der Ansprüche 4-7,
mit einem ersten Festkörpergelenk (80A), bestehend aus einem ersten länglichen Festkörper, welcher sich entlang einer zur dritten Richtung (Z) parallelen ersten Ebene (ME1) senkrecht zur dritten Richtung (Z) erstreckt und eine senkrecht zur dritten Richtung (Z) angeordnete Längsachse aufweist, wobei der erste längliche Festkörper folgende in Richtung der Längsachse des ersten länglichen Festkörpers hintereinander angeordnete Längsabschnitte aufweist:
- einen ersten Endabschnitt (E1), welcher ein erstes Ende des ersten länglichen Festkörpers bildet;
- einen zweiten Endabschnitt (E2), welcher ein dem ersten Ende des ersten länglichen Festkörpers in Richtung der Längsachse des ersten länglichen Festkörpers gegenüberliegendes zweites Ende des ersten länglichen Festkörpers bildet;
- einen zwischen dem ersten Endabschnitt und dem zweiten Endabschnitt des ersten länglichen Festkörpers angeordneten Mittelabschnitt (F);
- einen zwischen dem ersten Endabschnitt (E1) und dem Mittelabschnitt (F) des ersten länglichen Festkörpers angeordneten, mit dem ersten Endabschnitt (E1) und dem Mittelabschnitt (F) verbundenen ersten Stegteil (S1);
- einen zwischen dem zweiten Endabschnitt (E2) und dem Mittelabschnitt (F) angeordneten, mit dem zweiten Endabschnitt (E2) und dem Mittelabschnitt (F) des ersten länglichen Festkörpers verbundenen zweiten Stegteil (S2);
mit einem zweiten Festkörpergelenk (80B), bestehend aus einem zweiten länglichen Festkörper, welcher sich entlang einer zur dritten Richtung (Z) parallelen zweiten Ebene (ME2) senkrecht zur dritten Richtung (Z) erstreckt und eine senkrecht zur dritten Richtung (Z) angeordnete Längsachse aufweist, wobei der zweite längliche Festkörper folgende in Richtung der Längsachse des zweiten länglichen Festkörpers hintereinander angeordnete Längsabschnitte aufweist:
- einen ersten Endabschnitt (E1), welcher ein erstes Ende des zweiten länglichen Festkörpers bildet;
- einen zweiten Endabschnitt (E2), welcher ein dem ersten Ende des zweiten länglichen Festkörpers in Richtung der Längsachse des zweiten länglichen Festkörpers gegenüberliegendes zweites Ende des zweiten länglichen Festkörpers bildet;
- einen zwischen dem ersten Endabschnitt und dem zweiten Endabschnitt des zweiten länglichen Festkörpers angeordneten Mittelabschnitt (F);
- einen zwischen dem ersten Endabschnitt (E1) und dem Mittelabschnitt (F) des zweiten länglichen Festkörpers angeordneten, mit dem ersten Endabschnitt und dem Mittelabschnitt verbundenen ersten Stegteil (S1);
- einen zwischen dem zweiten Endabschnitt (E2) und dem Mittelabschnitt (F) des zweiten länglichen Festkörpers angeordneten, mit dem zweiten Endabschnitt (E2) und dem Mittelabschnitt (F) des ersten länglichen Festkörpers verbundenen zweiten Stegteil (S2);
wobei der Träger (70) mit dem Gantry-Balken (15) über das erste Festkörpergelenk (80A) und das zweite Festkörpergelenk (80B) derart verbunden ist,
dass der erste Endabschnitt (E1) des ersten länglichen Festkörpers und der zweite Endabschnitt (E2) des ersten länglichen Festkörpers starr mit dem Träger (70) und der Mittelabschnitt (F) des ersten länglichen Festkörpers starr mit dem Gantry-Balken (15) verbunden sind und
dass der erste Endabschnitt (E1) des zweiten länglichen Festkörpers und der zweite Endabschnitt (E2) des zweiten länglichen Festkörpers starr mit dem Träger (70) und der Mittelabschnitt (F) des zweiten länglichen Festkörpers starr mit dem Gantry-Balken (15) verbunden sind,
wobei die erste Ebene (ME1) und die zweite Ebene (ME2) relativ zueinander derart geneigt sind, dass die erste Ebene (ME1) und die zweite Ebene (ME2) eine sich parallel zur dritten Richtung (Z) erstreckende gemeinsame Schnittlinie (DZ) bilden,
wobei der erste Stegteil (S1) und der zweite Stegteil (S2) des ersten Festkörpergelenks (80A) und der erste Stegteil (S1) und der zweite Stegteil (S2)des zweiten Festkörpergelenks (80B) elastisch deformierbar ausgebildet sind, sodass der Mittelabschnitt (F) des ersten Festkörpergelenks (80A) relativ zum ersten Endabschnitt (E1) des ersten Festkörpergelenks (80A) und zum zweiten Endabschnitt (E2) des ersten Festkörpergelenks (80A) bewegbar ist und der Mittelabschnitt (F) des zweiten Festkörpergelenks (80B) relativ zum ersten Endabschnitt (E1) des zweiten Festkörpergelenks (80B) und zum zweiten Endabschnitt (E2) des zweiten Festkörpergelenks (80B) bewegbar ist, wobei der Träger (70) mittels des ersten Festkörpergelenks (80A) und des zweiten Festkörpergelenks (80B) an dem Gantry-Balken um die gemeinsame Schnittlinie (DZ) der ersten Ebene (ME1) und der zweiten Ebene (ME2) drehbar gelagert ist.

16. Positioniervorrichtung (1) gemäss Anspruch 15,
wobei das erste Festkörpergelenk (80A) und das zweite Festkörpergelenk (80B) symmetrisch bezüglich einer dritten Ebene (E3) angeordnet sind, welche sich parallel zur zweiten Richtung (Y) und parallel zur dritten Richtung (Z) erstreckt.

17. Positioniervorrichtung (1) gemäss einem der Ansprüche 15-16,
wobei der Träger (70) mindestens einen Hohlraum (71A, 71B) aufweist, in welchem das erste Festkörpergelenk (80A) und/oder das zweite Festkörpergelenk (80B) angeordnet ist.

18. Positioniervorrichtung (1) gemäss einem der Ansprüche 15-17,
wobei der Träger (70) mittels des ersten Festkörpergelenks (80A) und des zweiten Festkörpergelenks (80B) mit Bezug auf den Gantry-Balken (15) in einer Ruhelage gehalten ist, derart, dass der Träger (70) mittels einer Drehung des Trägers (70) relativ zum Gantry-Balken (15) um die gemeinsame Schnittlinie (DZ) der ersten Ebene (ME1) und der zweiten Ebene (ME2) aus der Ruhelage herausbewegbar ist.

19. Positioniervorrichtung (1) gemäss Anspruch 18,
wobei der Träger (70) mindestens ein Anschlagselement (HSA1, HSA2) aufweist, welches derart angeordnet ist, dass das Anschlagselement (HSA1, HSA2) einen Abstand zum Mittelabschnitt (F) des ersten Festkörpergelenks (80A) aufweist, wenn der Träger (70) relativ zum Gantry-Balken (15) in der Ruhelage angeordnet ist, und welches Anschlagselement (HSA1, HSA2) mittels einer Drehung des Trägers (70) um einen vorgegebenen maximalen Drehwinkel um die gemeinsame Schnittlinie (DZ) der ersten Ebene (ME1) und der zweiten Ebene (ME2) in Kontakt mit dem Mittelabschnitt (F) des ersten Festkörpergelenks (80A) bringbar ist, sodass der Mittelabschnitt (F) des ersten Festkörpergelenks (80A) einen die Drehung des Trägers (70) limitierenden mechanischen Anschlag für den Träger (70) bildet; und/oder
wobei der Träger (70) mindestens ein Anschlagselement (HSB1, HSB2) aufweist, welches derart angeordnet ist, dass das Anschlagselement (HSB1, HSB2) einen Abstand zum Mittelabschnitt (F) des zweiten Festkörpergelenks (80B) aufweist, wenn der Träger (70) relativ zum Gantry-Balken (15) in der Ruhelage angeordnet ist, und welches Anschlagselement (HSB1, HSB2) mittels einer Drehung des Trägers (70) um einen vorgegebenen maximalen Drehwinkel um die gemeinsame Schnittlinie (DZ) der ersten Ebene (ME1) und der zweiten Ebene (ME2) in Kontakt mit dem Mittelabschnitt (F) des zweiten Festkörpergelenks (80B) bringbar ist, sodass der Mittelabschnitt (F) des zweiten Festkörpergelenks (80B) einen die Drehung des Trägers (70) limitierenden mechanischen Anschlag für den Träger (70) bildet.

20. Positioniervorrichtung (1) gemäss einem der Ansprüche 1-19, wobei jeder Linearantrieb (LMX1, LMX2) der zwei ersten Linearachsen (X1, X2) ein Linearmotor ist und/oder der Linearantrieb (LMY) der zweiten Linearachse (Y1) ein Linearmotor ist.
